(19)

**Europäisches Patentamt**
**European Patent Office**
**Office européen des brevets**

(11) **EP 2 704 318 A1**

(12) **EUROPEAN PATENT APPLICATION**
published in accordance with Art. 153(4) EPC

(43) Date of publication:
**05.03.2014 Bulletin 2014/10**

(21) Application number: **12855920.0**

(22) Date of filing: **29.11.2012**

(51) Int Cl.:
**H03F 1/32** (2006.01)     **H03F 3/24** (2006.01)
**H04B 1/04** (2006.01)     **H04L 27/36** (2006.01)

(86) International application number:
**PCT/JP2012/080864**

(87) International publication number:
**WO 2013/084778 (13.06.2013 Gazette 2013/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.12.2011 JP 2011269882**

(71) Applicant: **NTT DOCOMO, INC.**
**Chiyoda-ku**
**Tokyo**
**100-6150 (JP)**

(72) Inventors:
• **OHKAWARA, Junya**
  **Tokyo 100-6150 (JP)**
• **SUZUKI, Yasunori**
  **Tokyo 100-6150 (JP)**
• **NARAHASHI, Shoichi**
  **Tokyo 100-6150 (JP)**

(74) Representative: **MERH-IP**
**Matias Erny Reichl Hoffmann**
**Paul-Heyse-Strasse 29**
**80336 München (DE)**

(54) **PREDISTORTER AND PREDISTORTER CONTROL METHOD**

(57)     A predistorter that is capable of compensating an inter-modulation distortion component which is generated in a power amplifier even when carrier aggregation is employed is provided. In a predistorter (10) of the present invention, a linear transmission path (150) delays and transmits an input signal. Signal generation units (120a, 120b) generate individual carrier distortion signals for respective carriers included in an input signal so as to output an individual carrier distortion compensation signal. A sub signal generation unit (130) generates a carrier inter-modulation distortion signal from the input signal and the individual carrier distortion signal and outputs a carrier inter-modulation distortion compensation signal. A signal divider (160) divides the input signal among the linear transmission path (150), the plurality of signal generation units (120a, 120b), and the sub signal generation unit (130). A signal combiner (170) combines the individual carrier distortion compensation signal and the carrier inter-modulation distortion compensation signal to generate a distortion compensation signal and combines the input signal and the distortion compensation signal so as to generate an output signal and output the output signal to an amplifier (20). A control unit (140) controls the plurality of signal generation units (120a, 120b) and the sub signal generation unit (130).

FIG.2

EP 2 704 318 A1

**Description**

[TECHNICAL FIELD]

The present invention relates to a predistorter which compensates a distortion component which is generated in a power amplifier and a predistorter control method.

[BACKGROUND ART]

Methods for reducing (hereinafter, referred to also as compensating) a nonlinear distortion component (hereinafter, referred to also as a distortion component) which is generated in a power amplifier include a method in which a predistorter is used, for example. A predistorter generates a distortion compensation signal in accordance with a model of a nonlinear characteristic in a power amplifier and adds the distortion compensation signal to a signal which is inputted into the power amplifier. For example, in non-patent literature 1 and non-patent literature 2, a distortion compensation signal which is capable of compensating a distortion component having frequency dependency is generated by using a model of a nonlinear characteristic based on the number of power series. According to the non-patent literature 1 and the non-patent literature 2, when an input signal of the predistorter is denoted as x(t), an output signal y(t) of the predistorter can be expressed as the formula (1).

$$y(t)=a_1x(t)+h_3(t)*a_3|x(t)|^2x(t) \qquad (1)$$

Here, the second member denotes a distortion compensation signal, $|x(t)|^2x(t)$ denotes a third order distortion component which is generated in a third order distortion generator of a predistorter, $a_1$ denotes a linear gain, $a_3$ denotes a complex coefficient which is provided to a third order distortion vector adjuster which adjusts an amplitude and a phase of the third order distortion component, $h_3(t)$ denotes an impulse response of a frequency property compensator which provides a frequency property to an output of the third order distortion vector adjuster, and * (asterisk) denotes convolution.
In this predistorter, a distortion compensation signal is generated through digital signal processing. At this time, $a_3$ and $h_3(t)$ are properly adjusted respectively so as to reduce a distortion component which is generated in a power amplifier and has frequency dependency.

[PRIOR ART LITERATURE]

[NON-PATENT LITERATURE]

Non-patent literature 1: S. Mizuta, Y. Suzuki, T. Hirota, and Y. Yamao, "Digital predistortion linearizer for compensating frequency-dependent IM distortion," in Proc. 34th European Microwave Conference, pp. 1053 - 1056, Oct. 2004.
Non-patent literature 2: S. Mizuta, Y. Suzuki, S. Narahashi, and Y. Yamao, "A New Adjustment Method for the Frequency-Dependent IMD Compensator of the Digital Predistortion Linearizer," IEEE Radio and Wireless Symposium 2006, pp. 255 - 258, Jan. 2006.

[SUMMARY OF THE INVENTION]

[PROBLEMS TO BE SOLVED BY THE INVENTION]

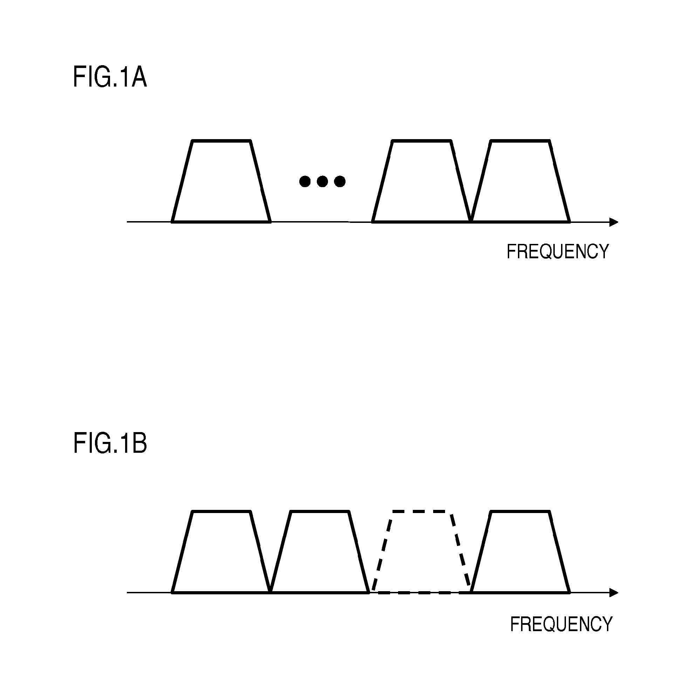

In LTE-Advanced, there is a technique which is called carrier aggregation (hereinafter, referred to as CA) in which a plurality of frequency bands (hereinafter, referred to also as carriers) are simultaneously used. CA falls into a case in which continuous frequency bands depicted in Fig. 1A are used and a case in which discontinuous frequency bands depicted in Fig. 1B are used. Here, Fig. 1B illustrates an example in which the frequency bands are relatively close to each other, but there is also a case in which an interval between frequency bands is wide.
In a case employing CA, a predistorter of related art may not be able to sufficiently reduce a distortion component depending on nonlinear characteristic of a power amplifier and a frequency band which is used. A case in which two frequency bands are used is concretely described below as an example.
When a signal which is transmitted by using the first frequency band is denoted as $s_1(t)$, a signal which is transmitted by using the second frequency band is denoted as $s_2(t)$, and an input signal $x(t)$ of a predistorter is expressed as $x(t)=s_1(t)+s_2(t)$, an output signal $y(t)$ of the predistorter can be expressed as formula (2).

$$
\begin{aligned}
y(t) &= a_1 x(t) + h_3(t) * a_3 \mid x(t) \mid^2 x(t) \\
&= a_1 \big( s_1(t) + s_2(t) \big) \\
&\quad + h_3(t) * a_3 \Big( \mid s_1(t) \mid^2 + s_1(t) s_2^*(t) + s_1^*(t) s_2(t) + \mid s_s(t) \mid^2 \Big) \big( s_1(t) + s_2(t) \big)
\end{aligned}
\qquad (2)
$$

Here, * (superscript asterisk) denotes a complex conjugate.

In formula (2), when a third order distortion component which is generated by the third order distortion generator of the predistorter is denoted as $d_c(t)$, $d_c(t)$ can be expressed as formula (3).

$$
\begin{aligned}
d_C(t) &= \mid x(t) \mid^2 x(t) \\
&= \Big( \mid s_1(t) \mid^2 + s_1(t) s_2^*(t) + s_1^*(t) s_2(t) + \mid s_2(t) \mid^2 \Big) \big( s_1(t) + s_2(t) \big) \\
&= \mid s_1(t) \mid^2 s_1(t) + 2 \mid s_1(t) \mid^2 s_2(t) + 2 \mid s_2(t) \mid^2 s_1(t) \\
&\quad + \mid s_2(t) \mid^2 s_2(t) + s_1^2(t) s_2^*(t) + s_2^2(t) s_1^*(t)
\end{aligned}
\qquad (3)
$$

Here, $\mid s_2(t) \mid^2 s_1(t)$ denotes an inter-modulation distortion component of $s_1(t)$ and $s_2(t)$. This distortion component is generated in a frequency band same as that of $\mid s_1(t) \mid^2 s_1(t)$. Further, $\mid s_1(t) \mid^2 s_2(t)$ also denotes an inter-modulation distortion component of $s_1(t)$ and $s_2(t)$. This distortion component is generated in a frequency band same as that of $\mid s_2(t) \mid^2 s_2(t)$. Apparent from formula (2), in the predistorter, all phases and amplitudes of a plurality of distortion components which are generated in identical frequency bands are adjusted by $a_3$ and $h_3(t)$ respectively.

It is known that nonlinear characteristic of a power amplifier becomes complicated when the power amplifier is operated with high efficiency. Here, when phases and amplitudes of respective distortion components are different from each other in a plurality of distortion components which are generated in identical frequency bands, it is impossible for a predistorter of related art to respectively adjust the phases and the amplitudes for respective distortion components. Therefore, the distortion components which are generated in the power amplifier remain.

Further, regarding a predistorter of a case that a plurality of frequency bands are used, predistorters are independently prepared for respective frequency bands as disclosed in "Japanese Patent Application Laid Open No. 2006-191673 (reference literature 1)", for example. Since predistorters are independently prepared for respective frequency bands in a case of the predistorter of reference literature 1, it is impossible to generate an inter-modulation distortion component of $s_1(t)$ and $s_2(t)$ by the predistorters. Therefore, even in a case where predistorters of reference literature 1 are used, distortion components which are generated in the power amplifier remain.

From the above description, such problem arises that an inter-modulation distortion component of $s_1(t)$ and $s_2(t)$ cannot be sufficiently reduced by a predistorter of related art in a case where CA is employed.

The present invention has been conceived to address such problem and has an objective to provide a predistorter which is capable of compensating an inter-modulation distortion component which is generated in a power amplifier even in a case where CA is employed.

[MEANS TO SOLVE THE PROBLEMS]

To solve the above-mentioned problem, a predistorter of the present invention includes a linear transmission path, a plurality of signal generation units, a sub signal generation unit, a signal divider, a signal combiner, and a control unit. The linear transmission path delays and transmits the input signal that includes a plurality of carries. The plurality of signal generation units generate an individual carrier distortion signal that is a distortion component, which is generated by the carriers, for each of the carriers included in the input signal and adjust the individual carrier distortion signal so as to output an individual carrier distortion compensation signal. The sub signal generation unit generates an inter-modulation distortion signal, which is generated among the carriers, from the input signal and the individual carrier distortion signal, extracts each component of a frequency band that is same at least as the carriers as a carrier inter-modulation distortion signal from the inter-modulation distortion signal, and adjusts the carrier inter-modulation distortion signal so as to output a carrier inter-modulation distortion compensation signal. The signal divider divides the input signal among the linear transmission path, the plurality of signal generation units, and the sub signal generation unit. The signal combiner that combines the individual carrier distortion compensation signal and the carrier inter-modulation distortion compensation signal to generate the distortion compensation signal and combines an input signal that is delayed by the linear transmission path and the distortion compensation signal so as to generate an output signal and output the output signal to the amplifier. The control unit controls the plurality of signal generation units and the sub signal generation unit by using a feedback signal from the amplifier.

[EFFECTS OF THE INVENTION]

According to the predistorter of the present invention, it is possible to independently generate an inter-modulation distortion compensation signal which corresponds to an inter-modulation distortion component among carriers by a sub signal generation unit and possible to independently adjust a phase and an amplitude of the signal. Therefore, an inter-modulation distortion component which is generated in a power amplifier can be compensated even in a case where CA is employed.

[BRIEF DESCRIPTION OF THE DRAWINGS]

Fig. 1A is a schematic view illustrating an example of frequency bands which are used in carrier aggregation.
Fig. 1B is a schematic view illustrating another example of frequency bands which are used in carrier aggregation.
Fig. 2 is a block diagram illustrating the whole configuration of a predistorter of Embodiment 1.
Fig. 3 is a block diagram illustrating the configuration of a distortion compensation signal generation path of Embodiment 1.
Fig. 4 is a schematic view illustrating a spectrum of a distortion component which is generated in a power amplifier.
Fig. 5 illustrates a flowchart P11 of a control method in the predistorter of Embodiment 1.
Fig. 6 illustrates a flowchart P12 of a control method in the predistorter of Embodiment 1.
Fig. 7 illustrates a flowchart P13 of a control method in the predistorter of Embodiment 1.
Fig. 8 is a block diagram illustrating the whole configuration of a predistorter of Modification 1 of Embodiment 1.
Fig. 9 is a block diagram illustrating the configuration of a distortion compensation signal generation path of Modification 1 of Embodiment 1.
Fig. 10 is a schematic view illustrating a divided band in Modification 2 of Embodiment 1.
Fig. 11 is a block diagram illustrating the whole configuration of a predistorter of Modification 2 of Embodiment 1.
Fig. 12 is a block diagram illustrating the configuration of a distortion compensation signal generation path of Modification 2 of Embodiment 1.
Fig. 13 is a block diagram illustrating the configuration of a distortion frequency property compensator of Modification 2 of Embodiment 1.
Fig. 14 illustrates a flowchart P14 of a control method in the predistorter of Modification 2 of Embodiment 1.
Fig. 15 illustrates a flowchart P15 of a control method in the predistorter of Modification 2 of Embodiment 1.
Fig. 16 illustrates a flowchart P16 of a control method in the predistorter of Modification 2 of Embodiment 1.
Fig. 17 illustrates a flowchart P17 of a control method in the predistorter of Modification 2 of Embodiment 1.
Fig. 18 is a block diagram illustrating the whole configuration of a predistorter of Embodiment 2.
Fig. 19 is a block diagram illustrating the configuration of a distortion compensation signal generation path of Embodiment 2.
Fig. 20 is a block diagram illustrating the whole configuration of a predistorter of Modification 1 of Embodiment 2.
Fig. 21 is a block diagram illustrating the configuration of a distortion compensation signal generation path of Modification 1 of Embodiment 2.
Fig. 22 is a block diagram illustrating the whole configuration of a predistorter of Modification 2 of Embodiment 2.
Fig. 23 is a block diagram illustrating the configuration of a distortion compensation signal generation path of Modification 2 of Embodiment 2.
Fig. 24 is a block diagram illustrating the whole configuration of a predistorter of Embodiment 3.
Fig. 25 is a block diagram illustrating the configuration of a distortion compensation signal generation path of Embodiment 3.
Fig. 26 illustrates a flowchart P31 of a control method in the predistorter of Embodiment 3.
Fig. 27 illustrates a flowchart P32 of a control method in the predistorter of Embodiment 3.
Fig. 28 illustrates a flowchart P33 of a control method in the predistorter of Embodiment 3.
Fig. 29 illustrates a flowchart P34 of a control method in the predistorter of Embodiment 3.
Fig. 30 is a block diagram illustrating the whole configuration of a predistorter of a modification of Embodiment 3.

Fig. 31 is a block diagram illustrating the configuration of a distortion compensation signal generation path of the modification of Embodiment 3.

Fig. 32 is a block diagram illustrating the whole configuration of a predistorter of Embodiment 4.

Fig. 33 is a block diagram 1 illustrating the configuration of a distortion compensation signal generation path of Embodiment 4.

Fig. 34 is a block diagram 2 illustrating the configuration of the distortion compensation signal generation path of Embodiment 4.

Fig. 35 illustrates a flowchart P41 of a control method in the predistorter of Embodiment 4.

Fig. 36 illustrates a flowchart P42 of a control method in the predistorter of Embodiment 4.

Fig. 37 illustrates a flowchart P43 of a control method in the predistorter of Embodiment 4.

[DETAILED DESCRIPTION OF THE EMBODIMENTS]

Embodiments of the present invention will be described in detail below. Here, constituent elements having the same function as each other are given the same number and duplicated description is omitted.

[Principle of Predistorter in Present Invention]

Before the provision of description of embodiments, a principle of a predistorter of the present invention is described. Here, a case in which a model of nonlinear characteristic of a power amplifier is a third order power series and two frequency bands are used is described as an example.

A signal which is transmitted by using the first frequency band is denoted as $s_1(t)$, a signal which is transmitted by using the second frequency band is denoted as $s_2(t)$, and an input signal $x(t)$ of the predistorter is expressed as $x(t)=s_1(t)+s_2(t)$.

A processing operation of the predistorter is performed by digital signal processing, so that only $s_1(t)$ can be extracted from $x(t)$ by using a digital filter such as a FIR filter. A third order distortion component $d_A(t)=|s_1(t)|^2 s_1(t)$ is generated from the extracted $s_1(t)$. In a similar manner, $s_2(t)$ is extracted from $x(t)$ by using a digital filter so as to generate a third order distortion component $d_B(t)=|s_2(t)|^2 s_2(t)$. When $d_A(t)$ and $d_B(t)$ are subtracted from a third order distortion component $d_c(t)$ of $x(t)$, which is expressed by formula (3) so as to generate an inter-modulation distortion component of $s_1(t)$ and $s_2(t)$, formula (A-1) can be expressed.

$$d_C(t) - d_A(t) - d_B(t) = |x(t)|^2\, x(t) - |s_1(t)|^2\, s_1(t) - |s_2(t)|^2\, s_2(t)$$
$$= 2|s_1(t)|^2\, s_2(t) + 2|s_2(t)|^2\, s_1(t) + s_1^2(t)s_2^*(t) + s_2^*(t)s_1^*(t) \qquad (A-1)$$

Inter-modulation distortion components $d_{CA}(t)$ and $d_{CB}(t)$ which are expressed by formulas (A-2) and (A-3) respectively are extracted from formula (A-1) by using a digital filter.

$$d_{CA}(t)=2|s_2(t)|^2 s_1(t) \qquad (A-2)$$

$$d_{CB}(t)=2|s_1(t)|^2 s_2(t) \qquad (A-3)$$

Thus, distortion components which are generated in identical frequency bands are respectively extracted. Then, phases and amplitudes of the extracted inter-modulation distortion components $d_A(t)$, $d_B(t)$, $d_{CA}(t)$, and $d_{CB}(t)$ are individually adjusted so as to obtain distortion compensation signals.

[Embodiment 1]

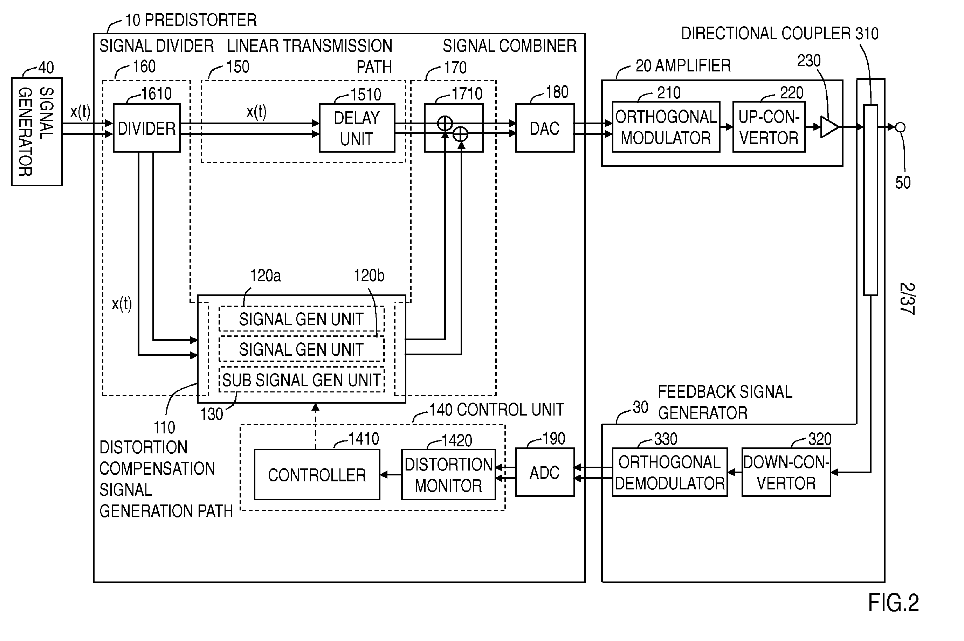

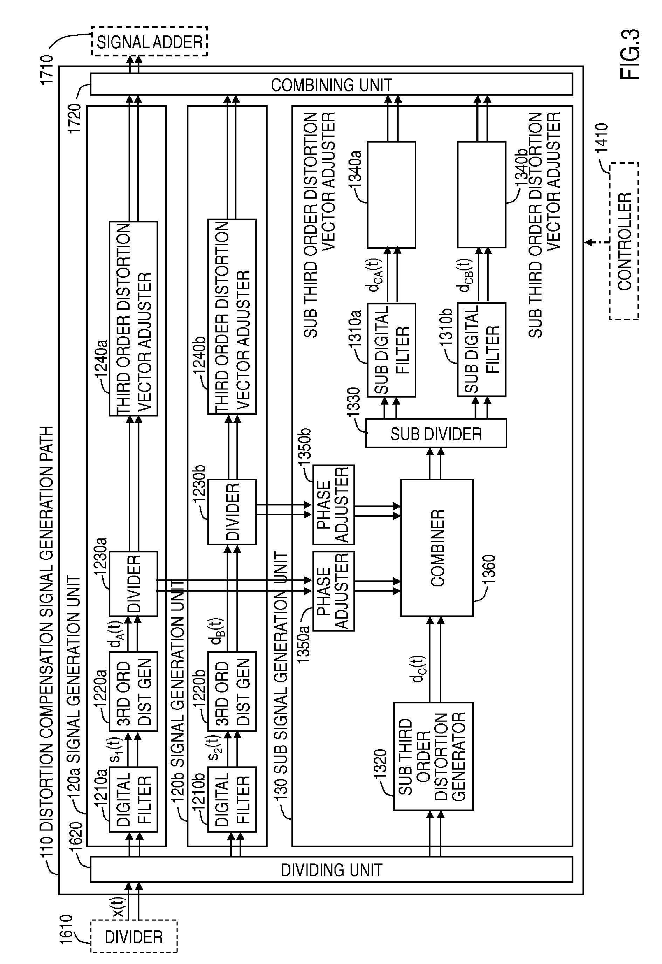

An operation of a predistorter 10 according to Embodiment 1 of the present invention is described in detail with reference to Figs. 2 and 3. Fig. 2 is a block diagram illustrating the whole configuration of the predistorter 10 and peripheral devices according to this embodiment. Fig. 3 is a block diagram illustrating the configuration of a distortion compensation signal generation path 110 which is included in the predistorter 10 according to this embodiment. The peripheral devices of this embodiment are an amplifier 20, a feedback signal generator 30, a signal generator 40, and an output terminal 50.

The predistorter 10 of this embodiment includes the distortion compensation signal generation path 110, a control unit 140, a linear transmission path 150, a signal divider 160, a signal combiner 170, a digital-analog converter (hereinafter, referred to as a DAC) 180, and an analog-digital converter (hereinafter, referred to as an ADC) 190.

The signal generator 40 outputs an input signal which is a digital signal which is composed of an I phase signal and a Q phase signal (hereinafter, referred to also as an I/Q signal) and uses $N_B$ (hereinafter, $N_B$ denotes a predetermined integer which is 2 or larger) pieces of frequency bands, which are different from each other, simultaneously. A case where $N_B$ is set to 2 is described below as an example.

The signal divider 160 includes a divider 1610 and a dividing unit 1620. The divider 1610 divides an input signal which is outputted by the signal generator 40 between the linear transmission path 150 and the distortion compensation signal generation path 110. The dividing unit 1620 will be described in description of the distortion compensation signal generation path 110 which will be mentioned later.

The linear transmission path 150 includes a delay unit 1510. The delay unit 1510 delays an input signal by delay time which is generated in the distortion compensation signal generation path 110.

The signal combiner 170 includes an adder 1710 and a combining unit 1720. The adder 1710 combines an input signal which is outputted by the linear transmission path 150 and a distortion compensation signal which is outputted by the distortion compensation signal generation path 110 so as to generate an output signal. The combining unit 1720 will be described in description of the distortion compensation signal generation path 110 which will be mentioned later.

The DAC 180 converts a digital signal which is outputted by the signal combiner 170 into an analog signal.

The amplifier 20 includes an orthogonal modulator 210, an up-converter 220, and a power amplifier 230. The orthogonal modulator 210 orthogonally modulates an analog signal which is outputted by the DAC 180. The up-converter 220 up-converts a signal which is outputted by the orthogonal modulator 210 into target frequency. The power amplifier 230 amplifies a signal which is outputted by the up-converter 220 to target power.

The output terminal 50 supplies a signal which is outputted by the amplifier 20 to an antenna via a duplexer and the like (not depicted).

The feedback signal generator 30 includes a directional coupler 310, a down-converter 320, and an orthogonal demodulator 330. The directional coupler 310 takes part of a signal which is outputted by the amplifier 20 into the feedback signal generator 30. The down-converter 320 down-converts a signal which is outputted by the directional coupler 310 into a predetermined frequency. The orthogonal demodulator 330 demodulates a signal which is outputted by the down-converter 320 into an I phase signal and a Q phase signal so as to generate a feedback signal.

The ADC 190 converts an analog signal which is outputted by the feedback signal generator 30 into a digital signal.

The control unit 140 includes a controller 1410 and a distortion monitor 1420. The distortion monitor 1420 measures power of a distortion component which is generated in the power amplifier 230, for every preliminarily-designated bandwidth, from a digital signal which is outputted by the ADC 190. The controller 1410 refers to an observation result which is outputted by the distortion monitor 1420 and controls the distortion compensation signal generation path 110 so as to reduce distortion components which are generated in the power amplifier 230. Details of an operation of the controller 1410 will be described later.

An operation of the distortion compensation signal generation path 110 is described in detail with reference to Fig. 3. The distortion compensation signal generation path 110 includes signal generation units 120a and 120b and a sub signal generation unit 130. The dividing unit 1620 described above divides an input signal which is outputted by the divider 1610 among the plurality of signal generation units 120a and 120b and the sub signal generation unit 130. The combining unit 1720 described above combines signals which are respectively outputted by the plurality of signal generation units 120a and 120b and the sub signal generation unit 130 so as to generate a distortion compensation signal and output the distortion compensation signal to the adder 1710. Here, it is assumed that delay time of signals which are respectively outputted by the plurality of signal generation units 120a and 120b and the sub signal generation unit 130 are adjusted to be same as each other by using a delay unit or the like (not depicted).

The signal generation unit 120a includes a digital filter 1210a, a third order distortion generator 1220a, a divider 1230a, and a third order distortion vector adjuster 1240a. The digital filter 1210a allows only a component of a preliminarily-designated frequency band (for example, one frequency band in Fig. 1A), which includes the signal $s_1(t)$ of an input signal $x(t)$ which is outputted by the dividing unit 1620, to pass therethrough. The third order distortion generator 1220a raises the signal $s_1(t)$ which is outputted by the digital filter 1210a to the $N_D$-th power to generate an individual carrier distortion signal $d_A(t)$ for generation of a $N_D$-th order distortion component (hereinafter, $N_D$ denotes a predetermined odd number which is 3 or larger). A case where $N_D$ is 3 is described as an example below. The divider 1230a divides the individual carrier distortion signal $d_A(t)$ which is outputted by the third order distortion generator 1220a between the sub signal generation unit 130 and the third order distortion vector adjuster 1240a. The third order distortion vector adjuster 1240a adjusts a phase and an amplitude of the individual carrier distortion signal $d_A(t)$ which is outputted by the divider 1230a on the basis of control information which is provided from the controller 1410 so as to generate an individual carrier distortion compensation signal and output the individual carrier distortion compensation signal to the combining unit 1720.

The signal generation unit 120b includes a digital filter 1210b, a third order distortion generator 1220b, a divider 1230b, and a third order distortion vector adjuster 1240b. The digital filter 1210b allows only a component of a frequency band (for example, another frequency band in Fig. 1A), which is different from a frequency band of which passage is allowed by the digital filter 1210a and includes the signal $s_2(t)$, in an input signal x(t) which is outputted by the dividing unit 1620, to pass. The third order distortion generator 1220b cubes the signal $s_2(t)$ which is outputted by the digital filter 1210b to generate an individual carrier distortion signal $d_B(t)$ for generation of a third order distortion component. The divider 1230b divides the individual carrier distortion signal $d_B(t)$ which is outputted by the third order distortion generator 1220b between the sub signal generation unit 130 and the third order distortion vector adjuster 1240b. The third order distortion vector adjuster 1240b adjusts a phase and an amplitude of the individual carrier distortion signal $d_B(t)$ which is outputted by the divider 1230b on the basis of control information which is provided from the controller 1410 so as to generate an individual carrier distortion compensation signal and output the individual carrier distortion compensation signal to the combining unit 1720.

The sub signal generation unit 130 includes a sub third order distortion generator 1320, phase adjusters 1350a and 1350b, a combiner 1360, a sub divider 1330, sub digital filters 1310a and 1310b, and sub third order distortion vector adjusters 1340a and 1340b. The sub third order distortion generator 1320 generates a third order distortion component which is obtained by cubing an input signal, which is outputted from the dividing unit 1620, and is expressed by formula (3). The phase adjuster 1350a adjusts a phase of the individual carrier distortion signal $d_A(t)$ which is outputted by the divider 1230a. The phase adjuster 1350b adjusts a phase of the individual carrier distortion signal $d_B(t)$ which is outputted by the divider 1230a. Here, it is assumed that delay time of signals which are respectively outputted by the dividers 1230a and 1230b is adjusted to be same as each other by using a delay unit or the like (not depicted). The combiner 1360 combines signals which are respectively outputted by the sub third order distortion generator 1320 and the phase adjusters 1350a and 1350b so as to generate a signal (hereinafter referred to as an inter-modulation distortion signal) which is expressed by formula (A-1). The sub divider 1330 divides a signal which is outputted by the combiner 1360 between the sub digital filters 1310a and 1310b. The sub digital filter 1310a allows only a component $2|s_2(t)|^2 s_1(t)$ of a frequency band, which is same as a frequency band of which passage is allowed by the digital filter 1210a, in a signal which is outputted by the sub divider 1330 to pass therethrough so as to output the component $2|s_2(t)|^2 s_1(t)$ as a carrier inter-modulation distortion signal $d_{CA}(t)$. It is assumed that a bandwidth for passage through the sub digital filter 1310a is predetermined. The sub digital filter 1310b allows only a component $2|s_1(t)|^2 s_2(t)$ of a frequency band, which is same as a frequency band of which passage is allowed by the digital filter 1210b, in a signal which is outputted by the sub divider 1330, to pass therethrough so as to output the component $2|s_1(t)|^2 s_2(t)$ as a carrier inter-modulation distortion signal $d_{CB}(t)$. It is assumed that a bandwidth for passage through the sub digital filter 1310b is also predetermined. The sub third order distortion vector adjuster 1340a adjusts a phase and an amplitude of the carrier inter-modulation distortion signal $d_{CA}(t)$ which is outputted by the sub digital filter 1310a, on the basis of control information which is provided by the controller 1410 so as to generate a carrier inter-modulation distortion compensation signal and output the carrier inter-modulation distortion compensation signal to the combining unit 1720. The sub third order distortion vector adjuster 1340b adjusts a phase and an amplitude of the carrier inter-modulation distortion signal $d_{CB}(t)$ which is outputted by the sub digital filter 1310b, on the basis of control information which is provided by the controller 1410, so as to generate a carrier inter-modulation distortion compensation signal and output the carrier inter-modulation distortion compensation signal to the combining unit 1720.

A phase setting method of the phase adjuster 1350a and the phase adjuster 1350b is described. Unless description is specifically provided, a signal which is outputted by the signal generator 40 and is transmitted by using the first frequency band is denoted as $s_1(t)$ and a signal which is outputted by the signal generator 40 and is transmitted by using the second frequency band is denoted as $s_2(t)$ below. It is assumed that the digital filter 1210a allows only $s_1(t)$ to pass therethrough and the digital filter 1210b allows only $s_2(t)$ to pass therethrough. In this case, a signal $d_A(t)$ which is outputted by the third order distortion generator 1220a is expressed as $d_A(t)=|s_1(t)|^2 s_1(t)$ and a signal $d_B(t)$ which is outputted by the third order distortion generator 1220b is expressed as $d_B(t)=|s_2(t)|^2 s_2(t)$. Further, a signal $d_c(t)$ which is outputted by the sub third order distortion generator 1320 is expressed as formula (4).

$$d_C(t) = \left( |s_1(t)|^2 + s_1(t)s_2^*(t) + s_1^*(t)s_2(t) + |s_2(t)|^2 \right)\left( s_1(t) + s_2(t) \right)$$
$$= d_A(t) + d_B(t) + d_{CA}(t) + d_{CB}(t) + s_1^2(t)s_2^*(t) + s_2^2(t)s_1^*(t) \qquad (4)$$

The phase adjuster 1350a adjusts a phase of $d_A(t)$ so as to cancel a component of $d_A(t)$ from $d_C(t)$. That is, the phase of $d_A(t)$ is reversed to obtain $-d_A(t)$. Alternatively, an amplitude of $d_A(t)$ is reversed to obtain $-d_A(t)$. The phase adjuster 1350b adjusts a phase of $d_B(t)$ so as to cancel a component of $d_B(t)$ from $d_C(t)$. That is, the phase of $d_B(t)$ is reversed to obtain $-d_B(t)$. Alternatively, an amplitude of $d_B(t)$ is reversed to obtain $-d_B(t)$. In a case where amplitudes of $d_A(t)$ and $d_B(t)$ do not accord with amplitudes of $d_A(t)$ and $d_B(t)$ which are included in $d_C(t)$ due to allowance of respective passage of $s_1(t)$ and $s_2(t)$ through the digital filters 1210a and 1210b, amplitude adjusters which adjust an amplitude and are not depicted may be disposed on the subsequent stages of the phase adjuster 1350a and the phase adjuster 1350b. The amplitude adjusters preliminarily confirm amplitudes of $d_A(t)$ and $d_B(t)$ and adjust so that the components, which are desired to be cancelled, in $d_C(t)$ are respectively accorded with the amplitudes.

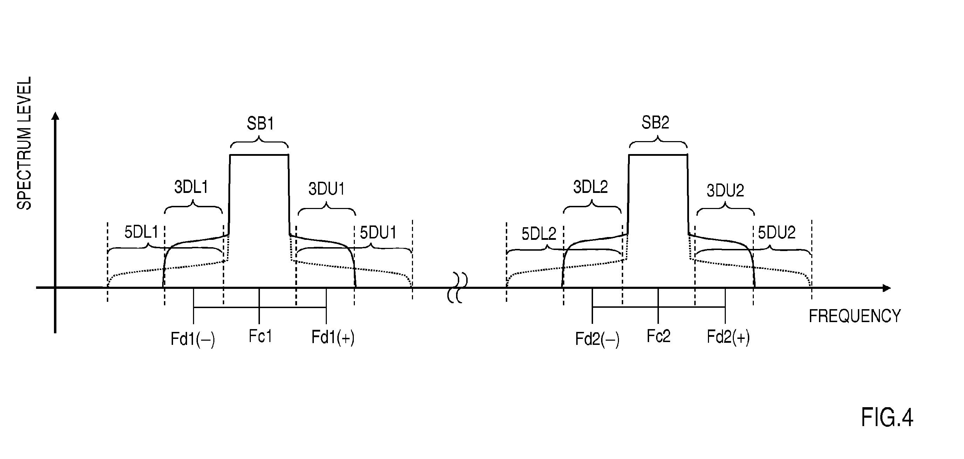

Details of an operation of the control unit 140 are described with reference to Fig. 4. Fig. 4 is a schematic view illustrating a spectrum of a signal which is outputted by the power amplifier 230. A signal band SB1 corresponds to the signal $s_1(t)$ which is transmitted by using the first frequency band and a signal band SB2 corresponds to the signal $s_2(t)$ which is transmitted by using the second frequency band. The distortion monitor 1420 measures power in bands which are represented by a third order distortion component lower side band 3DL1, a third order distortion component upper side band 3DU1, a third order distortion component lower side band 3DL2, and a third order distortion component upper side band 3DU2 in the spectrum depicted in Fig. 4. A bandwidth of each of the third order distortion components 3DL1, 3DU1, 3DL2, and 3DU2 is same as the bandwidths of the signal bands SB1 and SB2. Further, when an index such as an adjacent channel leakage power ratio (ACLR) is calculated, power in the signal band SB1 and power in the signal band SB2 are respectively measured, as well. Though bandwidths of respective bands SB1 and SB2 and detuning points from center frequencies Fc1 and Fc2 (detuning points Fd1(-), Fd1(+), Fd2(-), and Fd2(+) depicted in Fig. 4) can be arbitrarily set respectively, it is preferable to set in accordance with specifications of a radio communication system.

[Adjustment Processing Flow P11 of Embodiment 1]

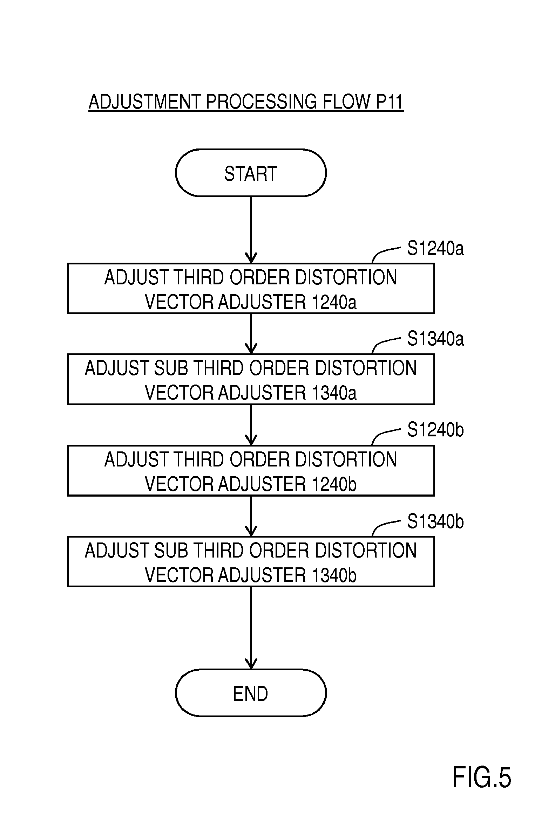

Fig. 5 illustrates an adjustment processing flow P11 in which the controller 1410 of this embodiment controls the distortion compensation signal generation path 110. In the adjustment processing flow P11, adjustment of the third order distortion vector adjuster 1240a (S1240a), adjustment of the sub third order distortion vector adjuster 1340a (S1340a), adjustment of the third order distortion vector adjuster 1240b (S1240b), and adjustment of the sub third order distortion vector adjuster 1340b (S1340b) are performed in sequence. Further, the controller 1410 performs adjustment processing of a third order distortion vector adjuster by a known method such as a perturbation method (refer to "T. Nojima and T. Konno, "Cuber Predistortion Linearizer for Relay Equipment in 800 MHz Band Land Mobile Telephone System, "IEEE Transactions on vehicular technology, Vol. 34, Issue 4, pp. 169-177, 1985") and a calculation method using quadratic function approximation (refer to "J. Ohkawara, Y. Suzuki, and S. Narahashi, "Fast Calculation Scheme for Frequency Characteristic Compensator of Digital Predistortion Linearizer," IEEE Vehicular Technology Conference Spring 2009, proceedings, Apr. 2009").

<Adjustment of Third Order Distortion Vector Adjuster 1240a>

(In Case of Perturbation Method)

A case where the perturbation method is employed as an adjustment method of a phase value and an amplitude value which are provided to the third order distortion vector adjuster 1240a is described. The controller 1410 instructs the distortion monitor 1420 to measure power of either one band between the third order distortion component upper side band 3DU1 and the third order distortion component lower side band 3DL1 and adjusts a phase value and an amplitude value of the third order distortion vector adjuster 1240a so as to reduce the power in the band. Power PD in bands designated before and after a phase value XP which is initially arbitrarily set (does not have to have the same value as an initial value in adjustment of the third order distortion vector adjuster 1240b and the sub third order distortion vector adjusters 1340a and 1340b which are other adjusters and will be described later) is measured, a phase is changed by a preliminarily-set offset value $\Delta$XP in a direction in which power PD is reduced, and power PD is measured by the distortion monitor 1420. A phase value $XP_{MIN}$ at which the power PD is equal to or smaller than a predetermined threshold value TH is obtained by repeating the change of a phase value and the measurement of power PD. The obtained phase value $XP_{MIN}$ is set in the third order distortion vector adjuster 1240a. Similar processing is performed for an amplitude value, as well.

(In Case Using Calculation Method Using Quadratic Function Approximation)

A case where a calculation method using quadratic function approximation is employed as an adjustment method of a phase value and an amplitude value which are provided to the third order distortion vector adjuster 1240a is described. Power $(PD_1, PD_2, ..., PD_R)$ in bands which are respectively designated by phase values $(XP_1, XP_2, ..., XP_R)$ of R points (hereinafter, R is an integer which is 3 or larger) which are different from each other is measured and

coefficients ($a_2$, $a_1$, $a_0$) of a quadratic function (PD=$a_2$XP$^2$+$a_1$XP+$a_0$) indicating dependency of power in the designated bands with respect to the phase values are obtained by the least square method on the basis of the used phase values (XP$_1$, XP$_2$, ..., XP$_R$) and the measured power (PD$_1$, PD$_2$, ..., PD$_R$). A phase value XP$_{MIN}$(=-$a_1$/2$a_2$) at which the power PD becomes minimum among the coefficients ($a_2$, $a_1$, $a_0$) is set in the third order distortion vector adjuster 1240a. The same goes for an amplitude value. The quadratic function has been described as an example here, but coefficients ($b_2$, $b_1$, $b_0$) of a trigonometric function (PD=$b_2$cos($b_1$-XP)+$b_0$) may be obtained instead of coefficients of a quadratic function by the least square method, as dependency of power in designated bands with respect to phase values, in calculation of a phase value. The obtained phase value XP$_{MIN}$(=$b_1$-$\pi$) at which the power PD becomes minimum in the trigonometric function (that is, $b_1$-XP=$\pi$ is satisfied) is set in the third order distortion vector adjuster 1240a.

In the calculation method employing the quadratic function approximation, when a coefficient $a_2$ becomes 0 or smaller or when no coefficient of a quadratic function is obtained, a phase value at which power becomes minimum among measured power may be set as XP$_{MIN}$. Further, an amplitude value is set after setting of a phase value in this example. However, when sensitivity of a distortion component which is generated in the power amplifier 230 is higher with respect to an amplitude value than with respect to a phase value, for example, setting of an amplitude value may be performed first.

It is necessary to set R to at least 3 so as to specify a quadratic function by using the least square method. However, increase of R can bring further-accurate approximation, so that R may be set to a value which is larger than 3 to the extent permitted by a requirement condition such as calculation time. Further, it is simplest that R is set to have same numbers between setting of a phase value and setting of an amplitude value. However, when approximation accuracy of either one of a phase value and an amplitude value needs to be enhanced, R may be set to have different values in setting of a phase value and setting of an amplitude value.

<Adjustment of Sub Third Order Distortion Vector Adjuster 1340a>

Adjustment of the sub third order distortion vector adjuster 1340a is same as that of the third order distortion vector adjuster 1240a.

<Adjustment of Third Order Distortion Vector Adjuster 1240b and Sub Third Order Distortion Vector Adjuster 1340b>

In adjustment of the third order distortion vector adjuster 1240b and the sub third order distortion vector adjuster 1340b, either one band between the third order distortion component upper side band 3DU2 and the third order distortion component lower side band 3DL2 is designated, and phase values and amplitude values of the third order distortion vector adjuster 1240b and the sub third order distortion vector adjuster 1340b are respectively adjusted in a procedure similar to the adjustment of the third order distortion vector adjuster 1240a so as to reduce power in the band. In this case, values of R may be set to different values from the case of the third order distortion vector adjuster 1240a depending on required approximation accuracy.

In a case employing the perturbation method, a larger amount of distortion compensation of a predistorter may be obtained compared to the calculation method employing quadratic function approximation, though processing time for setting of a phase value and an amplitude value takes a longer period of time. On the other hand, in a case where the calculation method using the quadratic function approximation is employed, a phase value and an amplitude value can be respectively set in a shorter period of time than the perturbation method. Setting of a phase value and an amplitude value may be arbitrarily selected depending on time required for processing or a distortion compensation amount to be obtained. Further, methods may be combined without selecting one of the methods.

[Adjustment Processing Flow P12 of Embodiment 1]

Distortion components, which are generated in the power amplifier 230, of respective bands have a relation to depend on each other. Therefore, when adjustment is performed only once in each of adjustment of the third order distortion vector adjuster 1240a to adjustment of the sub third order distortion vector adjuster 1340b as the adjustment processing flow P11, distortion components may not be able to be sufficiently compensated by a predistorter. In this case, an adjustment processing flow P12 may be employed as the processing flow of the controller 1410.

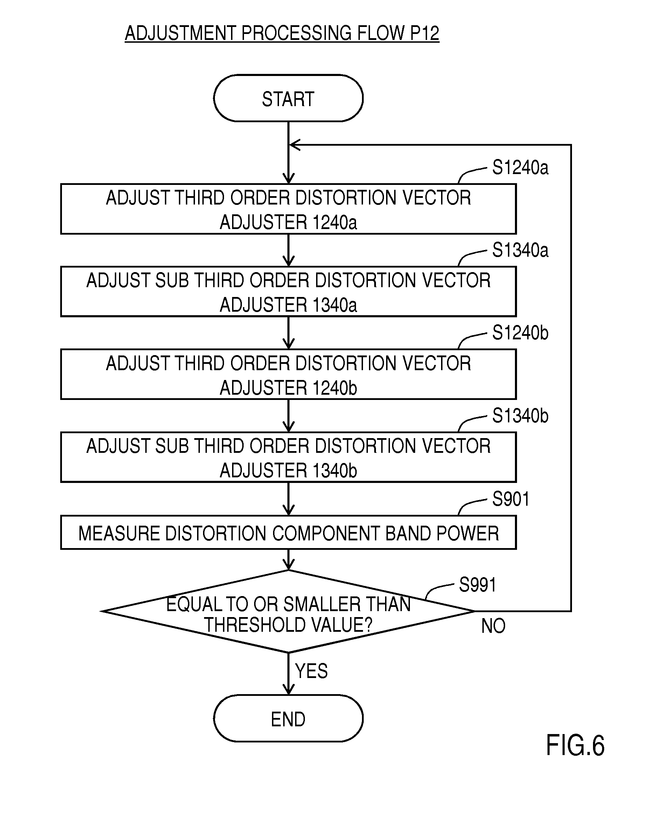

Fig. 6 illustrates the adjustment processing flow P12 in which the controller 1410 of this embodiment controls the distortion compensation signal generation path 110. In the adjustment processing flow P12, power of respective bands of distortion components is measured by the distortion monitor 1420 after adjustment up to adjustment of the sub third order distortion vector adjuster 1340b is performed by processing same as the adjustment processing flow P11 (S901). Whether or not all the measured power in the bands is equal to or smaller than a predetermined threshold value P$_{TH}$ is determined (S991). When all the measured power of the bands is equal to or smaller than the threshold value P$_{TH}$, the adjustment processing flow P12 is ended. When the condition is not satisfied, the flow returns to the adjustment of the third order distortion vector adjuster 1240a (S1240a). A series of repeating processing is repeated until the condition is satisfied in S991 or repeated predetermined times.

As mentioned above, distortion components have a relation to depend on each other. Therefore, when this is highly influential, orders of processing may be set as adjustment of the sub third order distortion vector adjuster 1340a (S1340a), adjustment of the third order distortion vector adjuster 1240a (S1240a), adjustment of the sub third order distortion vector adjuster 1340b (S1340b), and adjustment of the third order distortion vector adjuster 1240b (S1240b), from a viewpoint of reduction of the repeating time. Alternatively, an order of adjustment of the third order distortion vector adjuster 1240a (S1240a), adjustment of the third order distortion vector adjuster 1240b (S1240b), adjustment of the sub third order distortion vector adjuster 1340a (S1340a), and adjustment of the sub third order distortion vector adjuster 1340b (S 1340b) may be employed. Properties may vary depending on power amplifiers, so that an order in which the threshold value $P_{TH}$ or the less is attainable by the smallest repeating times is preliminarily confirmed among combinations to be taken, and the processing may be performed in the confirmed order.

[Adjustment Processing Flow P13 of Embodiment 1]

Adjustment of the third order distortion vector adjuster 1240a to adjustment of the sub third order distortion vector adjuster 1340b are performed in a predetermined order in the adjustment processing flow P11 and the adjustment processing flow P12, but the processing may be performed in parallel as an adjustment processing flow P13. When an influence of the relation of interdependency of distortion components is small, the threshold value $P_{TH}$ or the less may be achieved in a shorter period of processing time by independently performing processing in parallel for respective frequency bands.

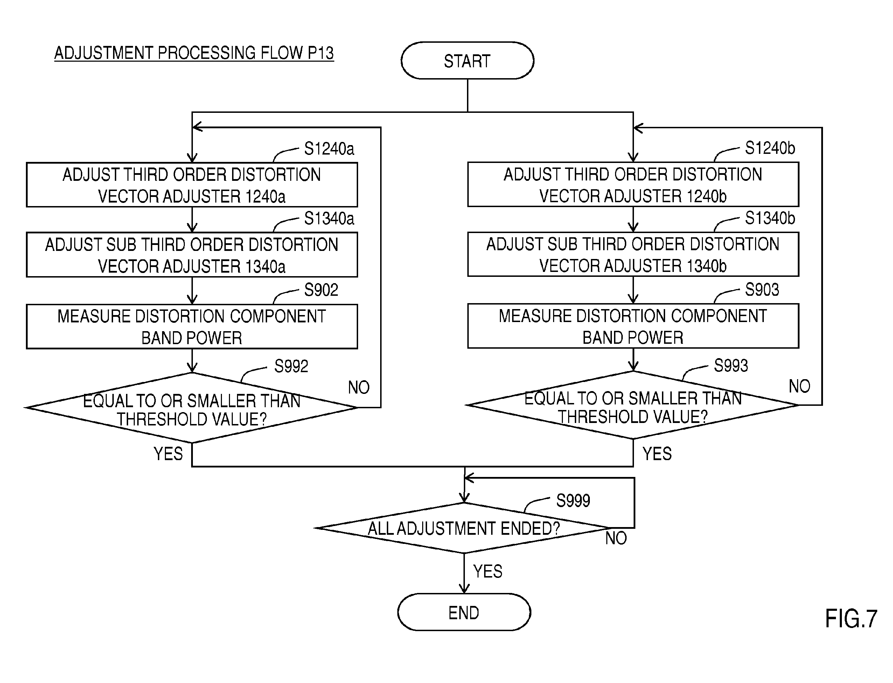

Fig. 7 illustrates the adjustment processing flow P13 in which the controller 1410 of this embodiment controls the distortion compensation signal generation path 110. In the adjustment processing flow P13, adjustment of the third order distortion vector adjuster 1240a (S1240a) and adjustment of the sub third order distortion vector adjuster 1340a (S 1340a) are performed in sequence and power in the third order distortion component lower side band 3DL1 and power in the third order distortion component upper side band 3DU1 are respectively measured (S902). Whether or not all the measured power in the bands is equal to or smaller than a predetermined threshold value $P_{TH}$ is determined (S992). When the condition is not satisfied, the flow returns to the adjustment of the third order distortion vector adjuster 1240a (S1240a). Meanwhile, adjustment of the third order distortion vector adjuster 1240b (S1240b) and adjustment of the sub third order distortion vector adjuster 1340b (S1340b) are performed in sequence and power in the third order distortion component upper side band 3DU2 and power in the third order distortion component lower side band 3DL2 are respectively measured (S903). Whether or not all the measured power in the bands is equal to or smaller than a predetermined threshold value $P_{TH}$ is determined (S993). When the condition is not satisfied, the flow returns to the adjustment of the third order distortion vector adjuster 1240b (S1240b). When the condition is satisfied in both of S992 and S993, the adjustment processing flow P13 is ended (S999).

A value of the threshold value $P_{TH}$ may be set as one value or a threshold value may be set for each band in any of the above-described adjustment processing flows. However, it is preferable to set a threshold value of each band depending on a permissible value of an obtained distortion component. The same goes for every embodiment and modification which will be described later.

Nonlinear characteristic of a power amplifier sometimes depends on average power or instantaneous power of signals which are inputted into the power amplifier. Therefore, a look-up table in which an amplitude and a phase, which are provided to the third order distortion vector adjuster, are referred depending on average power or instantaneous power of signals inputted into the power amplifier may be used. When average power is used as an index, an amplitude and a phase which are to be provided to a third order distortion vector adjuster are preliminarily obtained by using the above-described adjustment processing flow for each predetermined average power and the amplitude and the phase are recorded in the look-up table in a manner to be associated with the average power. When an intended signal is amplified, average power of a signal which is inputted into the predistorter is observed and an amplitude and a phase, which correspond to the average power, of the third order distortion vector adjuster are respectively used. Accordingly, an amplitude and a phase of the third order distortion vector adjuster can be changed depending on average power, so that distortion components may be able to be further compensated compared to a case where an amplitude and a phase are fixed. The same goes for a case where an amplitude and a phase are referred depending on instantaneous power.

[Modification 1 of Embodiment 1]

In order to simplify the configuration of a distortion compensation signal generation path, the configuration of a modification mentioned below may be employed. In this modification, a third order distortion calculator 1370 is provided instead of the sub third order distortion generator 1320, the phase adjusters 1350a and 1350b, the combiner 1360, the sub divider 1330, and the sub digital filters 1310a and 1310b, being able to reduce the number of parts and simplify the configuration of the distortion compensation signal generation path compared to Embodiment 1.

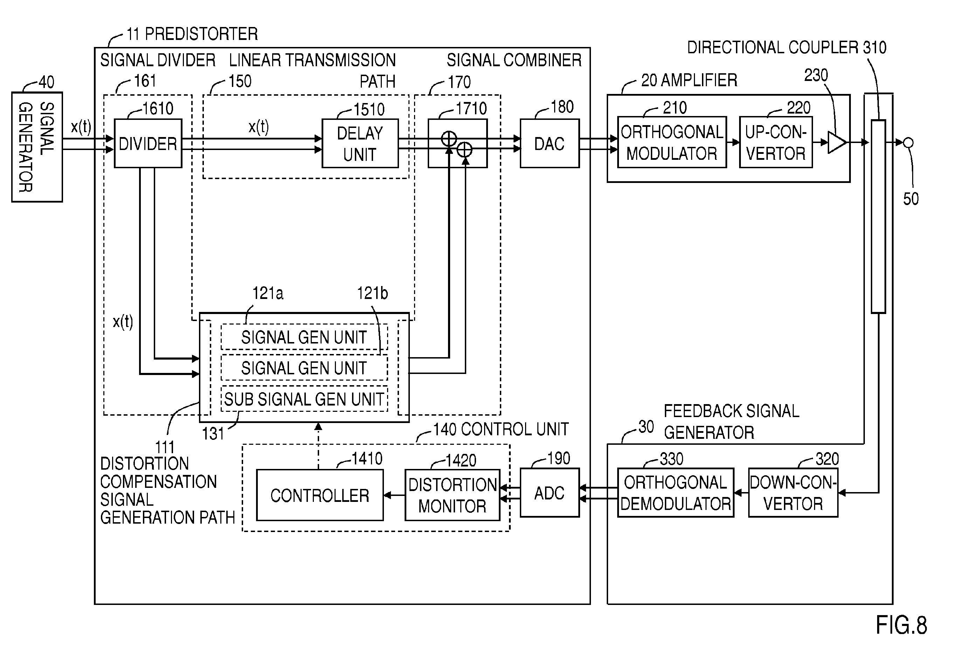

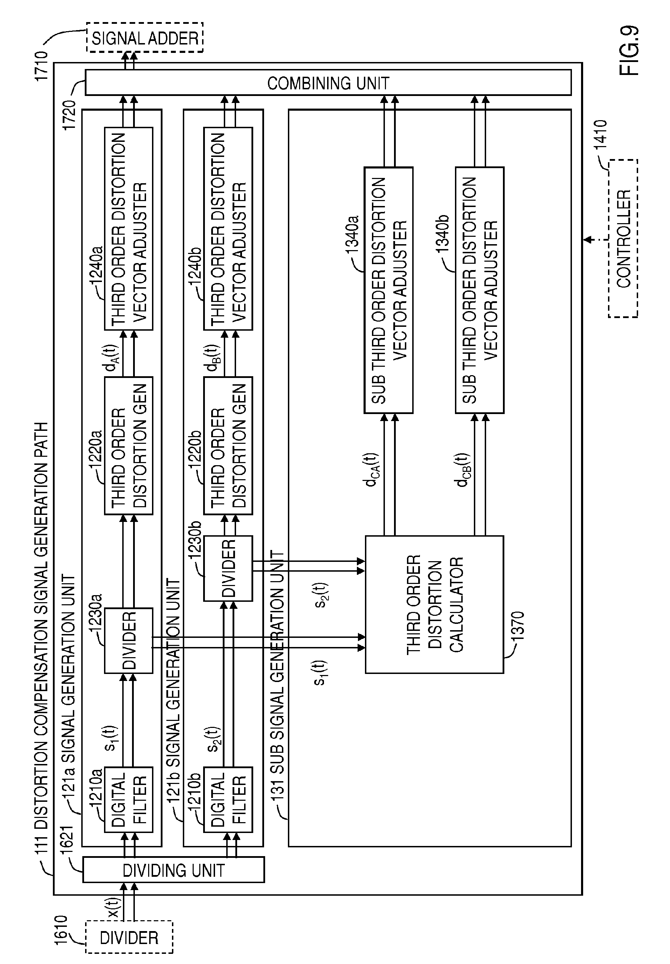

An operation of a predistorter 11 according to Modification 1 of Embodiment 1 of the present invention is described in detail with reference to Figs. 8 and 9. Fig. 8 is a block diagram illustrating the whole configuration of the predistorter 11 and peripheral devices according to this modification. Fig. 9 is a block diagram illustrating the configuration of a distortion compensation signal generation path 111 which is included in the predistorter 11 according to this modification.

The predistorter 11 of this modification includes the distortion compensation signal generation path 111, a control unit 140, a linear transmission path 150, a signal divider 161, a signal combiner 170, a DAC 180, and an ADC 190. The signal divider 161 includes a divider 1610 and a dividing unit 1621. The distortion compensation signal generation path 111 includes signal generation units 121a and 121b and a sub signal generation unit 131. The dividing unit 1621 divides an input signal x(t) which is outputted by the divider 1610 between the plurality of signal generation units 121a and 121b.

The signal generation unit 121a includes a digital filter 1210a, a divider 1230a, a third order distortion generator 1220a, and a third order distortion vector adjuster 1240a. The digital filter 1210a allows only a component of a preliminarily-designated frequency band in an input signal x(t) which is outputted by the dividing unit 1621 to pass therethrough, so as to generate an individual carrier input signal $s_1(t)$. The divider 1230a divides the individual carrier input signal $s_1(t)$ which is outputted by the digital filter 1210a between the sub signal generation unit 131 and the third order distortion generator 1220a. The third order distortion generator 1220a cubes the individual carrier input signal $s_1(t)$ which is outputted by the divider 1230a so as to generate an individual carrier distortion signal $d_A(t)$ for generation of a third order distortion component. The third order distortion vector adjuster 1240a adjusts a phase and an amplitude of the individual carrier distortion signal $d_A(t)$ which is outputted by the third order distortion generator 1220a, on the basis of control information which is provided from the controller 1410 so as to generate an individual carrier distortion compensation signal and output the individual carrier distortion compensation signal to the combining unit 1720.

The signal generation unit 121b includes a digital filter 1210b, a divider 1230b, a third order distortion generator 1220b, and a third order distortion vector adjuster 1240b. The digital filter 1210b allows only a component of a preliminarily-designated frequency band in an input signal x(t) which is outputted by the dividing unit 1621 to pass therethrough, so as to generate an individual carrier input signal $s_2(t)$. The divider 1230b divides the individual carrier input signal $s_2(t)$ which is outputted by the digital filter 1210b between the sub signal generation unit 131 and the third order distortion generator 1220b. The third order distortion generator 1220b cubes the individual carrier input signal $s_2(t)$ which is outputted by the divider 1230b so as to generate an individual carrier distortion signal $d_B(t)$ for generation of a third order distortion component. The third order distortion vector adjuster 1240b adjusts a phase and an amplitude of the individual carrier distortion signal $d_B(t)$ which is outputted by the third order distortion generator 1220b on the basis of control information which is provided from the controller 1410 so as to generate an individual carrier distortion compensation signal and output the individual carrier distortion compensation signal to the combining unit 1720.

The sub signal generation unit 131 includes the third order distortion calculator 1370 and sub third order distortion vector adjusters 1340a and 1340b. The third order distortion calculator 1370 generates carrier inter-modulation distortion signals $d_{CA}(t)$ and $d_{CB}(t)$ from the individual carrier input signal $s_1(t)$ which is outputted by the divider 1230a and the individual carrier input signal $s_2(t)$ which is outputted by the divider 1230b so as to output the carrier inter-modulation distortion signals $d_{CA}(t)$ and $d_{CB}(t)$ to the sub third order distortion vector adjusters 1340a and 1340b respectively. Here, the third order distortion calculator 1370 generates $d_{CA}(t)=2|s_2(t)|^2 s_1(t)$ and $d_{CB}(t)=2|s_1(t)|^2 s_2(t)$ as carrier inter-modulation distortion signals respectively. The sub third order distortion vector adjuster 1340a adjusts a phase and an amplitude of the carrier inter-modulation distortion signal $d_{CA}(t)$ which is outputted by the third order distortion calculator 1370, on the basis of control information which is provided from the controller 1410, so as to generate a carrier inter-modulation distortion compensation signal and output the carrier inter-modulation distortion compensation signal to the combining unit 1720. The sub third order distortion vector adjuster 1340b adjusts a phase and an amplitude of the carrier inter-modulation distortion signal $d_{CB}(t)$ which is outputted by the third order distortion calculator 1370, on the basis of control information which is provided from the controller 1410, so as to generate a carrier inter-modulation distortion compensation signal and output the carrier inter-modulation distortion compensation signal to the combining unit 1720.

The adjustment processing flow in which the controller 1410 of this modification controls the distortion compensation signal generation path 111 is same as that of Embodiment 1.

The case in which the number $N_B$ of frequency bands is set to 2 has been described in Embodiment 1 and Modification 1 above, but the above-mentioned idea is applicable to a case in which $N_B$ is set to 3 or larger, as well. Specifically, in Embodiment 1, for example, $N_B$ pieces of signal generation units are prepared in the distortion compensation signal generation path 110. An individual carrier distortion signal which is outputted by the third order distortion generator included in each of the plurality of signal generation units is adjusted by a phase adjuster so as to be combined with a carrier inter-modulation distortion signal which is outputted by the sub third order distortion generator 1320 which is included in the sub signal generation unit 130. A frequency band in which a distortion component is generated can be calculated by the above-mentioned formula (3). Therefore, sub digital filters are prepared as many as the number of distortion components which are generated in a frequency band same as that of an input signal and a signal which is desired to be transmitted is taken out among signals which are outputted by the combiner 1360 so as to adjust a phase and an amplitude by the sub third order distortion vector adjuster 1340. Alternatively, the third order distortion calculator 1370 may be prepared as the distortion compensation signal generation path 111 in Modification 1 of Embodiment 1, a distortion component which is generated in a frequency band same as that of an input signal may be generated by calculation, sub third order distortion vector adjusters may be prepared as many as the number of distortion components which are generated in the frequency band same as that of the input signal, and a phase and an amplitude of a carrier inter-modulation distortion signal, which is outputted by the third order distortion calculator 1370, may be adjusted by the sub third order distortion vector adjusters.

[Modification 2 of Embodiment 1]

In the configuration of the distortion compensation signal generation path 110 of Embodiment 1, it is impossible to provide a frequency property to a distortion compensation signal. Therefore, a distortion component having frequency dependency cannot be compensated in the predistorter 10 of Embodiment 1. To solve this problem, the configuration of a modification described below may be employed. In this modification, third order distortion frequency property compensators are disposed on subsequent stages of third order distortion vector adjusters respectively, being able to provide a frequency component to a distortion compensation signal.

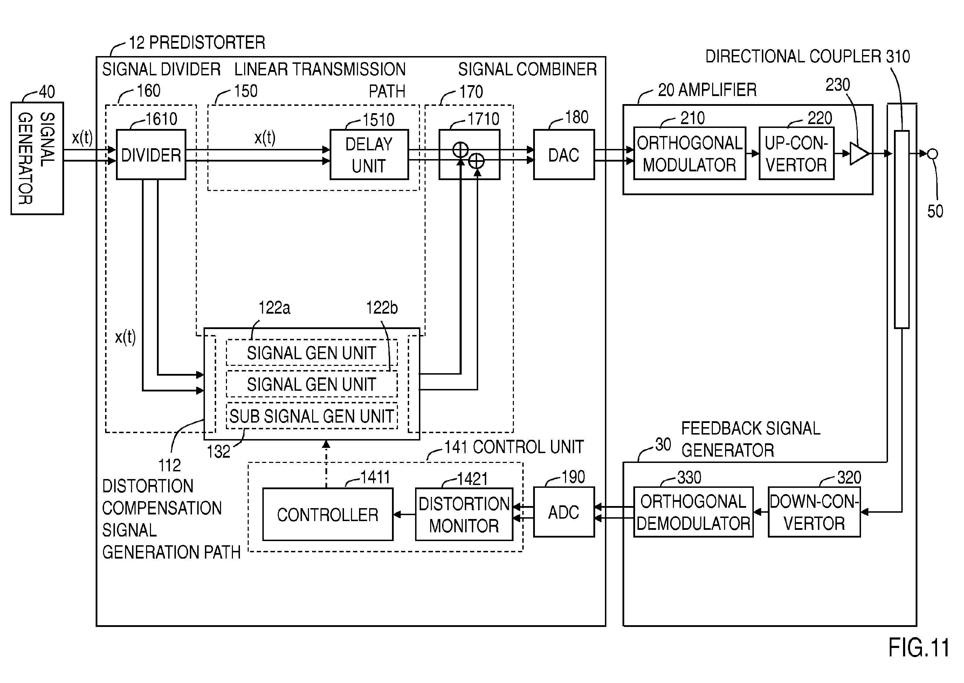

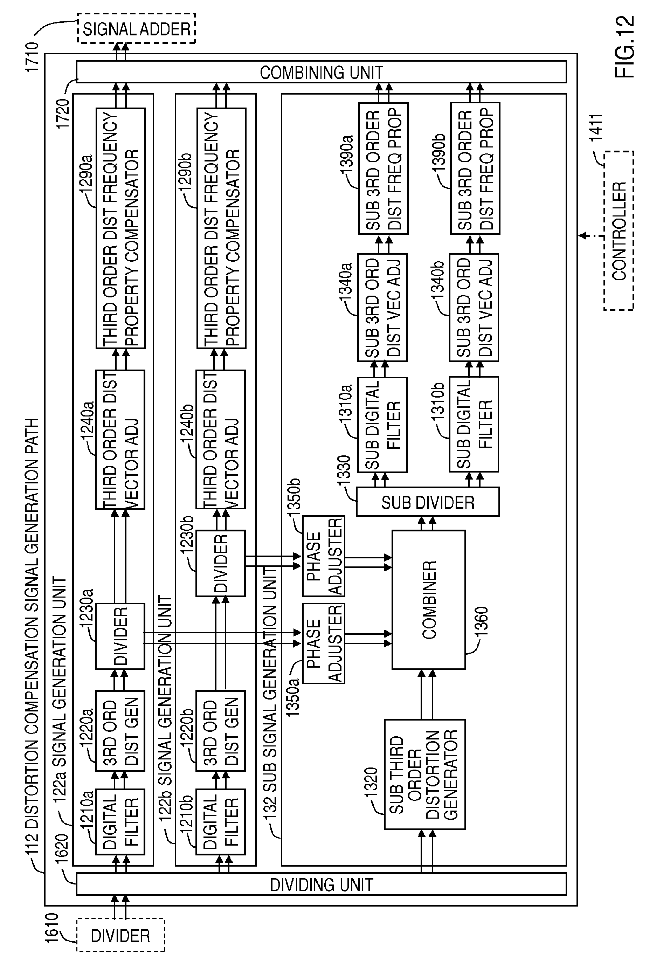

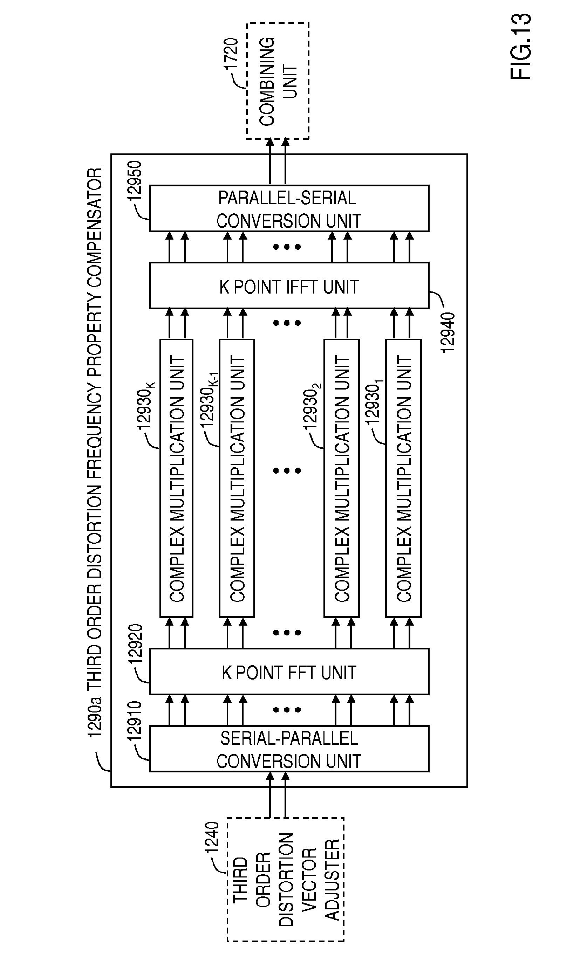

An operation of a predistorter 12 according to Modification 2 of Embodiment 1 of the present invention is described in detail with reference to Figs. 11, 12, and 13. Fig. 11 is a block diagram illustrating the whole configuration of the predistorter 12 and peripheral devices according to this modification. Fig. 12 is a block diagram illustrating the configuration of a distortion compensation signal generation path 112 which is included in the predistorter 12 according to this modification. Fig. 13 is a block diagram illustrating the configuration of a third order distortion frequency property compensator 1290.

The predistorter 12 of this modification includes a distortion compensation signal generation path 112, a control unit 141, a linear transmission path 150, a signal divider 160, a signal combiner 170, a DAC 180, and an ADC 190. The distortion compensation signal generation path 112 includes signal generation units 122a and 122b and a sub signal generation unit 132.

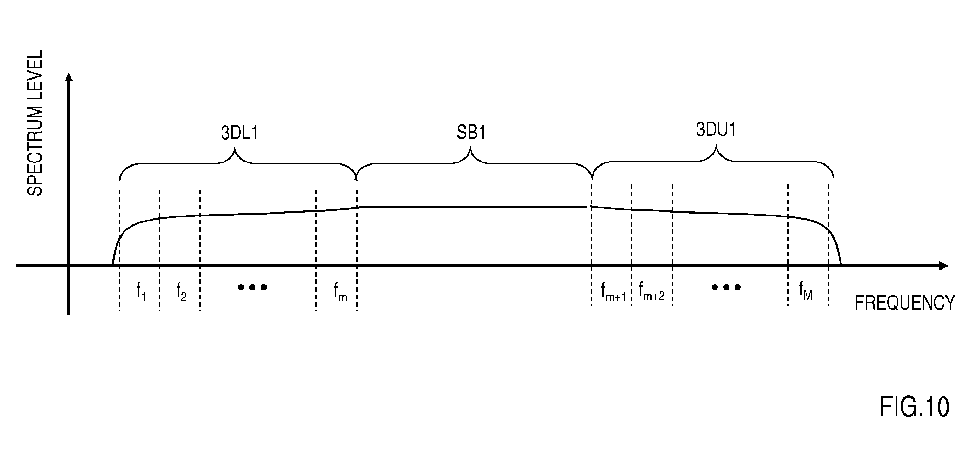

The signal generation unit 122a includes a digital filter 1210a, a third order distortion generator 1220a, a divider 1230a, a third order distortion vector adjuster 1240a, and a third order distortion frequency property compensator 1290a. The third order distortion frequency property compensator 1290a divides a third order distortion component lower side band 3DL1 and a third order distortion component upper side band 3DU1 into M pieces of bands in total ($f_1$, ..., $f_M$) (hereinafter, referred to also as divided bands), as depicted in Fig. 10, in an individual carrier distortion compensation signal which is outputted by the third order distortion vector adjuster 1240a. Then, a phase and an amplitude of the individual carrier distortion compensation signal which is outputted by the third order distortion vector adjuster 1240a are adjusted for each of the divided bands.

An operation of the third order distortion frequency property compensator 1290a is described in detail with reference to Fig. 13. The third order distortion frequency property compensator 1290a includes a serial-parallel conversion unit 12910, a K point fast Fourier transform (FFT) unit 12920, K pieces of complex multiplication units $12930_1$ to $12930_K$, a K point inverse fast Fourier transform (IFFT) unit 12940, and a parallel-serial conversion unit 12950. The serial-parallel conversion unit 12910 serial-parallel-converts individual carrier distortion compensation signals which are outputted by the third order distortion vector adjuster 1240a for every K pieces of samples. The K point FFT unit 12920 performs high-speed Fourier transform for every K pieces of samples (K is a predetermined integer which is larger than M) and converts a signal, which is outputted by the serial-parallel conversion unit 12910 and is indicated by a time domain, into a frequency domain. A signal corresponding to the divided band $f_1$ among signals which are outputted by the K point FFT unit 12920 is inputted into a complex multiplication unit $12930_k$ ($1 \leq k \leq K$) which corresponds to the divided band $f_1$. Then, a phase and an amplitude of the signal which corresponds to the divided band $f_1$ and is inputted into the complex multiplication unit $12930_k$ are respectively adjusted, on the basis of a phase value and an amplitude value which are provided by the controller 1411. The same goes for the divided bands $f_2$ to $f_M$. At this time, outputs, which do not correspond to any divided band, of the K point FFT unit 12920 (outputs corresponding to a band lower than the divided band $f_1$, outputs corresponding to a band higher than the divided band $f_M$, and a band between the third order distortion component lower side band 1 and the third order distortion component upper side band 1, depicted in Fig. 10) are inputted into the K point IFFT unit 12940 while phases and amplitudes of the outputs are not adjusted in the complex multiplication unit. The K point IFFT unit 12940 converts K pieces of signals which are outputted by the complex multiplication units $12930_1$ to $12930_K$ and are indicated by a frequency domain, into signals of a time domain. The parallel-serial conversion unit 12950 performs parallel-serial conversion for every K pieces of samples.

A phase value and an amplitude value which are provided to the complex multiplication units $12930_1$ to $12930_K$ which respectively correspond to the divided bands $f_1$ to $f_M$ are respectively set by the perturbation method or the calculation method using quadratic function approximation, as is the case with adjustment of the third order distortion vector adjuster 1240a. A different point from the adjustment of the third order distortion vector adjuster 1240a is that a band in which power of a distortion component is measured by a distortion monitor 1421 is power in a divided band in which a phase value or an amplitude value is adjusted. For example, when a phase value and an amplitude value of the complex multiplication unit $12930_k$ which corresponds to the divided band $f_1$ are adjusted, power in the divided band $f_1$ is measured by the distortion monitor 1421.

Phase values and amplitude values which are provided to the complex multiplication units $12930_1$ to $12930_K$ may be set from the divided band $f_1$ to the divided band $f_M$ in sequence. At this time, setting of phase values and amplitude values corresponding to the divided bands $f_1$ to $f_M$ may be respectively repeated until a level of a distortion component becomes to be equal to or less than a threshold value $P_{TH}$. Further, an order of divided bands in which phase values and amplitude values are set may be changed depending on a property of the power amplifier 230. For example, there is a case where a divided band in which a level of a distortion component is higher more largely influences on other bands than a divided band in which a level is lower. Therefore, the repeating times may be able to be reduced by performing setting in the order from a divided band, in which a level of a distortion component is higher. Further, phase values or amplitude values of a plurality of divided bands or all divided bands may be simultaneously set. When influence of relation in which distortion components depend on each other is small, time required for setting can be reduced by simultaneously setting phase values or amplitude values.

The third order distortion frequency property compensator 1290a corresponding to the signal $s_1(t)$ of the first frequency band SB1 has been described thus far. The third order distortion frequency property compensator 1290b corresponding to the signal $s_2(t)$ of the second frequency band SB2 has the same configuration and performs the same operation as the third order distortion frequency property compensator 1290a depicted in Fig. 13, and a configuration diagram and description thereof are omitted. The sub third order distortion frequency property compensator 1390a depicted in Fig. 12 and the sub third order distortion frequency property compensator 1390b depicted in Fig. 12 also have the same configuration and perform the same operation as the third order distortion frequency property compensator 1290a depicted in Fig. 13, and a configuration diagram and description thereof are omitted.

[Adjustment Processing Flow P14 of Modification 2 of Embodiment 1]

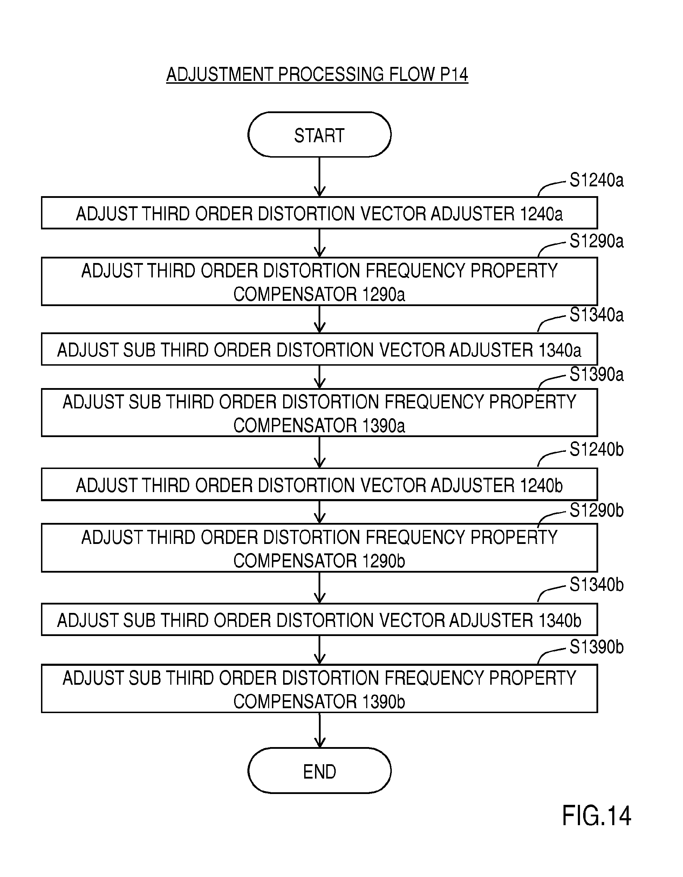

Fig. 14 illustrates an adjustment processing flow P14 in which the controller 1411 of this modification controls the distortion compensation signal generation path 112. In the adjustment processing flow P14, adjustment of the third order distortion vector adjuster 1240a (S1240a), adjustment of the third order distortion frequency property compensator 1290a (S1290a), adjustment of the sub third order distortion vector adjuster 1340a (S1340a), adjustment of the sub third order distortion frequency property compensator 1390a (S1390a), adjustment of the third order distortion vector adjuster 1240b (S1240b), adjustment of the third order distortion frequency property compensator 1290b (S1290b), adjustment of the sub third order distortion vector adjuster 1340b (S1340b), and adjustment of the sub third order distortion frequency property compensator 1390b (S1390b) are performed in sequence.

Due to the same reason as the adjustment processing flow P12 of Embodiment 1, after adjustment up to adjustment of the sub third order distortion frequency property compensator 1390b is performed, power of respective bands of a distortion component may be measured by the distortion monitor 1421 and repetition may be made until all measured power in bands becomes to be equal to or smaller than a predetermined threshold value $P_{TH}$.

[Adjustment Processing Flow P15 of Modification 2 of Embodiment 1]

A third order distortion vector adjuster cannot compensate a distortion component having frequency dependency. Therefore, power in all bands may become to be equal to or smaller than a threshold value $P_{TH}$ with fewer repeating times when a third order distortion frequency property compensator compensates a distortion component having frequency dependency after a third order distortion vector adjuster compensates distortion components. Therefore, an adjustment processing flow P15 described below may be employed as the adjustment processing flow of the controller 1411.

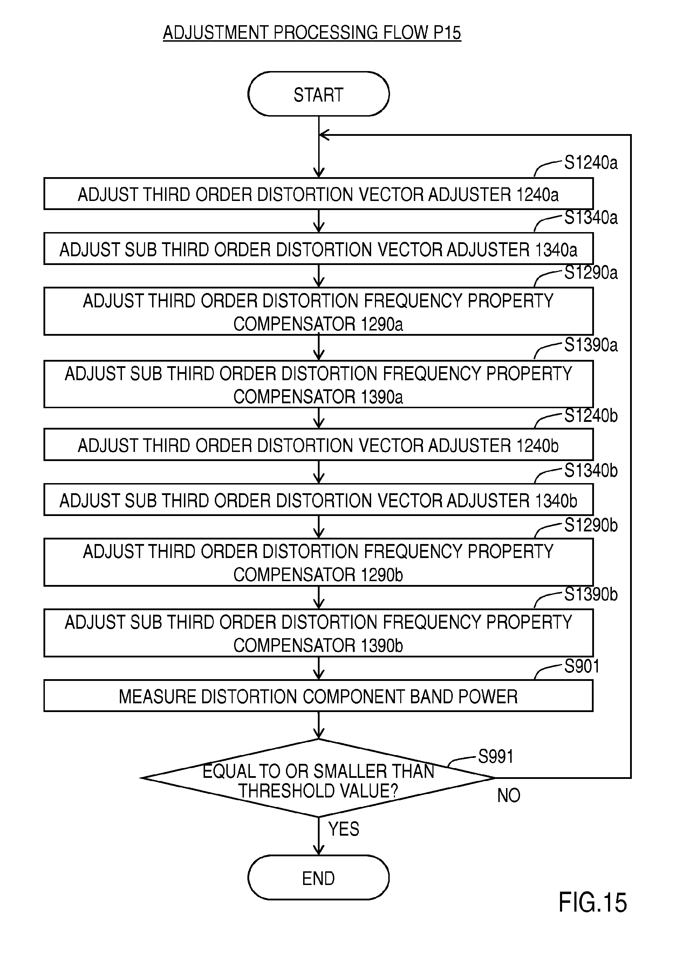

Fig. 15 illustrates the adjustment processing flow P15 in which the controller 1411 of this modification controls the distortion compensation signal generation path 112. In the adjustment processing flow P15, adjustment of the third order distortion vector adjuster 1240a (S1240a), adjustment of the sub third order distortion vector adjuster 1340a (S1340a), adjustment of the third order distortion frequency property compensator 1290a (S1290a), adjustment of the sub third order distortion frequency property compensator 1390a (S1390a), adjustment of the third order distortion vector adjuster 1240b (S1240b), adjustment of the sub third order distortion vector adjuster 1340b (S1340b), adjustment of the third order distortion frequency property compensator 1290b (S1290b), and adjustment of the sub third order distortion frequency property compensator 1390b (S1390b) are performed in sequence. Subsequently, the distortion monitor 1421 measures power of respective bands of the distortion component (S901). Whether or not all the measured power in the bands is equal to or smaller than a predetermined threshold value $P_{TH}$ is determined (S991). When all the measured power of the bands is equal to or smaller than the threshold value $P_{TH}$, the adjustment processing flow P15 is ended. When the condition is not satisfied, the flow returns to the adjustment of the third order distortion vector adjuster 1240a (S1240a). A series of repeating processing is repeated until the condition is satisfied in S991 or repeated predetermined times.

[Adjustment Processing Flow P16 of Modification 2 of Embodiment 1]

Due to the same reason as the adjustment processing flow P15 of Modification 2 of Embodiment 1, the adjustment processing flow of the controller 1411 may be configured as an adjustment processing flow P16 described below.

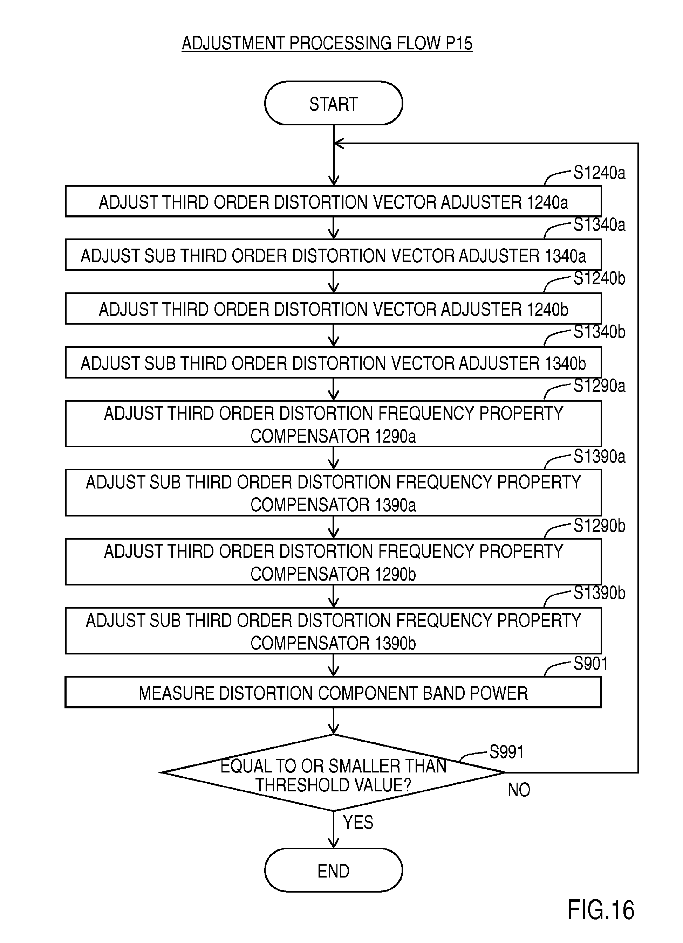

Fig. 16 illustrates the adjustment processing flow P16 in which the controller 1411 of this modification controls the distortion compensation signal generation path 112. In the adjustment processing flow P16, adjustment of the third order distortion vector adjuster 1240a (S1240a), adjustment of the sub third order distortion vector adjuster 1340a (S1340a), adjustment of the third order distortion vector adjuster 1240b (S1240b), adjustment of the sub third order distortion vector adjuster 1340b (S1340b), adjustment of the third order distortion frequency property compensator 1290a (S1290a), adjustment of the sub third order distortion frequency property compensator 1390a (S1390a), adjustment of the third order distortion frequency property compensator 1290b (S1290b), and adjustment of the sub third order distortion frequency property compensator 1390b (S1390b) are performed in sequence. Subsequently, the distortion monitor 1421 measures power of respective bands of the distortion component (S901). Whether or not all the measured power in the bands is equal to or smaller than a predetermined threshold value $P_{TH}$ is determined (S991). When all the measured power of the bands is equal to or smaller than the threshold value $P_{TH}$, the adjustment processing flow P16 is ended. When the condition is not satisfied, the flow returns to the adjustment of the third order distortion vector adjuster 1240a (S1240a). A series of repeating processing is repeated until the condition is satisfied in S991 or repeated predetermined times.

[Adjustment Processing Flow P17 of Modification 2 of Embodiment 1]

Due to the same reason as the adjustment processing flow P13 of Embodiment 1, the adjustment processing flow of the controller 1411 may be configured as an adjustment processing flow P17 described below.

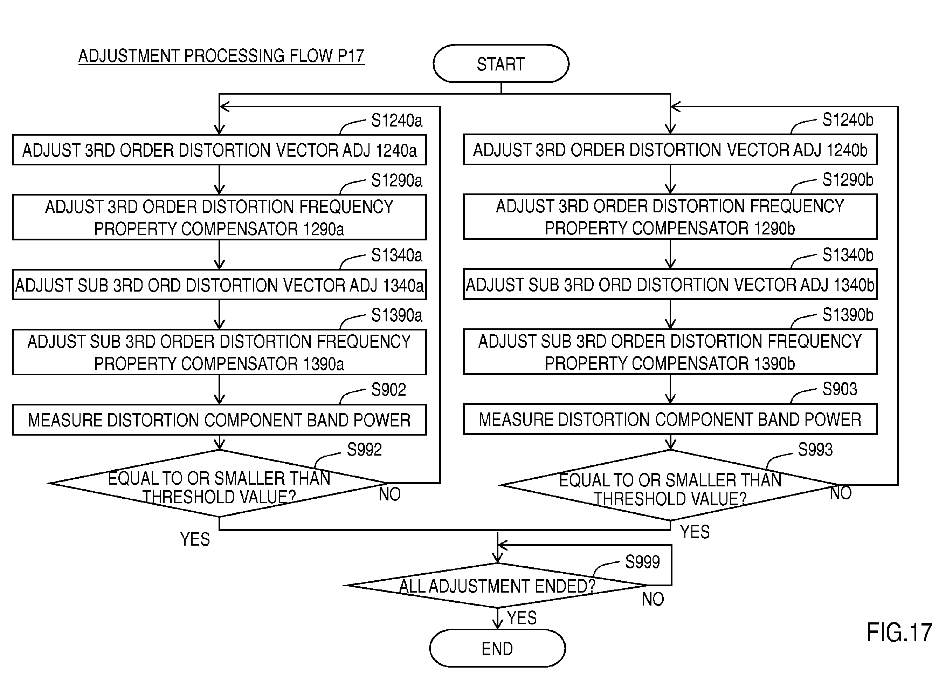

Fig. 17 illustrates the adjustment processing flow P17 in which the controller 1411 of this modification controls the distortion compensation signal generation path 112. In the adjustment processing flow P17, adjustment of the third order distortion vector adjuster 1240a (S1240a), adjustment of the third order distortion frequency property compensator 1290a (S1290a), adjustment of the sub third order distortion vector adjuster 1340a (S1340a), and adjustment of the sub third order distortion frequency property compensator 1390a (S1390a) are performed in sequence and power in the third order distortion component upper side band 3DU1 and power in the third order distortion component lower side band 3DL1 are respectively measured (S902). Whether or not all the measured power in the bands is equal to or smaller than a predetermined threshold value $P_{TH}$ is determined (S992). When the condition is not satisfied, the flow returns to the adjustment of the third order distortion vector adjuster 1240a (S1240a). Meanwhile, adjustment of the third order distortion vector adjuster 1240b (S1240b), adjustment of the third order distortion frequency property compensator 1290b (S1290b), adjustment of the sub third order distortion vector adjuster 1340b (S1340b), and adjustment of the sub third order distortion frequency property compensator 1390b (S1390b) are performed in sequence and power in the third order distortion component upper side band 3DU2 and power in the third order distortion component lower side band 3DL2 are respectively measured (S903). Whether or not all the measured power in the bands is equal to or smaller than a predetermined threshold value $P_{TH}$ is determined (S993). When the condition is not satisfied, the flow returns to the adjustment of the third order distortion vector adjuster 1240b (S1240b). When the condition is satisfied in both of S992 and S993, the adjustment processing flow P17 is ended (S999).

Due to the same reason as the adjustment processing flow P15 of Modification 2 of Embodiment 1, adjustment of the third order distortion vector adjuster 1240a (S1240a), adjustment of the sub third order distortion vector adjuster 1340a (S1340a), adjustment of the third order distortion frequency property compensator 1290a (S1290a), and adjustment of the sub third order distortion frequency property compensator 1390a (S1390a) may be performed in sequence. Further, adjustment of the third order distortion vector adjuster 1240b (S1240b), adjustment of the sub third order distortion vector adjuster 1340b (S1340b), adjustment of the third order distortion frequency property compensator 1290b (S1290b), and adjustment of the sub third order distortion frequency property compensator 1390b (S1390b) may be performed in sequence.

In this modification, the third order distortion frequency property compensators are disposed on subsequent stages of all third order distortion vector adjusters respectively. However, such case is conceivable that frequency dependency is small in a specific distortion component depending on a property of the power amplifier 230. In this case, a third order distortion frequency property compensator corresponding to a distortion component having small frequency dependency does not have to be disposed. For example, when frequency dependency of a distortion component corresponding to the sub third order distortion vector adjuster 1340b is small, the sub third order distortion frequency property compensator 1390b does not have to be disposed.

[Embodiment 2]

In a case where intervals among frequency bands are wide when a signal using two or more different frequency bands is amplified by a power amplifier, it is conceivable that a sampling theorem cannot be satisfied by a single DAC. In addition, when a predistorter includes a single DAC, increase of a frequency interval causes increase of a sampling rate of the DAC, bringing increase of power consumption of the DAC. To solve this problem, the configuration of Embodiment 2 can be employed.

A predistorter 13 of this embodiment is different from the predistorter 10 of Embodiment 1 (Figs. 2 and 3) in that $N_B$ pieces of combinations of a linear transmission path, a signal adder, and a DAC are provided, namely, the combinations are provided as many as the number of frequency bands, outputs of a distortion compensation signal generation path are provided as many as the number $N_B$ of frequency bands, signals from a signal generator are divided among the $N_B$ pieces of linear transmission paths and the distortion compensation signal generation path respectively, and each of the linear transmission paths has a digital filter. An amplifier is different in that combinations of an orthogonal modulator and an up-converter are provided as many as the number $N_B$ of frequency bands and a power combiner which combines signals outputted from the $N_B$ pieces of up-converters is provided. Therefore, a signal which travels via the power combiner is inputted into the power amplifier 230.

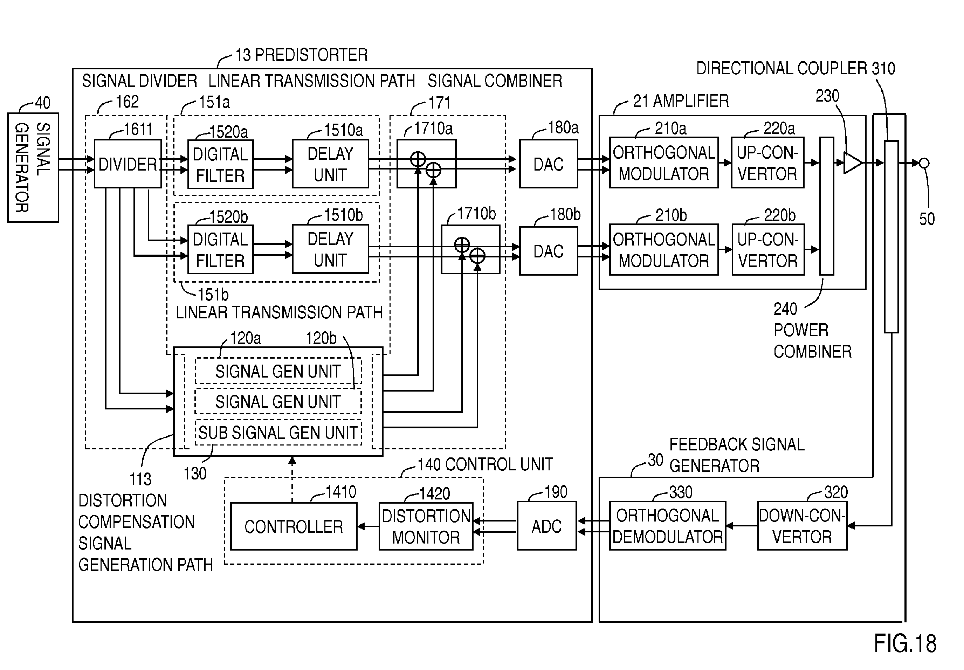

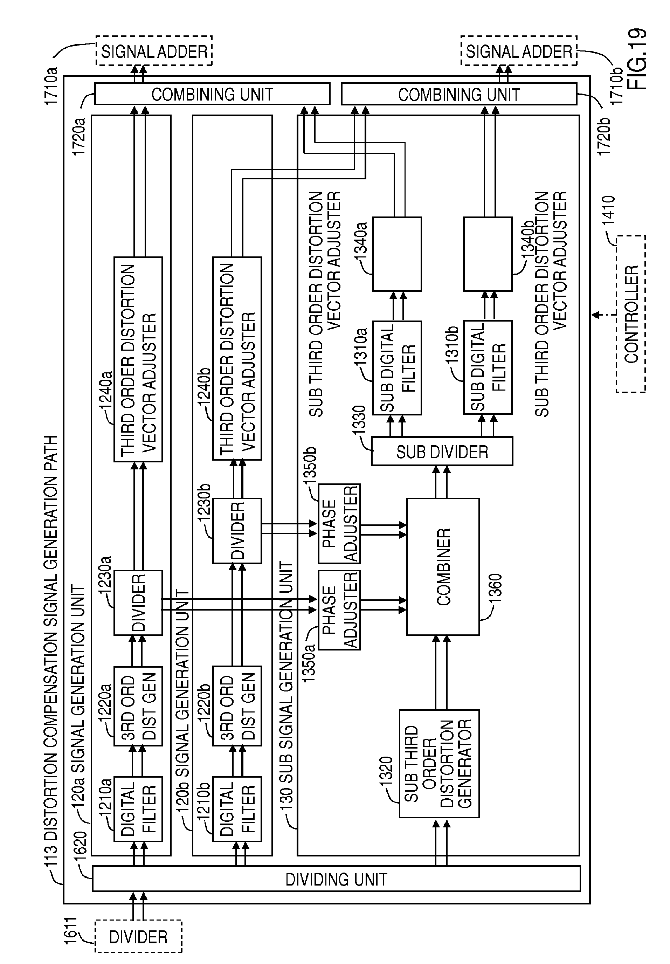

An operation of the predistorter 13 according to Embodiment 2 of the present invention is described in detail with reference to Figs. 18 and 19. Fig. 18 is a block diagram illustrating the whole configuration of the predistorter 13 and peripheral devices according to this embodiment. Fig. 19 is a block diagram illustrating the configuration of a distortion compensation signal generation path 113 which is included in the predistorter 13 according to this embodiment. The peripheral devices of this embodiment are a signal generator 40, an amplifier 21, a feedback signal generator 30, and an output terminal 50.

The predistorter 13 of this embodiment includes the distortion compensation signal generation path 113, a control unit 140, linear transmission paths 151a and 151b, a signal divider 162, a signal combiner 171, a DAC 180a, a DAC 180b, and an ADC 190.

The signal divider 162 includes a divider 1611 and a dividing unit 1620. The divider 1611 divides an input signal which is outputted by the signal generator 40 among the linear transmission paths 151a and 151b and the distortion compensation signal generation path 113.

The linear transmission path 151a includes a delay unit 1510a and a digital filter 1520a. The digital filter 1520a allows a signal using the first frequency band, in an input signal which is outputted by the divider 1611, to pass therethrough, so as to generate an individual carrier input signal $s_1(t)$. The delay unit 1510a delays the individual carrier input signal $s_1(t)$ which is outputted by the digital filter 1520a so that the delay agrees with delay time of a distortion compensation signal which is inputted into a signal adder 1710a via the distortion compensation signal generation path 113. In a similar manner, the linear transmission path 151a includes a delay unit 1510b and a digital filter 1520b. The digital filter 1520b allows a signal using the second frequency band, in an input signal which is outputted by the divider 1611, to pass therethrough, so as to generate an individual carrier input signal $s_2(t)$. The delay unit 1510b delays the individual carrier input signal $s_2(t)$ which is outputted by the digital filter 1520b so that the delay agrees with delay time of a distortion compensation signal which is inputted into a signal adder 1710b via the distortion compensation signal generation path 113.

The signal combiner 171 includes the adders 1710a and 1710b and combining units 1720a and 1720b. The adder 1710a combines a signal which is outputted by the linear transmission path 151a with a signal which is outputted by the combining unit 1720a. The adder 1710b combines a signal which is outputted by the linear transmission path 151b with a signal which is outputted by the combining unit 1720b. The combining units 1720a and 1720b will be described in description of the distortion compensation signal generation path 113 which will be mentioned later.

The DAC 180a converts a digital signal which is outputted by the signal adder 1710a into an analog signal. In a similar manner, the DAC 180b converts a digital signal which is outputted by the signal adder 1710b into an analog signal.

The amplifier 21 includes orthogonal modulators 210a and 210b, up-converters 220a and 220b, a power amplifier 230, and a power combiner 240. The orthogonal modulator 210a orthogonally modulates an analog signal which is outputted by the DAC 180a. In a similar manner, the orthogonal modulator 210b orthogonally modulates an analog signal which is outputted by the DAC 180b. The up-converter 220a up-converts a signal which is outputted by the orthogonal modulator 210a into a signal of target frequency. In a similar manner, the up-converter 220b up-converts a signal which is outputted by the orthogonal modulator 210b into target frequency. The power combiner 240 combines signals which are outputted by the up-converters 220a and 220b. The power amplifier 230 amplifies a signal which is outputted by the power combiner 240 to obtain target power. When a signal which uses different frequency bands can be up-converted to a signal of a predetermined frequency by a single up-converter, such configuration may be employed that outputs of the orthogonal modulators 210a and 210b are combined by the power combiner 240 and the output is up-converted by a single up-converter, from a viewpoint of reduction of the number of circuit parts.

Delay time of a signal which is outputted from the DAC 180a to be inputted into the power combiner 240 via the orthogonal modulator 210a and the up-converter 220a and delay time of a signal which is outputted from the DAC 180b to be inputted into the power combiner 240 via the orthogonal modulator 210b and the up-converter 220b are adjusted so as to be same as each other. When large difference is generated between delay time, difference is generated between a distortion compensation signal which is generated in the predistorter 13 and a distortion component which is generated in the power amplifier 230. Accordingly, a distortion compensation amount may be degraded.

When frequency bands used by the predistorter 13 are expressed by each center frequency $F_{C1}$ and $F_{C2}=F_{C1}+\Delta F_C$, the DAC 180a digital-analog-converts a signal using $F_{C1}$ and the DAC 180b digital-analog-converts a signal using $F_{C2}$. In this case, the DAC 180b commonly needs to digital-analog-convert a signal of which the center frequency is separated from a direct-current component by $\Delta F_C$, causing rise of a sampling rate. To solve this, a frequency of a signal can be converted between the signal adder 1710b and the DAC 180b so that a direct-current component becomes to be the center. Specifically, conversion from a time domain to a frequency domain is performed by using Fourier conversion so as to shift a frequency by $-\Delta F_C$. Then, conversion from the frequency domain to the time domain is performed by using inverse Fourier conversion. At this time, down-sampling is performed so as to obtain a predetermined sampling rate. A down-sampled signal is inputted into the DAC 180b. The up-converter 220b up-converts an output, which travels through the orthogonal modulator 210b, of the DAC 180b to $F_{C2}$. On the other hand, down-sampling is performed between the signal adder 1710a and the DAC 180a, as well, so as to obtain a predetermined sampling rate, and a down-sampled signal is inputted into the DAC 180a. The up-converter 220a up-converts an output, which travels through the orthogonal modulator 210a, of the DAC 180a to $F_{C1}$. Accordingly, the sampling rate of the DAC can be lowered and increase of a power consumption amount caused by increase of a sampling rate can be avoided. Hereinafter, such configuration may be employed in the configuration using a plurality of DACs.

The distortion compensation signal generation path 113 includes a signal generation unit 120a, a signal generation unit 120b, and a sub signal generation unit 130. The above-mentioned combining unit 1720a combines a signal which is outputted by the third order distortion vector adjuster 1240a included in the signal generation unit 120a with a signal which is outputted by the sub third order distortion vector adjuster 1340a included in the sub signal generation unit 130, so as to generate a distortion compensation signal and output the distortion compensation signal to the signal adder 1710a. In a similar manner, the above-mentioned combining unit 1720b combines a signal which is outputted by the third order distortion vector adjuster 1240b included in the signal generation unit 120b with a signal which is outputted by the sub third order distortion vector adjuster 1340b included in the sub signal generation unit 130, so as to generate a distortion compensation signal and output the distortion compensation signal to the signal adder 1710b.

An adjustment processing flow in which the controller 1410 of this embodiment controls the distortion compensation signal generation path 113 is same as that of Embodiment 1.

[Modification 1 of Embodiment 2]

When a single ADC cannot handle a plurality of frequency bands as is the case with a DAC, the configuration of Modification 1 of Embodiment 2 can be employed.

A predistorter 14 of this modification is different from the predistorter 13 of Embodiment 2 in that ADCs and distortion monitors are provided as many as the number of frequency bands and a controller refers to a measurement result of each of the distortion monitors. A feedback signal generator is different in that a power distributor which distributes an output signal from a directional coupler is included and down-converters and orthogonal demodulators are provided as many as the number of frequency bands.

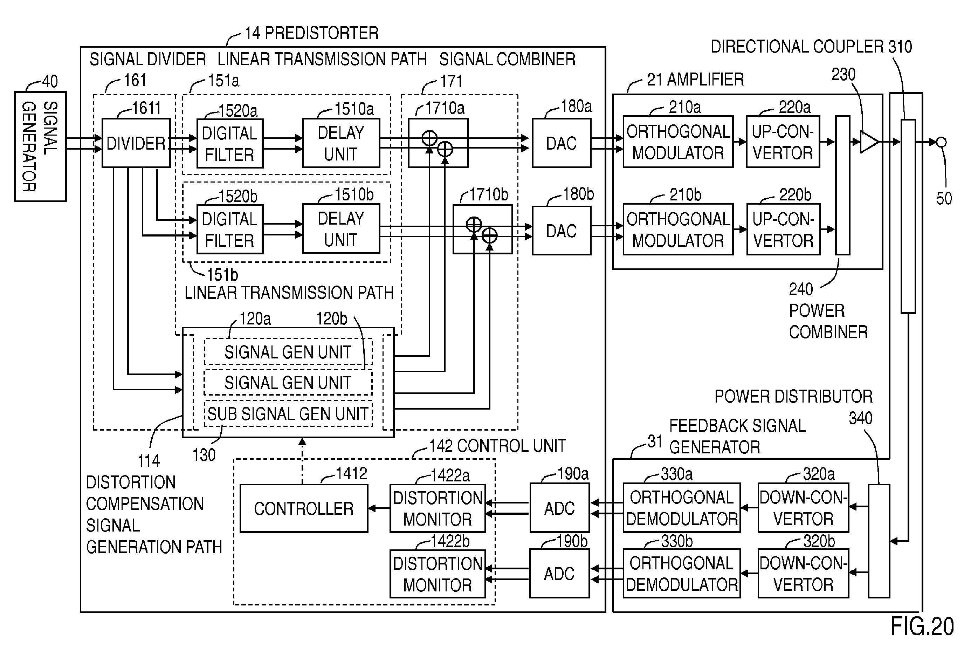

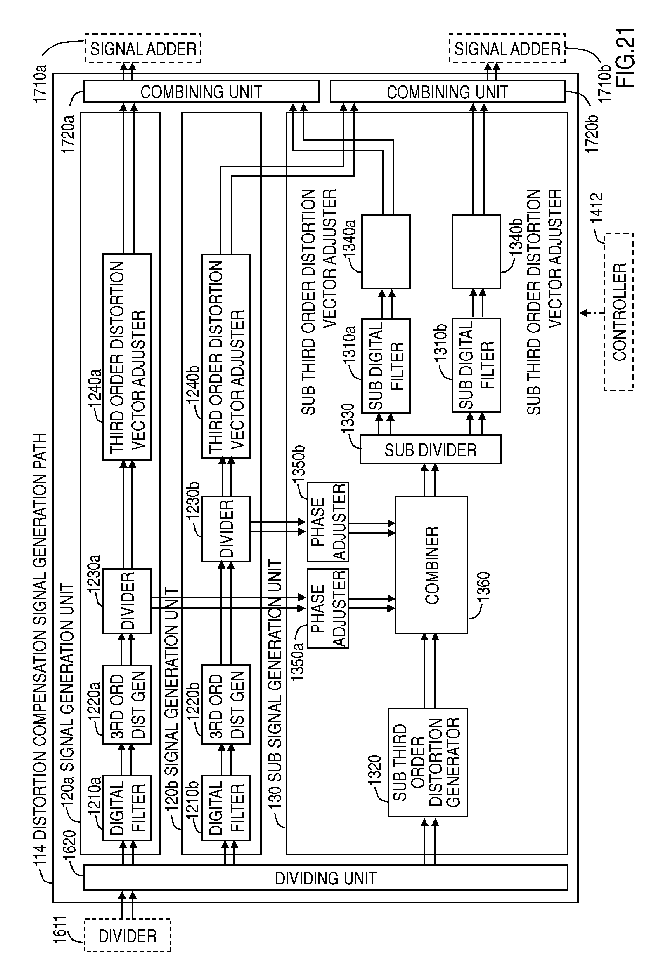

An operation of the predistorter 14 according to Modification 1 of Embodiment 2 of the present invention is described in detail with reference to Figs. 20 and 21. Fig. 20 is a block diagram illustrating the whole configuration of the predistorter 14 and peripheral devices according to this modification. Fig. 21 is a block diagram illustrating the configuration of a distortion compensation signal generation path 114 which is included in the predistorter 14 according to this modification. The peripheral devices of this modification are a signal generator 40, an amplifier 21, a feedback signal generator 31, and an output terminal 50.

The predistorter 14 of this modification includes the distortion compensation signal generation path 114, a control unit 142, linear transmission paths 151a and 151b, a signal divider 161, a signal combiner 171, a DAC 180a, a DAC 180b, an ADC 190a, and an ADC 190b.

The feedback signal generator 31 includes a directional coupler 310, down-converters 320a and 320b, orthogonal demodulators 330a and 330b, and a power distributor 340. The power distributor 340 distributes a feedback signal which is outputted by the directional coupler 310 to the down-converter 320a and the down-converter 320b. The down-converter 320a down-converts a signal which is outputted by the directional coupler 310 to a signal of a predetermined frequency. Here, the down-converter 320a allows only a signal which uses the first frequency band to pass therethrough. In a similar manner, the down-converter 320b down-converts a feedback signal which is outputted by the directional coupler 310 to a signal of a predetermined frequency. Here, the down-converter 320b allows only a signal which uses the second frequency band to pass therethrough. The orthogonal demodulator 330a demodulates a signal which is outputted by the down-converter 320a to an I phase signal and a Q phase signal. In a similar manner, the orthogonal demodulator 330b demodulates a signal which is outputted by the down-converter 320b to an I phase signal and a Q phase signal.

When a bandwidth of the down-converter 320 can be widened, only a single piece of down-converter 320 may be provided to receive an output of the directional coupler 310 and an output of the down-converter 320 may be distributed to the orthogonal demodulators 330a and 330b by the distributor 340, so as to reduce the number of parts.

The control unit 142 includes distortion monitors 1422a and 1422b and a controller 1412. The distortion monitor 1422a observes a distortion component which is generated in the vicinity of the first frequency band and transmits a measurement result to the controller 1412. In a similar manner, the distortion monitor 1422b observes a distortion component which is generated in the vicinity of the second frequency band and transmits a measurement result to the controller 1412.

From the viewpoint that a load on digital signal processing is reduced so as to simply observe a distortion component or the viewpoint that a predistorter is simplified, the distortion monitors 1422a and 1422b may be composed of analog circuits. In this case, as constituent elements of the distortion monitors 1422a and 1422b, bandpass filters and power measurement units which are respectively provided as many as the number of frequency bands of which power is intended to be measured, for example, may be used, namely, two pieces of bandpass filters and two pieces of power measurement units may be used in this example. Further, the ADC 190a is disposed between the distortion monitor 1422a and the controller 1412 and the ADC 190b is disposed between the distortion monitor 1422b and the controller 1412. The distortion monitor 1422a allows only a signal of a frequency band, in which power is desired to be measured by a bandpass filter, of a feedback signal which is outputted by the orthogonal demodulator 330a to pass therethrough and power of a signal which is outputted by the bandpass filter is measured by a power measurement unit. The measurement result is transmitted to the controller 1412 via the ADC 190. At this time, in a case where power in an intended frequency band can be measured from a signal which is outputted by the down-converter 320a, the orthogonal demodulator 330a does not have to be used. In a similar manner, the distortion monitor 1422b allows only a signal of a frequency band, in which power is desired to be measured by a bandpass filter, of a signal which is outputted by the down-converter 320b or a feedback signal which is outputted by the orthogonal demodulator 330b to pass therethrough and power of a signal which is outputted by the bandpass filter is measured by a power measurement unit. The measurement result is transmitted to the controller 1412 via the ADC 190b. At this time, in a case where power in an intended frequency band can be measured from a signal which is outputted by the down-converter 320b, the orthogonal demodulator 330b does not have to be used.

[Modification 2 of Embodiment 2]

In a case where signals which use two different frequency bands simultaneously are generated from respective signal generators, the configuration of Modification 2 of Embodiment 2 may be employed.

A predistorter 15 of this modification is different from the predistorter 13 (Fig. 18) of Embodiment 2 in that two pieces of signal generators 40a and 40b and two pieces of dividers 1610a and 1610b are used and signals of two frequency bands are separately inputted into a distortion compensation signal generation path 115. Difference from the distortion compensation signal generation path 113 (Fig. 19) is that a dividing unit 1622 is composed of two pieces of dividers 1630a and 1630b and a combiner 1640.

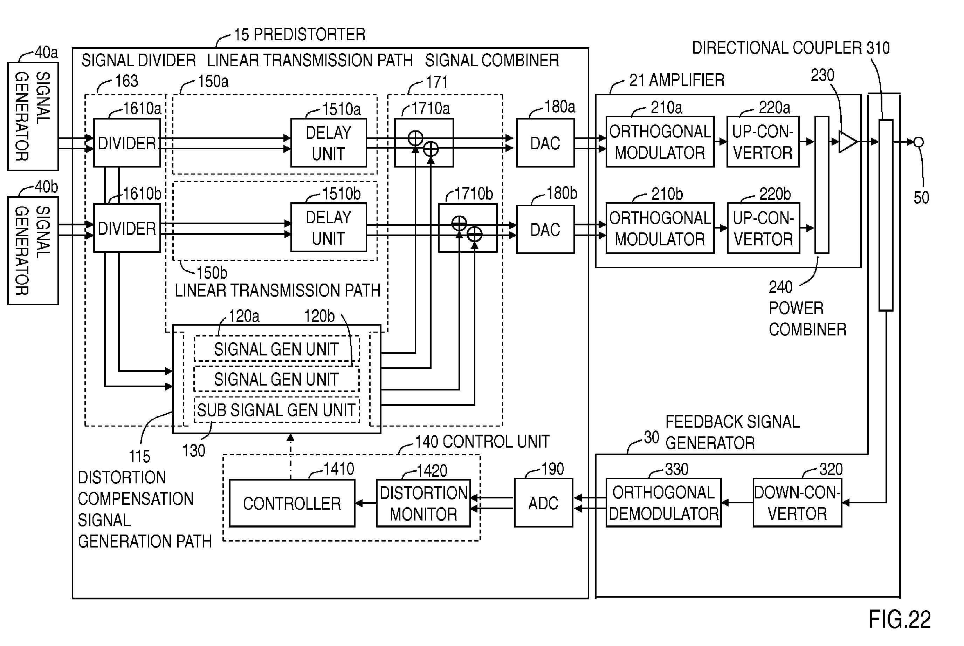

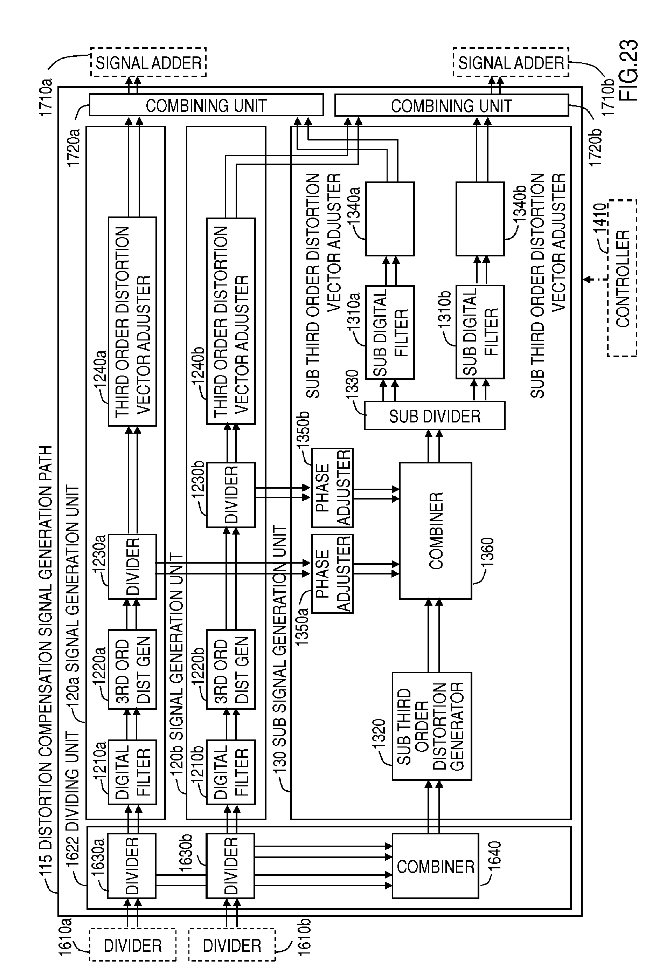

An operation of the predistorter 15 according to Modification 2 of Embodiment 2 of the present invention is described in detail with reference to Figs. 22 and 23. Fig. 22 is a block diagram illustrating the whole configuration of the predistorter 15 and peripheral devices according to this modification. Fig. 23 is a block diagram illustrating the configuration of the distortion compensation signal generation path 115 which is included in the predistorter 15 according to this modification. The peripheral devices of this modification are the signal generators 40a and 40b, an amplifier 21, a feedback signal generator 30, and an output terminal 50. Each of the signal generators 40a and 40b generates a signal of the first frequency band and a signal of the second frequency band and provides the signals to the dividers 1610a and 1610b. In this configuration, both of the signal generators 40a and 40b may generate baseband signals. Accordingly, processing speed of a signal processing unit can be lowered and a predistorter can be realized by a signal processing unit such as a digital signal processor (DSP) and a field programmable array (FPGA) of which an operation clock is low. At this time, the up-converter 220b sets such that a signal, which is outputted from the DAC 180b and travels through the orthogonal modulator 210b has a center frequency which has a predetermined frequency interval with respect to a center frequency of a signal which is outputted from the up-converter 220a.

The predistorter 15 of this modification includes the distortion compensation signal generation path 115, a control unit 140, linear transmission paths 150a and 150b, a signal divider 163, a signal combiner 171, a DAC 180a, a DAC 180b, and an ADC 190.

The signal divider 163 includes dividers 1610a and 1610b and a dividing unit 1622. The divider 1610a divides input signals which are outputted by the signal generator 40a between the linear transmission path 150a and the distortion compensation signal generation path 115. In a similar manner, the divider 1610b divides input signals which are outputted by the signal generator 40b between the linear transmission path 150b and the distortion compensation signal generation path 115. The dividing unit 1622 includes a divider 1630a, a divider 1630b, and a combiner 1640. The divider 1630a divides input signals which are outputted by the divider 1610a between the signal generation unit 120a and the combiner 1640. In a similar manner, the divider 1630b divides input signals which are outputted by the divider 1610b between the signal generation unit 120b and the combiner 1640. The combiner 1640 combines a signal which is outputted by the divider 1630a with a signal which is outputted by the divider 1630b so as to output a signal to the sub signal generation unit 130.

The linear transmission path 150a includes a delay unit 1510a. The delay unit 1510a delays a signal which is outputted by the divider 1610a so that delay time of an output of the delay unit 1510a agrees with delay time of a distortion compensation signal which is inputted into the signal adder 1710a via the distortion compensation signal generation path 115. In a similar manner, the linear transmission path 150b includes a delay unit 1510b. The delay unit 1510b delays a signal which is outputted by the divider 1610b so that delay time of an output of the delay unit 1510b agrees with delay time of a distortion compensation signal which is inputted into the signal adder 1710b via the distortion compensation signal generation path 115.

[Embodiment 3]

In a case where signals which simultaneously use two different frequency bands (hereinafter, a signal having a lower frequency is denoted as a signal S 1 and a signal having a higher frequency is denoted as a signal S2 between the two signals) are amplified in a power amplifier, distortion components are generated not only in vicinities of a band of the signal S1 and a band of the signal S2 but also in frequencies which are separated from center frequencies of respective signals, which are references, by a frequency interval of the signals respectively, in the power amplifier. For example, when a frequency interval of the signal 1 and the signal 2 is set as 100 MHz, distortion components are respectively generated in a frequency which is lower than the center frequency of the signal 1 by 100 MHz and in a frequency which is higher than the center frequency of the signal 2 by 100 MHz. In a communication device having a transmission unit and a reception unit, such distortion components are commonly suppressed by a wireless circuit such as a duplexer, which is not depicted, via an output terminal. However, in a case that a frequency in which a distortion component is generated is same as a frequency which is used for reception, for example, such problems arise that loss from an output terminal to an antenna is increased when a wireless circuit for suppressing a distortion component is added, and cost and a circuit size are increased due to the addition of the wireless circuit. On the other hand, in the configuration of the distortion compensation signal generation path 110 which is included in the predistorter 10 of Embodiment 1, components which compensate these distortion components are respectively suppressed by the sub digital filters 1310a and 1310b. To solve this problem, the configuration of Embodiment 3 may be employed.

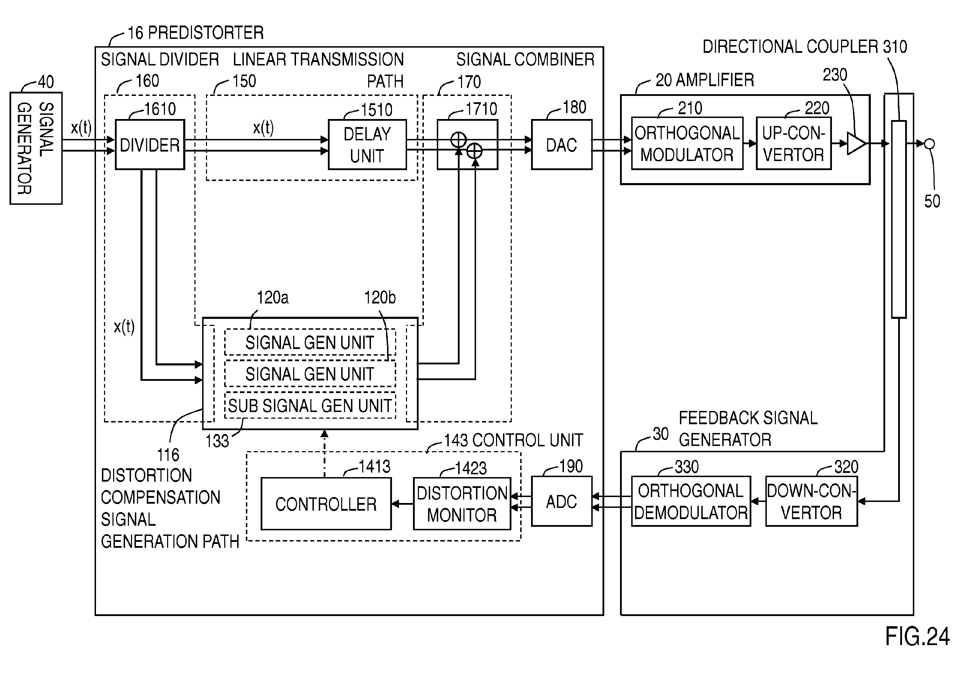

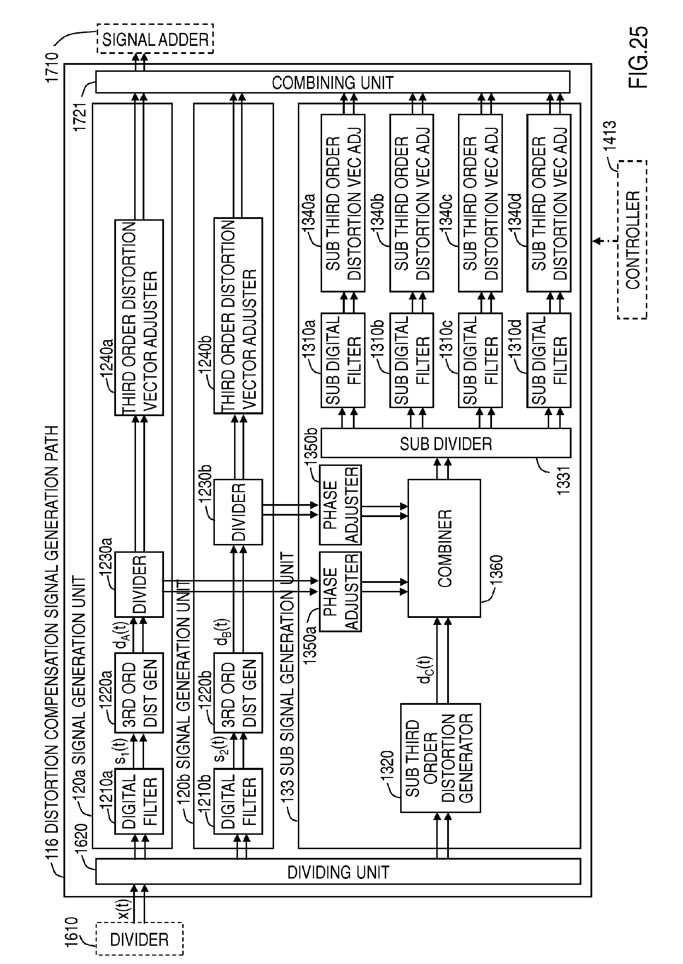

An operation of a predistorter 16 according to Embodiment 3 of the present invention is described in detail with reference to Figs. 24 and 25. Fig. 24 is a block diagram illustrating the whole configuration of the predistorter 16 and peripheral devices according to this embodiment. Fig. 25 is a block diagram illustrating the configuration of a distortion compensation signal generation path 116 which is included in the predistorter 16 according to this embodiment.

The predistorter 16 of this embodiment includes the distortion compensation signal generation path 116, a control unit 143, a linear transmission path 150, a signal divider 160, a signal combiner 170, a DAC 180, and an ADC 190.

The control unit 143 includes a controller 1413 and a distortion monitor 1423. The distortion monitor 1423 is capable of measuring not only power of distortion components in vicinities of the signal S1 and the signal S2 but also power of a distortion component which is generated in a frequency which is lower than the signal S 1 by a frequency interval between the signal S1 and the signal S2 and a distortion component which is generated in a frequency which is higher than the signal S2 by the frequency interval between the signal S1 and the signal S2, on the basis of a signal which is outputted by the ADC 190, for every predetermined bandwidth. Components which are desired to be transmitted via an antenna are not included in frequencies in which these latter two distortion components are generated. Therefore, it is preferable to measure power, in a bandwidth same as that from a lower end of the third order distortion component lower side band 3DL1, which is depicted in Fig. 10, to an upper end of the third order distortion component upper side band 3DU1, which is depicted in Fig. 10, for example, while setting frequencies of these distortion components as centers respectively.

The distortion compensation signal generation path 116 includes the plurality of signal generation units 120a and 120b and a sub signal generation unit 133. The sub signal generation unit 133 includes a sub third order distortion generator 1320, a phase adjuster 1350a, a phase adjuster 1350b, a combiner 1360, a sub divider 1331, sub digital filters 1310a, 1310b, 1310c, and 1310d, and sub third order distortion vector adjusters 1340a, 1340b, 1340c, and 1340d.

The sub divider 1331 divides signals which are outputted by the combiner 1360 among the sub digital filters 1310a, 1310b, 1310c, and 1310d.

The sub digital filter 1310c allows a signal which corresponds to a distortion component which is generated in a frequency which is lower than a center frequency of the signal S 1 by a frequency interval between the signal S1 and the signal S2, so as to generate a sub carrier inter-modulation distortion signal. A bandwidth which the sub digital filter 1310c allows passage is predetermined. The sub third order distortion vector adjuster 1340c adjusts a phase and an amplitude of a sub carrier inter-modulation distortion signal which is outputted by the sub digital filter 1310c, on the basis of control information which is provided by the controller 1413, so as to generate a sub carrier inter-modulation distortion compensation signal and output the sub carrier inter-modulation distortion compensation signal to the combining unit 1721. In a similar manner, the sub digital filter 1310d allows a signal which corresponds to a distortion component which is generated in a frequency which is higher than a center frequency of the signal S2 by a frequency interval between the signal S1 and the signal S2, so as to generate a sub carrier inter-modulation distortion signal. A bandwidth which the sub digital filter 1310d allows passage is predetermined, as well. The sub third order distortion vector adjuster 1340d adjusts a phase and an amplitude of a sub carrier inter-modulation distortion signal which is outputted by the sub digital filter 1310d, on the basis of control information which is provided by the controller 1413, so as to generate a sub carrier inter-modulation distortion compensation signal and output the sub carrier inter-modulation distortion compensation signal to the combining unit 1721.

The combining unit 1721 combines signals which are outputted by the third order distortion vector adjusters 1240a and 1240b and the sub third order distortion vector adjusters 1340a, 1340b, 1340c, and 1340d so as to generate a distortion compensation signal and output the distortion compensation signal to the signal adder 1710.

The case that two separate frequency bands are simultaneously used as described above has been described here. When frequency bands of input signals are close to each other, distortion components which are generated in frequencies which are separated by a frequency interval of the above-described signals is generated in the vicinity of the frequency band of the input signals. Since a distortion compensation signal which compensates this distortion component can be generated by the configuration of this embodiment, this embodiment is applicable to a case that frequency bands of the input signals contact with each other, as well.

[Adjustment Processing Flow P31 of Embodiment 3]

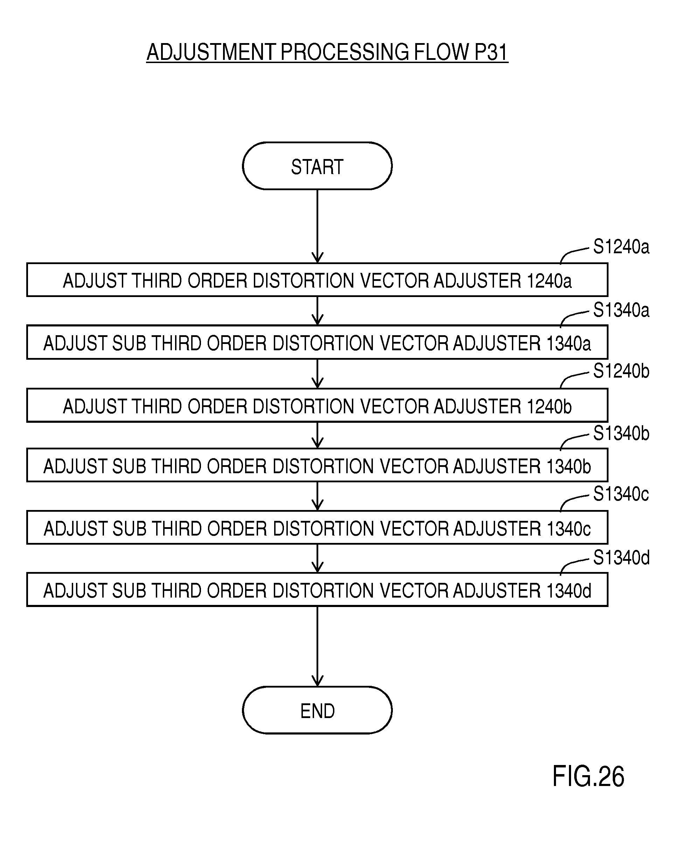

Fig. 26 illustrates an adjustment processing flow P31 in which the controller 1413 of this embodiment controls the distortion compensation signal generation path 116. In the adjustment processing flow P31, adjustment of the third order distortion vector adjuster 1240a (S1240a), adjustment of the sub third order distortion vector adjuster 1340a (S1340a), adjustment of the third order distortion vector adjuster 1240b (S1240b), adjustment of the sub third order distortion vector adjuster 1340b (S1340b), adjustment of the sub third order distortion vector adjuster 1340c (S1340c), and adjustment of the sub third order distortion vector adjuster 1340d (S1340d) are performed in sequence. In the adjustment of the sub third order distortion vector adjuster 1340c, a result which is obtained by measuring power of a distortion component which is generated in the power amplifier 230 and corresponds to a signal which is outputted by the sub digital filter 1310c, by the distortion monitor 1423 is referred and a phase value and an amplitude value are respectively adjusted in a procedure same as the adjustment of the third order distortion vector adjuster 1240a. In a similar manner, in the adjustment of the sub third order distortion vector adjuster 1340d, a result which is obtained by measuring power of a distortion component which is generated in the power amplifier 230 and corresponds to a signal which is outputted by the sub digital filter 1310d, by the distortion monitor 1423 is referred and a phase value and an amplitude value are respectively adjusted in a procedure same as the adjustment of the third order distortion vector adjuster 1240a.

[Adjustment Processing Flow P32 of Embodiment 3]

Due to the same reason as the adjustment processing flow P12 of Embodiment 1, the adjustment processing flow of the controller 1413 may be configured as an adjustment processing flow P32.

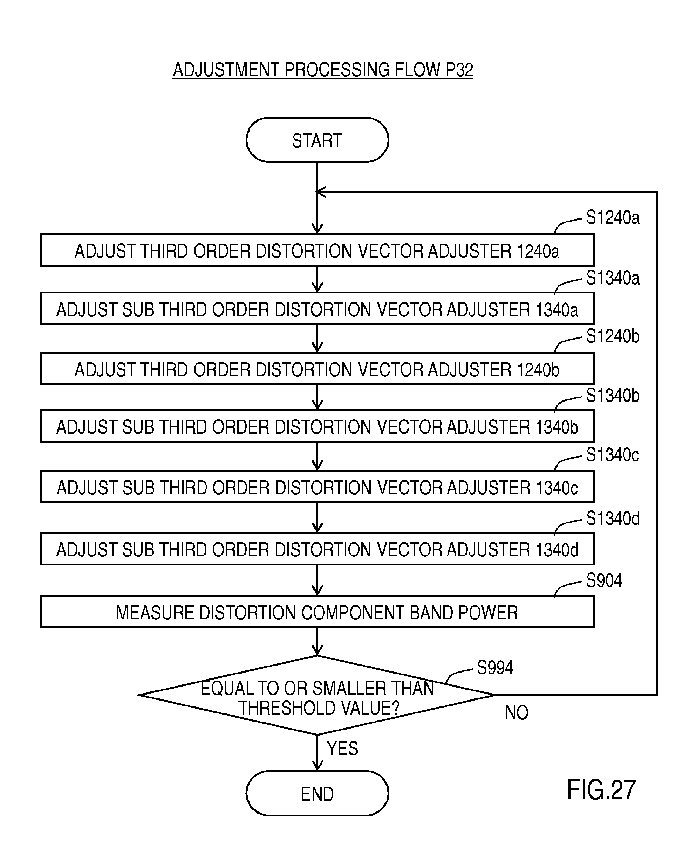

Fig. 27 illustrates the adjustment processing flow P32 in which the controller 1413 of this embodiment controls the distortion compensation signal generation path 116. In the adjustment processing flow P32, power of respective bands of distortion components is measured by the distortion monitor 1423 after adjustment up to adjustment of the sub third order distortion vector adjuster 1340d is performed, by processing same as that of the adjustment processing flow P31 (S904). Whether or not all the measured power in the bands is equal to or smaller than a predetermined threshold value $P_{TH}$ is determined (S994). When all the measured power of the bands is equal to or smaller than the threshold value $P_{TH}$, the adjustment processing flow P32 is ended. When the condition is not satisfied, the flow returns to the adjustment of the third order distortion vector adjuster 1240a (S1240a). A series of repeating processing is repeated until the condition in S994 is satisfied or repeated predetermined times.

In S904, the distortion monitor 1423 measures not only power of distortion components in respective bands but also power in a band of a distortion component which is generated in a frequency which is lower than the center frequency of the signal S 1 by a frequency interval between the signal S1 and the signal S2 and power in a band of a distortion component which is generated in a frequency which is higher than the center frequency of the signal S2 by the frequency interval between the signal S1 and the signal S2.

[Adjustment Processing Flow P33 of Embodiment 3]

When distortion components which are reduced by the sub third order distortion vector adjuster 1340c and the sub third order distortion vector adjuster 1340d do not largely influence on distortion components which are generated in other bands, the adjustment processing flow of the controller 1413 is set as an adjustment processing flow P33 described below, being able to further reduce time required for the adjustment processing due to parallel processing.

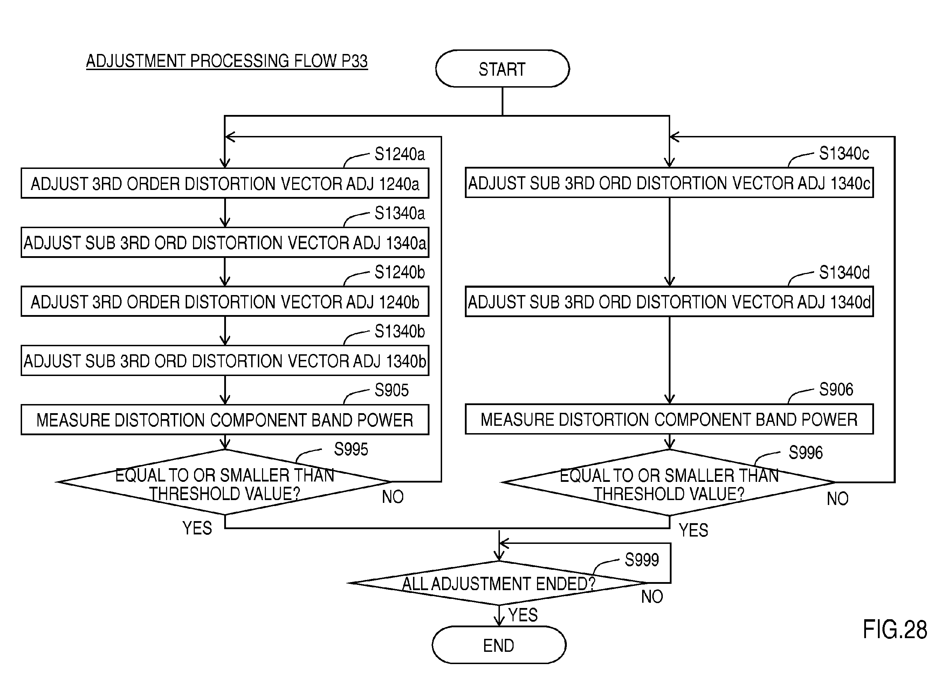

Fig. 28 illustrates the adjustment processing flow P33 in which the controller 1413 of this embodiment controls the distortion compensation signal generation path 116. In the adjustment processing flow P33, adjustment of the third order distortion vector adjuster 1240a (S1240a), adjustment of the sub third order distortion vector adjuster 1340a (S1340a), adjustment of the third order distortion vector adjuster 1240b (S1240b), and adjustment of the sub third order distortion vector adjuster 1340b (S1340b) are performed in sequence and power in the third order distortion component upper side band 3DU1, power in the third order distortion component lower side band 3DL1, power in the third order distortion component upper side band 3DU2, and power in the third order distortion component lower side band 3DL2 are respectively measured (S905). Whether or not all of the measured power in the bands is equal to or smaller than a predetermined threshold value $P_{TH}$ is determined (S995). When the condition is not satisfied, the flow returns to the adjustment of the third order distortion vector adjuster 1240a (S1240a). Meanwhile, adjustment of the sub third order distortion vector adjuster 1340c (S1340c) and adjustment of the sub third order distortion vector adjuster 1340d (S1340d) are performed in sequence and power in a band of a distortion component which is generated in a frequency which is lower than the center frequency of the signal S 1 by a frequency interval between the signal S1 and the signal S2 and power in a band of a distortion component which is generated in a frequency which is higher than the center frequency of the signal S2 by the frequency interval between the signal S1 and the signal S2 are respectively measured (S906). Whether or not all of the measured power in the bands is equal to or smaller than a predetermined threshold value $P_{TH}$ is determined (S996). When the condition is not satisfied, the flow returns to the adjustment of the sub third order distortion vector adjuster 1340c (S1340c). When the condition is satisfied in both of S995 and S996, the adjustment processing flow P33 is ended (S999).

[Adjustment Processing Flow P34 of Embodiment 3]

When influence of relation in which distortion components mutually depend is small, an adjustment processing flow P34 described below is employed as the adjustment processing flow of the controller 1413, being able to expect further reduction of time required for the adjustment processing.

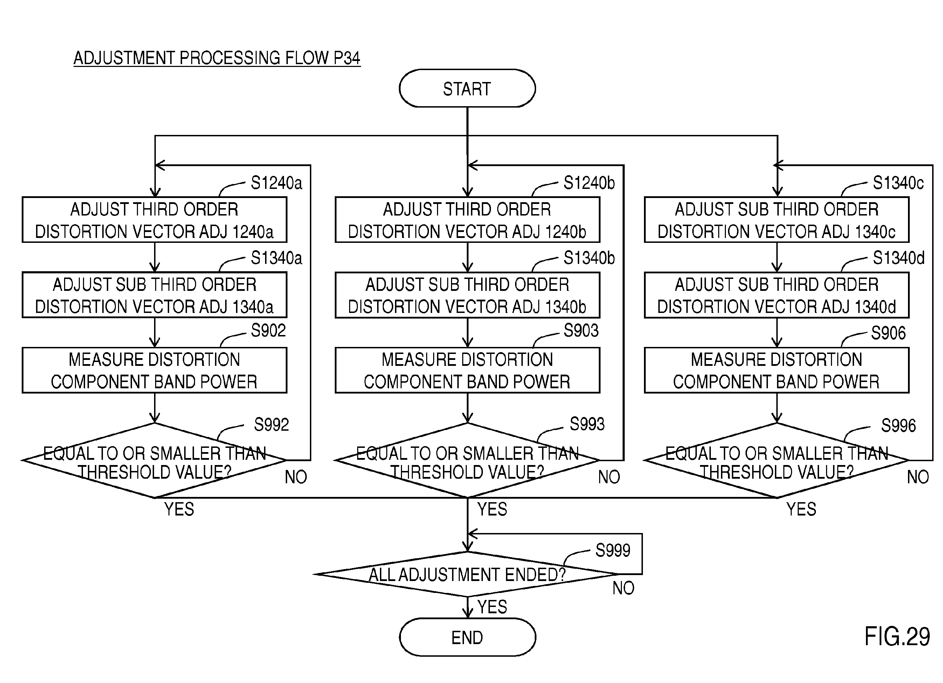

Fig. 29 illustrates the adjustment processing flow P34 in which the controller 1413 of this embodiment controls the distortion compensation signal generation path 116. In the adjustment processing flow P34, adjustment of the third order distortion vector adjuster 1240a (S1240a) and adjustment of the sub third order distortion vector adjuster 1340a (S 1340a) are performed in sequence and power in the third order distortion component upper side band 3DU1 and power in the third order distortion component lower side band 3DL1 are respectively measured (S902). Whether or not all the measured power in the bands is equal to or smaller than a predetermined threshold value $P_{TH}$ is determined (S992). When the condition is not satisfied, the flow returns to the adjustment of the third order distortion vector adjuster 1240a (S1240a). Further, adjustment of the third order distortion vector adjuster 1240b (S1240b) and adjustment of the sub third order distortion vector adjuster 1340b (S 1340b) are performed in sequence and power in the third order distortion component upper side band 3DU2 and power in the third order distortion component lower side band 3DL2 are respectively measured (S903). Whether or not all the measured power in the bands is equal to or smaller than a predetermined threshold value $P_{TH}$ is determined (S993). When the condition is not satisfied, the flow returns to the adjustment of the third order distortion vector adjuster 1240b (S1240b). Meanwhile, adjustment of the sub third order distortion vector adjuster 1340c (S1340c) and adjustment of the sub third order distortion vector adjuster 1340d (S1340d) are performed in sequence and power in a band of a distortion component which is generated in a frequency which is lower than the center frequency of the signal S 1 by a frequency interval between the signal S1 and the signal S2 and power in a band of a distortion component which is generated in a frequency which is higher than the center frequency of the signal S2 by the frequency interval between the signal S1 and the signal S2 are respectively measured (S906). Whether or not all the measured power in the bands is equal to or smaller than a predetermined threshold value $P_{TH}$ is determined (S996). When the condition is not satisfied, the flow returns to the adjustment of the sub third order distortion vector adjuster 1340c (S1340c). When the condition is satisfied in all of S992, S993, and S996, the adjustment processing flow P34 is ended (S999).

In order to further reduce time required for the adjustment processing, the adjustment of the sub third order distortion vector adjuster 1340c (S1340c) and the adjustment of the sub third order distortion vector adjuster 1340d (S1340d) may be performed in parallel. At this time, the adjustment of the sub third order distortion vector adjuster 1340c (S1340c) is performed and power in a band of a distortion component which is generated in a frequency which is lower than the center frequency of the signal S 1 by a frequency interval between the signal S1 and the signal S2 is measured so as to determine whether or not the measured power in the band is equal to or smaller than the predetermined threshold value $P_{TH}$. When the condition is not satisfied, the flow returns to the adjustment of the sub third order distortion vector adjuster 1340c (S1340c). The same goes for the adjustment of the sub third order distortion vector adjuster 1340d (S1340d).

The case that center frequencies of the signal S 1 and the signal S2 are separated from each other as depicted in Fig. 4 has been described here. However, when the center frequencies of the signal S1 and the signal S2 are close to each other, that is, when bands of the signal S1 and the signal S2 are continuous, a similar idea is applicable. However, when a distortion component which is generated in a band same as that of the signal S 1 or in a frequency which is lower than the signal S 1 is compensated, a distortion component of the 3DU1 is not observed but a distortion component only in the band of the 3DL1 is observed because the distortion component of the 3DU1 of Fig. 10 is generated in the band same as the signal S1. When a distortion component is generated only in the band of the 3DL1, an index such as error vector magnitude (EVM) of the signal S2, for example, may be observed so as to adjust an amplitude and a phase of a signal which compensates the distortion component for improvement of the EVM. On the other hand, when a distortion component which is generated in a band same as that of the signal S2 or in a frequency which is higher than the signal S2 is compensated, it is impossible to observe a distortion component of the 3DL2 because the distortion component of the 3DL2 is in a band same as that of the signal S1. Therefore, only a distortion component in the band of the 3DU2 is observed. Further, when bands which the sub digital filters 1310a and 1310c allow passage are overlapped with each other, a distortion component cannot be compensated. Therefore, the configuration using the sub digital filters 1310a, 1310b, 1310c, and 1310d is not employed but it is preferable to employ the configuration in which a third order distortion calculator has a function to generate a distortion component which is generated in a frequency which is lower than the center frequency of the signal S 1 by a frequency interval between the signal S 1 and the signal S2. The same goes for a case that bands which the sub digital filters 1310b and 1310d allow passage are overlapped with each other.

[Modification of Embodiment 3]

In the predistorter 16 of Embodiment 3 as well, when handling is impossible by a single DAC due to the same reason as Embodiment 2, especially, when a distortion compensation signal which compensates a distortion component which is separated from a center frequency of each signal by a frequency interval cannot be outputted by a single DAC, the configuration of Modification of Embodiment 3 may be employed.

A predistorter 17 of this modification is different from the predistorter 16 of Embodiment 3 in that two pieces of DACs are added, there are three combinations outputs of the distortion compensation signal generation path 117, and outputs of a distortion compensation signal generation path are respectively provided to different DACs. An amplifier is different in that orthogonal modulators 210 and up-converters 220 are provided as many as the number of the DACs, a power combiner 240 which combines outputs of the up-converters 220 is included, and a signal which travels through the power combiner 240 is outputted to the power amplifier 230.

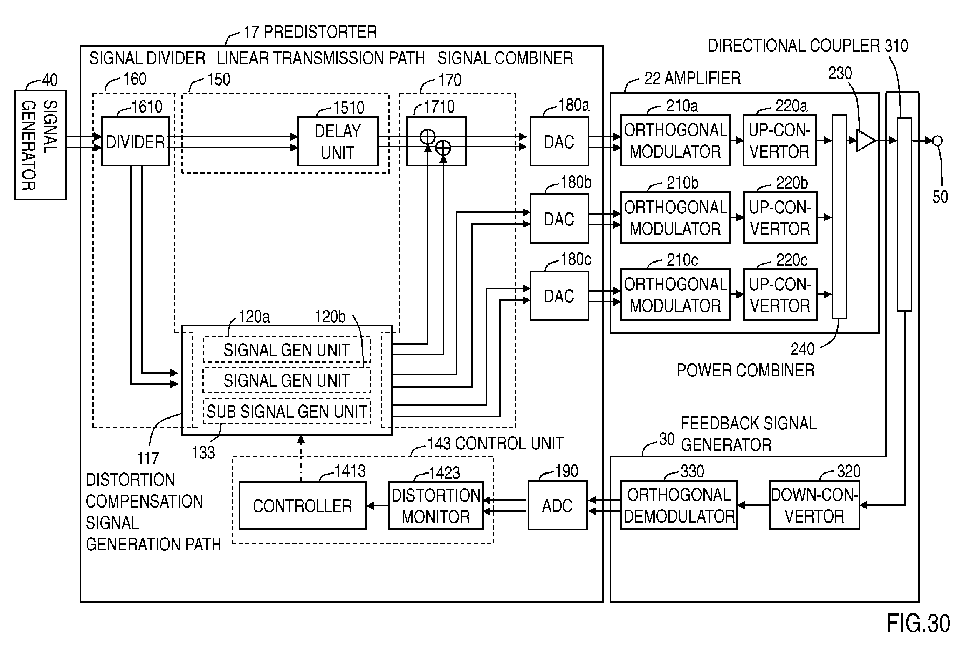

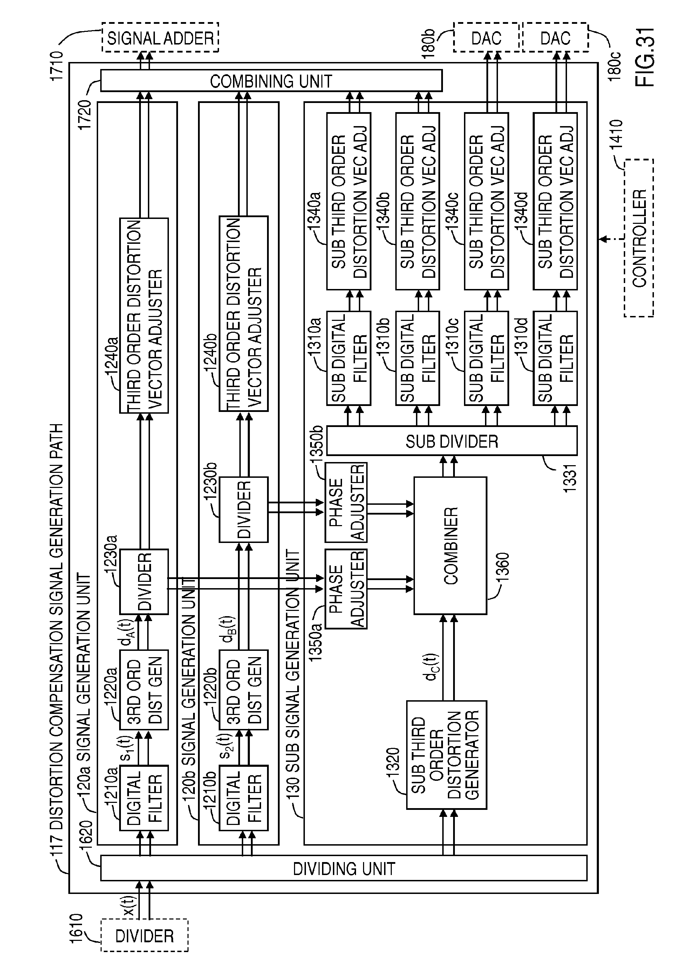

An operation of the predistorter 17 according to this modification is described in detail with reference to Figs. 30 and 31. Fig. 30 is a block diagram illustrating the whole configuration of the predistorter 17 and peripheral devices according to this modification. Fig. 31 is a block diagram illustrating the configuration of the distortion compensation signal generation path 117 which is included in the predistorter 17 according to this modification. The peripheral devices of this modification are a signal generator 40, an amplifier 22, a feedback signal generator 30, and an output terminal 50.

The predistorter 17 of this modification includes the distortion compensation signal generation path 117, a control unit 143, a linear transmission path 150, a signal divider 160, a signal combiner 170, a DAC 180a, a DAC 180b, a DAC 180c, and an ADC 190.

The DAC 180a converts a digital signal which is outputted by the signal combiner 170 into an analog signal. Further, the DAC 180b converts a digital signal which is outputted by the sub third order distortion vector adjuster 1340c which is included in the sub signal generation unit 133 into an analog signal. In a similar manner, the DAC 180c converts a digital signal which is outputted by the sub third order distortion vector adjuster 1340d which is included in the sub signal generation unit 133 into an analog signal.

The amplifier 22 includes orthogonal modulators 210a, 210b, and 210c, up-converters 220a, 220b, and 220c, a power amplifier 230, and a power combiner 240. The orthogonal modulator 210a orthogonally modulates an analog signal which is outputted by the DAC 180a. Further, the orthogonal modulator 210b orthogonally modulates an analog signal which is outputted by the DAC 180b. In a similar manner, the orthogonal modulator 210c orthogonally modulates an analog signal which is outputted by the DAC 180c. The up-converter 220a up-converts a signal which is outputted by the orthogonal modulator 210a to a target frequency. Further, the up-converter 220b up-converts a signal which is outputted by the orthogonal modulator 210b to a target frequency. In a similar manner, the up-converter 220c up-converts a signal which is outputted by the orthogonal modulator 210c to a target frequency. The power combiner 240 combines signals which are outputted by the up-converters 220a, 220b, and 220c. The power amplifier 230 amplifies a signal which is outputted by the power combiner 240 to target power. When a single up-converter is capable of up-converting signals, which use different frequency bands, to a predetermined frequency, such configuration may be employed that outputs of the orthogonal modulators 210a, 210b, and 210c are combined by the power combiner 240 and then a single up-converter up-converts the output to a predetermined frequency.

[Embodiment 4]

In order to enhance a distortion compensation amount of a predistorter, it is effective to generate a distortion compensation signal which can compensate a high-order distortion component of which $N_D$ is 5, for example.

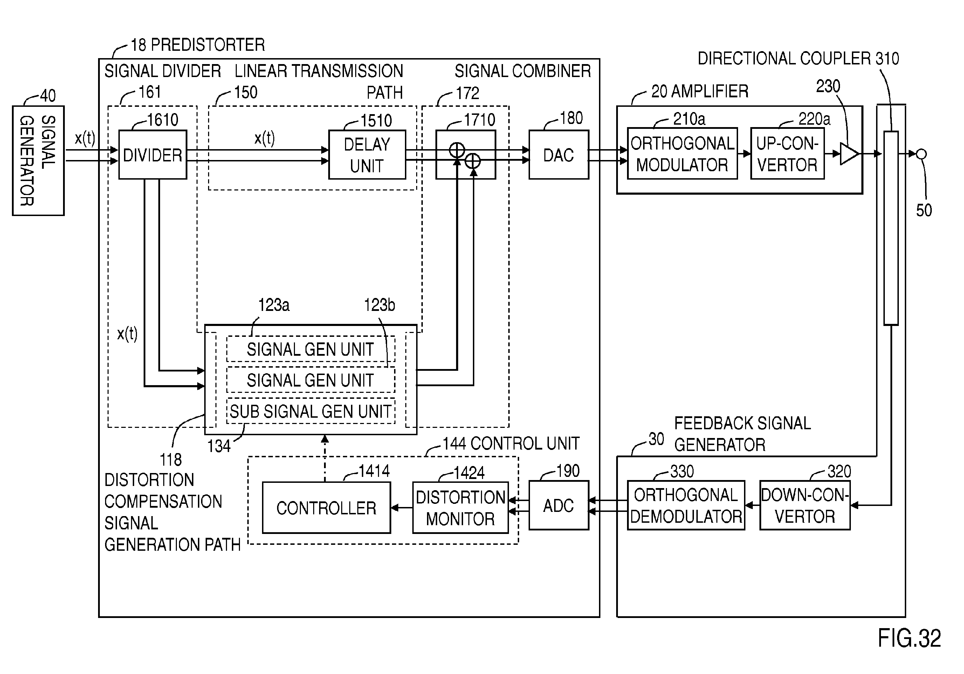

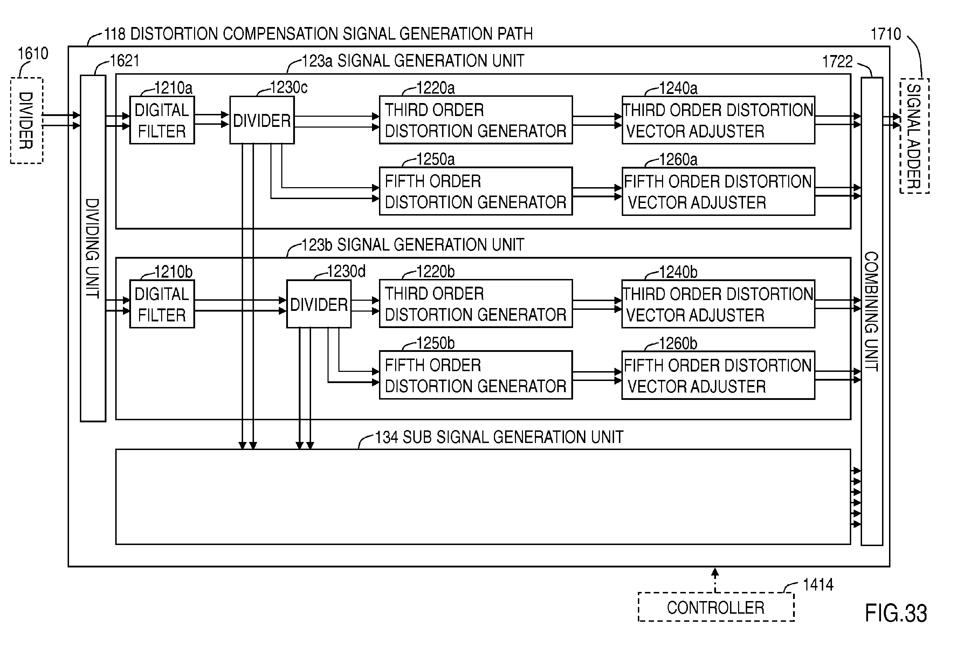

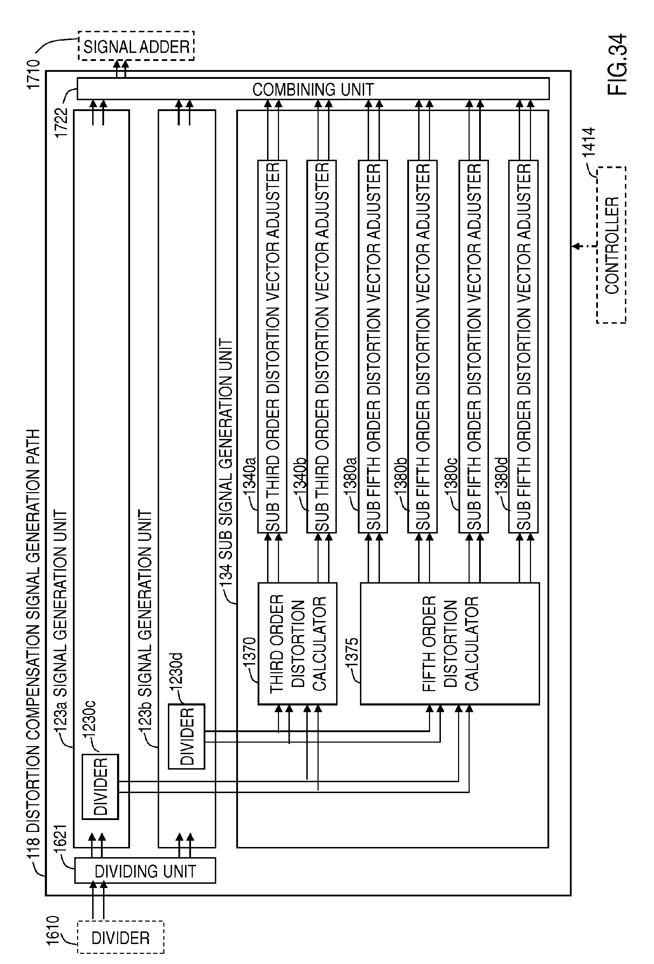

An operation of a predistorter 18 according to Embodiment 4 of the present invention is described in detail with reference to Figs. 32, 33, and 34. Fig. 32 is a block diagram illustrating the whole configuration of the predistorter 18 and peripheral devices according to this embodiment. Fig. 33 is a block diagram illustrating the configuration of signal generation units 123a and 123b in a distortion compensation signal generation path 118 which is included in the predistorter 18 according to Embodiment 4 of the present invention. Fig. 34 is a block diagram illustrating the configuration of a sub signal generation unit 134 of the distortion compensation signal generation path 118 which is included in the predistorter 18 according to this embodiment.

The predistorter 18 of this embodiment includes the distortion compensation signal generation path 118, a control unit 144, a linear transmission path 150, a signal divider 161, a signal combiner 172, a DAC 180, and an ADC 190.

The control unit 144 includes a controller 1414 and a distortion monitor 1424. The distortion monitor 1424 measures power in bands corresponding to a fifth-order distortion component as well as a third-order distortion component which is generated in the power amplifier 230 for every predetermined bandwidth and transmits the measurement result to the controller 1414. The controller 1414 controls the distortion compensation signal generation path 118 on the basis of the measurement result of the distortion monitor 1424.

The distortion compensation signal generation path 118 includes the plurality of signal generation units 123a and 123b and the sub signal generation unit 134. The signal generation unit 123a includes a digital filter 1210a, a divider 1230c, a third order distortion generator 1220a, a third order distortion vector adjuster 1240a, a fifth order distortion generator 1250a, and a fifth order distortion vector adjuster 1260a. The divider 1230c divides an individual carrier input signal which is outputted by the digital filter 1210a among the third order distortion generator 1220a, the fifth order distortion generator 1250a, and the sub signal generation unit 134. In order to generate a fifth order distortion component, the fifth order distortion generator 1250a raises an individual carrier input signal which is outputted by the divider 1230c to fifth power and generates an individual carrier distortion signal. The fifth order distortion vector adjuster 1260a adjusts a phase and an amplitude of an individual carrier distortion signal which is outputted by the fifth order distortion generator 1250a, on the basis of control information which is provided from the controller 1414 so as to generate an individual carrier distortion compensation signal and output the individual carrier distortion compensation signal to the combining unit 1722. In a similar manner, the signal generation unit 123b includes a digital filter 1210b, a divider 1230d, a third order distortion generator 1220b, a third order distortion vector adjuster 1240b, a fifth order distortion generator 1250b, and a fifth order distortion vector adjuster 1260b. The divider 1230d divides an individual carrier input signal which is outputted by the digital filter 1210b among the third order distortion generator 1220b, the fifth order distortion generator 1250b, and the sub signal generation unit 134. In order to generate a fifth order distortion component, the fifth order distortion generator 1250b raises an individual carrier input signal which is outputted by the divider 1230d to fifth power and generates an individual carrier distortion signal. The fifth order distortion vector adjuster 1260b adjusts a phase and an amplitude of an individual carrier distortion signal which is outputted by the fifth order distortion generator 1250b, on the basis of control information which is provided from the controller 1414 so as to generate an individual carrier distortion compensation signal and output the individual carrier distortion compensation signal to the combining unit 1722.

The sub signal generation unit 134 includes a third order distortion calculator 1370, sub third order distortion vector adjusters 1340a and 1340b, a fifth order distortion calculator 1375, and sub fifth order distortion vector adjusters 1380a, 1380b, 1380c, and 1380d, as depicted in Fig. 34. The fifth order distortion calculator 1375 generates a carrier inter-modulation distortion signal from an individual carrier input signal which is outputted by the divider 1230c and an individual carrier input signal which is outputted by the divider 1230d. Here, when a signal which is outputted by the divider 1230c is denoted as $s_1(t)$ mentioned above and a signal which is outputted by the divider 1230d is denoted as $s_2(t)$ mentioned above, a fifth order distortion component $d_E(t)$ can be expressed as formula (5).

$$d_E(t) = |s_1(t) + s_2(t)|^4 \left(s_1(t) + s_2(t)\right)$$
$$= |s_1(t)|^4 s_1(t) + |s_2(t)|^4 s_2(t)$$
$$+ |s_1(t)|^2 \left(2s_1^2(t)s_2^*(t) + 3s_1^*(t)s_2^2(t)\right) + |s_2(t)|^2 \left(3s_1^2(t)s_2^*(t) + 2s_1^*(t)s_2^2(t)\right)$$
$$+ 3|s_2(t)|^4 s_1(t) + 3|s_1(t)|^4 s_2(t)$$
$$+ 6|s_1(t)|^2|s_2(t)|^2 s_1(t) + 6|s_1(t)|^2|s_2(t)|^2 s_2(t)$$
$$+ \left(s_1(t)s_2^*(t)\right)^2 s_1(t) + \left(s_1^*(t)s_2(t)\right)^2 s_2(t) \qquad (5)$$

When a frequency interval between $s_1(t)$ and $s_2(t)$ is large (for example, 100 MHz), distortion components including a frequency band same as that of $s_1(t)$ in $d_E(t)$ are $|s_1(t)|^4 s_1(t)$, $3|s_2(t)|^4 s_1(t)$, and $6|s_1(t)|^2|s_2(t)|^2 s_1(t)$ and distortion components including a frequency band same as that of $s_2(t)$ in $d_E(t)$ are $|s_2(t)|^4 s_2(t)$, $3|s_1(t)|^4 s_2(t)$, and $6|s_1(t)|^2|s_2(t)|^2 s_2$ (t). Here, $|s_1(t)|^4 s_1(t)$ is generated in the fifth order distortion generator 1250a and $|s_2(t)|^4 s_2(t)$ is generated in the fifth order distortion generator 1250b. Therefore, the fifth order distortion calculator 1375 generates a carrier inter-modulation distortion signal from an individual carrier input signal $s_1(t)$ which is outputted by the divider 1230c and an individual carrier input signal $s_2(t)$ which is outputted by the divider 1230d so as to output the carrier inter-modulation distortion signal to the sub fifth order distortion vector adjusters 1380a to 1380d respectively. In this example, it is assumed that a carrier inter-modulation distortion signal calculated by $3|s_2(t)|^4 s_1(t)$ is outputted to the sub fifth order distortion vector adjuster 1380a, a carrier inter-modulation distortion signal calculated by $6|s_1(t)|^2|s_2(t)|^2 s_1(t)$ is outputted to the sub fifth order distortion vector adjuster 1380b, a carrier inter-modulation distortion signal calculated by $3|s_1(t)|^4 s_2(t)$ is outputted to the sub fifth order distortion vector adjuster 1380c, and a carrier inter-modulation distortion signal calculated by $6|s_1(t)|^2|s_2(t)|^2 s_2(t)$ is outputted to the sub fifth order distortion vector adjuster 1380d.

Each of the sub fifth order distortion vector adjusters 1380a to 1380d adjusts a phase and an amplitude of the carrier inter-modulation distortion signal which is outputted by the fifth order distortion calculator 1375, on the basis of control information which is provided from the controller 1414 so as to generate a carrier inter-modulation distortion compensation signal and output the carrier inter-modulation distortion compensation signal to the combining unit 1722.

The combining unit 1722 combines outputs of the third order distortion vector adjusters 1240a and 1240b, the fifth order distortion vector adjusters 1260a and 1260b, the sub third order distortion vector adjusters 1340a and 1340b, and the sub fifth order distortion vector adjusters 1380a to 1380d so as to output the output to the signal adder 1710.

[Adjustment Processing Flow P41 of Embodiment 4]

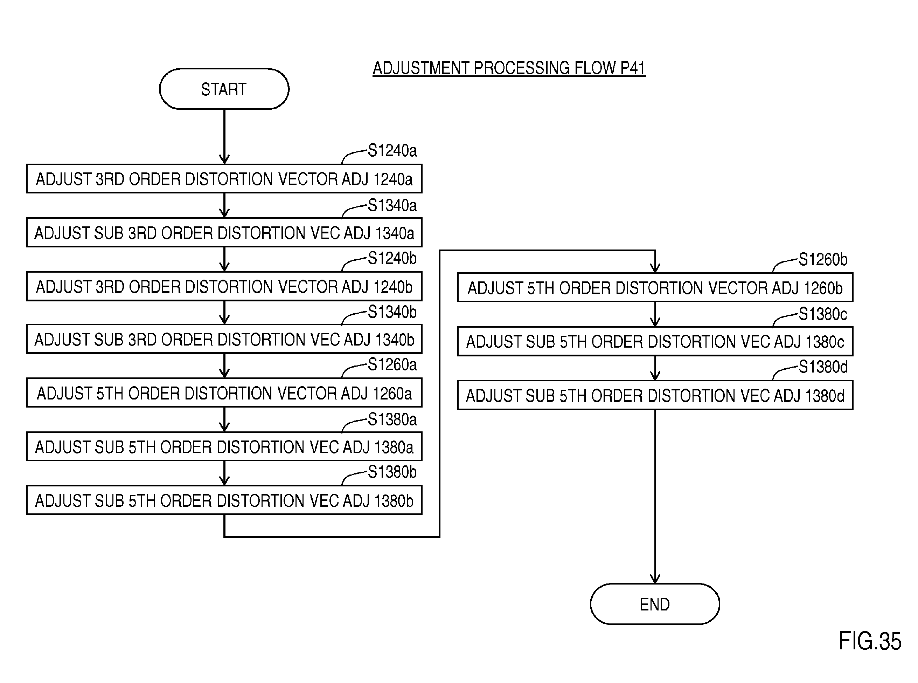

Fig. 35 illustrates an adjustment processing flow P41 in which the controller 1414 of this embodiment controls the distortion compensation signal generation path 118. In the adjustment processing flow P12, adjustment of the third order distortion vector adjuster 1240a (S1240a), adjustment of the sub third order distortion vector adjuster 1340a (S1340a), adjustment of the third order distortion vector adjuster 1240b (S1240b), adjustment of the sub third order distortion vector adjuster 1340b (S1340b), adjustment of the fifth order distortion vector adjuster 1260a (S1260a), adjustment of the sub fifth order distortion vector adjuster 1380a (S1380a), adjustment of the sub fifth order distortion vector adjuster 1380b (S1380b), adjustment of the fifth order distortion vector adjuster 1260b (S1260b), adjustment of the sub fifth order distortion vector adjuster 1380c (S1380c), and adjustment of the sub fifth order distortion vector adjuster 1380d (S1380d) are performed in sequence.

[Adjustment Processing Flow P42 of Embodiment 4]

Due to the same reason as the adjustment processing flow P12 of Embodiment 1, the adjustment processing flow of the controller 1414 may be configured as an adjustment processing flow P42 described below.

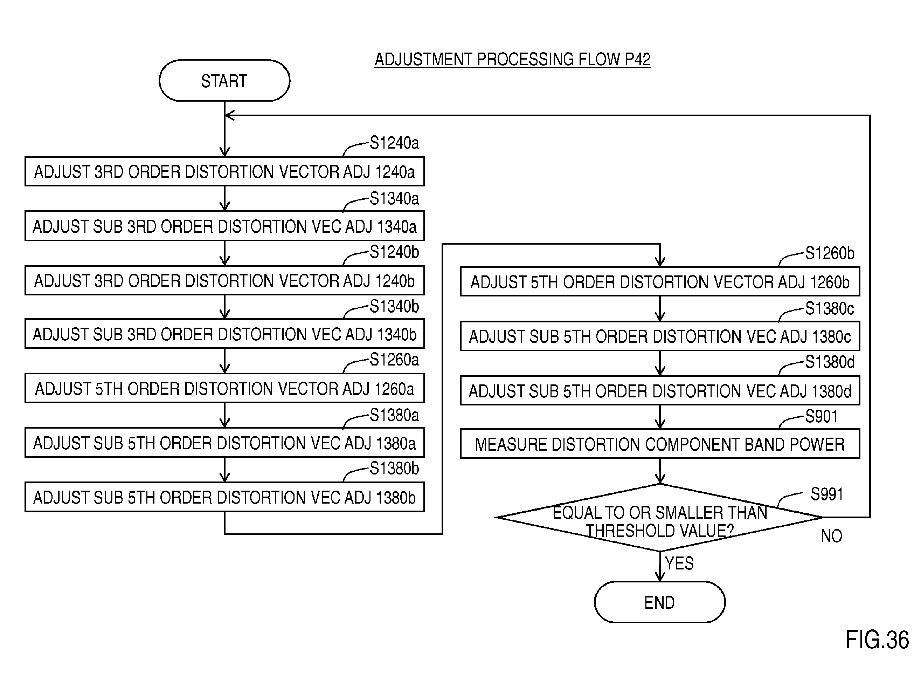

Fig. 36 illustrates the adjustment processing flow P42 in which the controller 1414 of this embodiment controls the distortion compensation signal generation path 118. In the adjustment processing flow P42, power of respective bands of distortion components is measured by the distortion monitor 1424 after adjustment up to adjustment of the sub fifth order distortion vector adjuster 1380d is performed by processing same as the adjustment processing flow P41 (S901). Whether or not all the measured power in the bands is equal to or smaller than a predetermined threshold value $P_{TH}$ is determined (S991). When all the measured power of the bands is equal to or smaller than the threshold value $P_{TH}$, the adjustment processing flow P42 is ended. When the condition is not satisfied, the flow returns to the adjustment of the third order distortion vector adjuster 1240a (S1240a). A series of repeating processing is repeated until the condition of S991 is satisfied or repeated predetermined times.

[Adjustment Processing Flow P43 of Embodiment 4]

Due to the same reason as the adjustment processing flow P13 of Embodiment 1, the adjustment processing flow of the controller 1414 may be configured as an adjustment processing flow P43 described below.

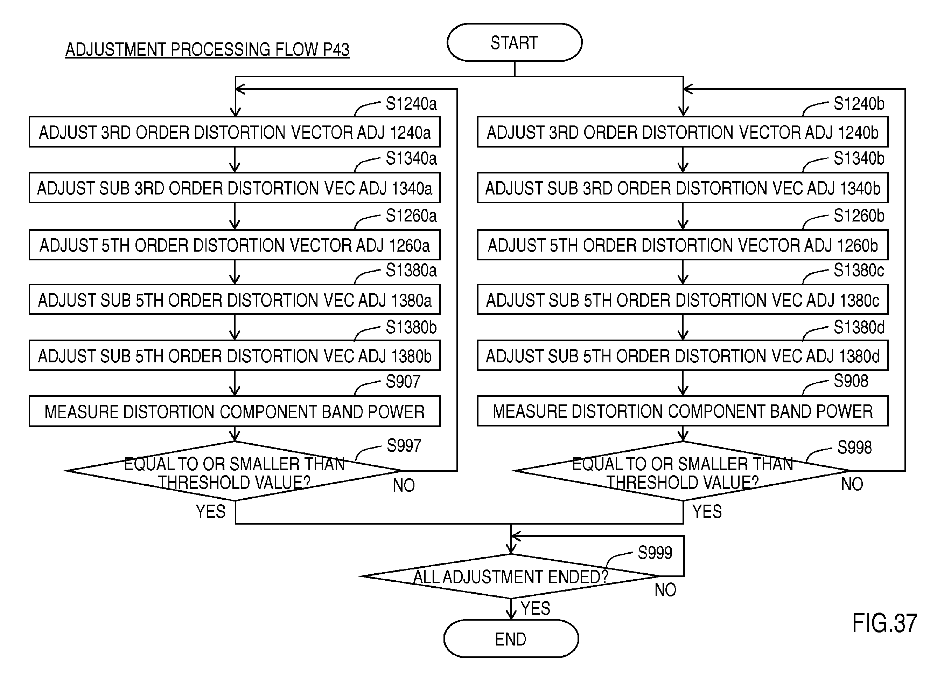

Fig. 37 illustrates the adjustment processing flow P43 in which the controller 1414 of this embodiment controls the distortion compensation signal generation path 118. In the adjustment processing flow P43, adjustment of the third order distortion vector adjuster 1240a (S1240a), adjustment of the sub third order distortion vector adjuster 1340a (S1340a), adjustment of the fifth order distortion vector adjuster 1260a (S1260a), adjustment of the sub fifth order distortion vector adjuster 1380a (S1380a), and adjustment of the sub fifth order distortion vector adjuster 1380b (S1380b) are performed in sequence and power in the third order distortion component upper side band 3DU1, power in the third order distortion component lower side band 3DL1, power in a fifth order distortion component upper side band 5DU1 which has a bandwidth which is twice as wide as the third order distortion component upper side band 3DU1 as depicted by a dashed line in Fig. 4, and power in a fifth order distortion component lower side band 5DL1 which has a bandwidth which is twice as wide as the third order distortion component lower side band 3DL1 as depicted by a dashed line in Fig. 4, are respectively measured (S907). Whether or not all of the measured power in the bands is equal to or smaller than a predetermined threshold value $P_{TH}$ is determined (S997). When the condition is not satisfied, the flow returns to the adjustment of the third order distortion vector adjuster 1240a (S1240a). Meanwhile, adjustment of the third order distortion vector adjuster 1240b (S1240b), adjustment of the sub third order distortion vector adjuster 1340b (S1340b), adjustment of the fifth order distortion vector adjuster 1260b (S1260b), adjustment of the sub fifth order distortion vector adjuster 1380c (S1380c), and adjustment of the sub fifth order distortion vector adjuster 1380d (S1380d) are performed in sequence and power in the third order distortion component upper side band 3DU2, power in the third order distortion component lower side band 3DL2, power in a fifth order distortion component upper side band 5DU2, and power in a fifth order distortion component lower side band 5DL2 are respectively measured (S908). Whether or not all of the measured power in the bands is equal to or smaller than a predetermined threshold value $P_{TH}$ is determined (S998). When the condition is not satisfied, the flow returns to the adjustment of the third order distortion vector adjuster 1240b (S1240b). When the condition is satisfied in both of S997 and S998, the adjustment processing flow P43 is ended (S999).

When a higher order distortion component such as a seventh order distortion component is compensated, the configuration of this embodiment is referred and the signal generation unit 123a, the signal generation unit 123b, and the sub signal generation unit 134 are allowed to generate signals for compensating high order distortion components respectively so as to add a function for adjusting a phase and an amplitude of the signals.

[INDUSTRIAL APPLICABILITY]

A predistorter according to the present invention is applicable to a transmission amplifier which is used in a base station of mobile body communication.

**Claims**

1. A predistorter that adds a distortion compensation signal to an input signal, the input signal including a plurality of carriers, so as to output the input signal to an amplifier; comprising:

   a linear transmission path that delays and transmits the input signal;
   a plurality of signal generation units that generate an individual carrier distortion signal that is a distortion component, the distortion component being generated by the carriers, for each of the carriers included in the input signal and adjust the individual carrier distortion signal so as to output an individual carrier distortion compensation signal;
   a sub signal generation unit that generates an inter-modulation distortion signal, the inter-modulation distortion signal being generated among the carriers, from the input signal and the individual carrier distortion signal, extracts each component of a frequency band that is same at least as the carriers as a carrier inter-modulation distortion signal from the inter-modulation distortion signal, and adjusts the carrier inter-modulation distortion signal so as to output a carrier inter-modulation distortion compensation signal;
   a signal divider configured to divide the input signal among the linear transmission path, the plurality of signal generation units, and the sub signal generation unit;
   a signal combiner that combines the individual carrier distortion compensation signal and the carrier inter-modulation distortion compensation signal to generate the distortion compensation signal and combines an input signal that is delayed by the linear transmission path and the distortion compensation signal so as to generate an output signal and output the output signal to the amplifier; and

a control unit configured to control the plurality of signal generation units and the sub signal generation unit by using a feedback signal from the amplifier.

**2.** A predistorter that adds a distortion compensation signal to an input signal, the input signal including a plurality of carriers, so as to output the input signal to an amplifier; comprising:

a linear transmission path that delays and transmits the input signal;

a plurality of signal generation units that extract a component of a frequency band that is same as a frequency band of the carriers from the input signal as an individual carrier input signal for each of the carriers included in the input signal, generates a distortion component of the individual carrier input signal as an individual carrier distortion signal, adjust the individual carrier distortion signal so as to generate an individual carrier distortion compensation signal, and output the individual carrier input signal and the individual carrier distortion compensation signal;

a sub signal generation unit that calculates a distortion component, the distortion component including a frequency band that is same as a frequency band of the carriers, as a carrier inter-modulation distortion signal, among distortion components that are generated among the carriers from the individual carrier input signal, and adjusts the carrier inter-modulation distortion signal so as to output a carrier inter-modulation distortion compensation signal;

a signal divider configured to divide the input signal among the linear transmission path and the plurality of signal generation units;

a signal combiner that combines the individual carrier distortion compensation signal and the carrier inter-modulation distortion compensation signal to generate the distortion compensation signal and combines an input signal that is delayed by the linear transmission path and the distortion compensation signal so as to generate an output signal and output the output signal to the amplifier; and

a control unit configured to control the plurality of signal generation units and the sub signal generation unit by using a feedback signal from the amplifier.

**3.** The predistorter according to claim 1 or 2, wherein

the linear transmission path is configured to generate an individual carrier input signal for each of the carriers included in the input signal and delay and transmit the individual carrier input signal, and

the signal combiner is configured such that the signal combiner combines the individual carrier input signal that is delayed by the linear transmission path, the individual carrier distortion compensation signal, and the carrier inter-modulation distortion compensation signal with each other for every identical frequency band so as to generate the distortion compensation signal.

**4.** The predistorter according to any of claims 1 to 3, wherein

the plurality of signal generation units are configured to adjust the individual carrier distortion compensation signal for each of divided bands that are obtained by dividing the individual carrier distortion compensation signal by a predetermined frequency bandwidth, and

the sub signal generation unit is configured to adjust the carrier inter-modulation distortion compensation signal for each of the divided bands.

**5.** The predistorter according to any of claims 1 to 3, wherein

the sub signal generation unit is configured such that the sub signal generation unit generates a sub carrier inter-modulation distortion signal, the sub carrier inter-modulation distortion signal being a distortion component that is generated in a frequency band that is separated from a center frequency of the carriers by a frequency interval same as a frequency interval among the carriers, and adjusts the sub carrier inter-modulation distortion signal to generate a sub carrier inter-modulation distortion compensation signal, and

the signal combiner is configured such that the signal combiner combines the individual carrier distortion compensation signal, the carrier inter-modulation distortion compensation signal, and the sub carrier inter-modulation distortion compensation signal with each other to generate the distortion compensation signal and combines an input signal that is delayed by the linear transmission path with the distortion compensation signal to generate an output signal.

**6.** A predistorter control method in the predistorter according to any of claims 1 to 4; comprising:

a distortion component power measurement step in which a distortion monitor measures distortion component power that includes power of a distortion component upper side band, of which the distortion component is a distortion component that exits in a frequency band that is higher than a frequency band of the carriers, and power of a distortion component lower side band, of which the distortion component is a distortion component that exits in a frequency band that is lower than the frequency band of the carriers, from the feedback signal, for each frequency band of the carriers;

a signal generation unit control step in which a controller provides control information to the plurality of signal generation units so as to reduce the distortion component power for each frequency band of the carriers; and

a sub signal generation unit control step in which the controller provides control information to the sub signal generation unit so as to reduce the distortion component power for each frequency band of the carriers.

7. The predistorter control method according to claim 6, wherein the signal generation unit control step and the sub signal generation unit control step are executed in parallel for each frequency band of the carriers.

8. The predistorter control method in the predistorter according to claim 5; comprising:

a distortion component power measurement step in which a distortion monitor measures distortion component power that includes power of a distortion component upper side band, of which the distortion component is a distortion component that exits in a frequency band that is higher than a frequency band of the carriers, and power of a distortion component lower side band, of which the distortion component is a distortion component that exits in a frequency band that is lower than the frequency band of the carriers, from the feedback signal, for each frequency band of the carriers;

a carrier out-of-band distortion component power measurement step in which the distortion monitor measures carrier out-of-band distortion component power of which the carrier out-of-band distortion component is a distortion component existing in a corresponding carrier out-of-band frequency band, from the feedback signal, for every carrier out-of-band frequency band that is separated from a center frequency of the carriers by a frequency interval same as a frequency interval among the carriers;

a signal generation unit control step in which a controller provides control information to the plurality of signal generation units so as to reduce the distortion component power for each frequency band of the carriers;

a sub signal generation unit control step in which the controller provides control information to the sub signal generation unit so as to reduce the distortion component power for each frequency band of the carriers; and

a sub signal generation unit carrier out-of-band control step in which the controller provides control information to the sub signal generation unit so as to reduce the carrier out-of-band distortion component power for each carrier out-of-band frequency band.

9. The predistorter control method according to claim 8, wherein
the signal generation unit control step and the sub signal generation unit control step are executed in parallel for each frequency band of the carriers, and
the sub signal generation unit carrier out-of-band control step is executed in parallel with the signal generation unit control step and the sub signal generation unit control step.

FIG.1A

FREQUENCY

FIG.1B

FREQUENCY

FIG.2

EP 2 704 318 A1

110 DISTORTION COMPENSATION SIGNAL GENERATION PATH

1610 — DIVIDER — $x(t)$

1620 — DIVIDING UNIT

120a SIGNAL GENERATION UNIT

- 1210a DIGITAL FILTER — $s_1(t)$ — 1220a 3RD ORD DIST GEN — $d_A(t)$ — 1230a DIVIDER — 1240a THIRD ORDER DISTORTION VECTOR ADJUSTER

120b SIGNAL GENERATION UNIT

- 1210b DIGITAL FILTER — $s_2(t)$ — 1220b 3RD ORD DIST GEN — $d_B(t)$ — 1230b DIVIDER — 1240b THIRD ORDER DISTORTION VECTOR ADJUSTER

130 SUB SIGNAL GENERATION UNIT

- 1350a PHASE ADJUSTER
- 1350b PHASE ADJUSTER
- SUB THIRD ORDER DISTORTION VECTOR ADJUSTER
- 1320 SUB THIRD ORDER DISTORTION GENERATOR — $d_C(t)$ — 1360 COMBINER
- 1330 SUB DIVIDER
- 1310a SUB DIGITAL FILTER — $d_{CA}(t)$ — 1340a
- 1310b SUB DIGITAL FILTER — $d_{CB}(t)$ — 1340b
- SUB THIRD ORDER DISTORTION VECTOR ADJUSTER

1710 — 1720 — COMBINING UNIT — SIGNAL ADDER

1410 CONTROLLER

FIG.3

FIG.4

ADJUSTMENT PROCESSING FLOW P11

```
                    ┌──────────┐
                    │  START   │
                    └────┬─────┘
                         │
                         ▼                    ⌐ S1240a
        ┌────────────────────────────────────┐
        │    ADJUST THIRD ORDER DISTORTION    │
        │     VECTOR ADJUSTER 1240a           │
        └────────────────┬───────────────────┘
                         │
                         ▼                    ⌐ S1340a
        ┌────────────────────────────────────┐
        │  ADJUST SUB THIRD ORDER DISTORTION  │
        │     VECTOR ADJUSTER 1340a           │
        └────────────────┬───────────────────┘
                         │
                         ▼                    ⌐ S1240b
        ┌────────────────────────────────────┐
        │    ADJUST THIRD ORDER DISTORTION    │
        │     VECTOR ADJUSTER 1240b           │
        └────────────────┬───────────────────┘
                         │
                         ▼                    ⌐ S1340b
        ┌────────────────────────────────────┐
        │  ADJUST SUB THIRD ORDER DISTORTION  │
        │     VECTOR ADJUSTER 1340b           │
        └────────────────┬───────────────────┘
                         │
                         ▼
                    ┌──────────┐
                    │   END    │
                    └──────────┘
```

FIG.5

ADJUSTMENT PROCESSING FLOW P12

```
                    ┌─────────────┐
                    │    START    │
                    └──────┬──────┘
                           │         ┌──────────────────────┐
                           ▼         │                      │
        ┌──────────────────────────────────┐  ╭─ S1240a
        │  ADJUST THIRD ORDER DISTORTION VECTOR │
        │         ADJUSTER 1240a            │
        └──────────────────┬───────────────┘
                           ▼             ╭─ S1340a
        ┌──────────────────────────────────┐
        │ ADJUST SUB THIRD ORDER DISTORTION VECTOR │
        │         ADJUSTER 1340a            │
        └──────────────────┬───────────────┘
                           ▼             ╭─ S1240b
        ┌──────────────────────────────────┐
        │  ADJUST THIRD ORDER DISTORTION VECTOR │
        │         ADJUSTER 1240b            │
        └──────────────────┬───────────────┘
                           ▼             ╭─ S1340b
        ┌──────────────────────────────────┐
        │ ADJUST SUB THIRD ORDER DISTORTION VECTOR │
        │         ADJUSTER 1340b            │
        └──────────────────┬───────────────┘
                           ▼             ╭─ S901
        ┌──────────────────────────────────┐
        │ MEASURE DISTORTION COMPONENT BAND POWER │
        └──────────────────┬───────────────┘
                           ▼
                  ╱────────────────╲    ╭─ S991
                 ╱ EQUAL TO OR SMALLER╲
                ╱    THAN THRESHOLD    ╲──── NO ──┘
                ╲       VALUE?         ╱
                 ╲────────────────────╱
                           │
                          YES
                           ▼
                    ┌─────────────┐
                    │     END     │
                    └─────────────┘
```

FIG.6

ADJUSTMENT PROCESSING FLOW P13

START

ADJUST THIRD ORDER DISTORTION VECTOR ADJUSTER 1240a — S1240a

ADJUST SUB THIRD ORDER DISTORTION VECTOR ADJUSTER 1340a — S1340a

MEASURE DISTORTION COMPONENT BAND POWER — S902

EQUAL TO OR SMALLER THAN THRESHOLD VALUE? — S992    NO

YES

ADJUST THIRD ORDER DISTORTION VECTOR ADJUSTER 1240b — S1240b

ADJUST SUB THIRD ORDER DISTORTION VECTOR ADJUSTER 1340b — S1340b

MEASURE DISTORTION COMPONENT BAND POWER — S903

EQUAL TO OR SMALLER THAN THRESHOLD VALUE? — S993    NO

YES

ALL ADJUSTMENT ENDED? — S999    NO

YES

END

FIG.7

EP 2 704 318 A1

FIG.8

FIG.9

FIG.10

FIG.11

FIG.12

EP 2 704 318 A1

38

EP 2 704 318 A1

1290a THIRD ORDER DISTORTION FREQUENCY PROPERTY COMPENSATOR

FIG.13

ADJUSTMENT PROCESSING FLOW P14

START

S1240a
ADJUST THIRD ORDER DISTORTION VECTOR ADJUSTER 1240a

S1290a
ADJUST THIRD ORDER DISTORTION FREQUENCY PROPERTY
COMPENSATOR 1290a

S1340a
ADJUST SUB THIRD ORDER DISTORTION VECTOR ADJUSTER 1340a

S1390a
ADJUST SUB THIRD ORDER DISTORTION FREQUENCY PROPERTY
COMPENSATOR 1390a

S1240b
ADJUST THIRD ORDER DISTORTION VECTOR ADJUSTER 1240b

S1290b
ADJUST THIRD ORDER DISTORTION FREQUENCY PROPERTY
COMPENSATOR 1290b

S1340b
ADJUST SUB THIRD ORDER DISTORTION VECTOR ADJUSTER 1340b

S1390b
ADJUST SUB THIRD ORDER DISTORTION FREQUENCY PROPERTY
COMPENSATOR 1390b

END

FIG.14

## ADJUSTMENT PROCESSING FLOW P15

START

S1240a
ADJUST THIRD ORDER DISTORTION VECTOR ADJUSTER 1240a

S1340a
ADJUST SUB THIRD ORDER DISTORTION VECTOR ADJUSTER 1340a

S1290a
ADJUST THIRD ORDER DISTORTION FREQUENCY PROPERTY
COMPENSATOR 1290a

S1390a
ADJUST SUB THIRD ORDER DISTORTION FREQUENCY PROPERTY
COMPENSATOR 1390a

S1240b
ADJUST THIRD ORDER DISTORTION VECTOR ADJUSTER 1240b

S1340b
ADJUST SUB THIRD ORDER DISTORTION VECTOR ADJUSTER 1340b

S1290b
ADJUST THIRD ORDER DISTORTION FREQUENCY PROPERTY
COMPENSATOR 1290b

S1390b
ADJUST SUB THIRD ORDER DISTORTION FREQUENCY PROPERTY
COMPENSATOR 1390b

S901
MEASURE DISTORTION COMPONENT BAND POWER

S991
EQUAL TO OR SMALLER THAN
THRESHOLD VALUE?

NO

YES

END

FIG.15

ADJUSTMENT PROCESSING FLOW P15

START

S1240a

ADJUST THIRD ORDER DISTORTION VECTOR ADJUSTER 1240a

S1340a

ADJUST SUB THIRD ORDER DISTORTION VECTOR ADJUSTER 1340a

S1240b

ADJUST THIRD ORDER DISTORTION VECTOR ADJUSTER 1240b

S1340b

ADJUST SUB THIRD ORDER DISTORTION VECTOR ADJUSTER 1340b

S1290a

ADJUST THIRD ORDER DISTORTION FREQUENCY PROPERTY COMPENSATOR 1290a

S1390a

ADJUST SUB THIRD ORDER DISTORTION FREQUENCY PROPERTY COMPENSATOR 1390a

S1290b

ADJUST THIRD ORDER DISTORTION FREQUENCY PROPERTY COMPENSATOR 1290b

S1390b

ADJUST SUB THIRD ORDER DISTORTION FREQUENCY PROPERTY COMPENSATOR 1390b

S901

MEASURE DISTORTION COMPONENT BAND POWER

S991

EQUAL TO OR SMALLER THAN THRESHOLD VALUE?

NO

YES

END

FIG.16

EP 2 704 318 A1

ADJUSTMENT PROCESSING FLOW P17

( START )

S1240a

ADJUST 3RD ORDER DISTORTION VECTOR ADJ 1240a

S1290a

ADJUST 3RD ORDER DISTORTION FREQUENCY PROPERTY COMPENSATOR 1290a

S1340a

ADJUST SUB 3RD ORD DISTORTION VECTOR ADJ 1340a

S1390a

ADJUST SUB 3RD ORDER DISTORTION FREQUENCY PROPERTY COMPENSATOR 1390a

S902

MEASURE DISTORTION COMPONENT BAND POWER

S992

EQUAL TO OR SMALLER THAN THRESHOLD VALUE?  NO

YES

S1240b

ADJUST 3RD ORDER DISTORTION VECTOR ADJ 1240b

S1290b

ADJUST 3RD ORDER DISTORTION FREQUENCY PROPERTY COMPENSATOR 1290b

S1340b

ADJUST SUB 3RD ORD DISTORTION VECTOR ADJ 1340b

S1390b

ADJUST SUB 3RD ORDER DISTORTION FREQUENCY PROPERTY COMPENSATOR 1390b

S903

MEASURE DISTORTION COMPONENT BAND POWER

S993

EQUAL TO OR SMALLER THAN THRESHOLD VALUE?  NO

YES

S999

ALL ADJUSTMENT ENDED?  NO

YES

( END )

FIG.17

FIG.18

FIG.19

FIG.20

FIG.21

FIG.22

FIG.23

FIG.24

16 PREDISTORTER

SIGNAL DIVIDER / LINEAR TRANSMISSION PATH / SIGNAL COMBINER

DIRECTIONAL COUPLER 310

40 SIGNAL GENERATOR

160 DIVIDER

150

1510 DELAY UNIT

170

1710

180 DAC

20 AMPLIFIER

230

210 ORTHOGONAL MODULATOR

220 UP-CONVERTOR

120a SIGNAL GEN UNIT

120b SIGNAL GEN UNIT

SUB SIGNAL GEN UNIT

133

116 DISTORTION COMPENSATION SIGNAL GENERATION PATH

143 CONTROL UNIT

1413 CONTROLLER

1423 DISTORTION MONITOR

190 ADC

30 FEEDBACK SIGNAL GENERATOR

330 ORTHOGONAL DEMODULATOR

320 DOWN-CONVERTOR

EP 2 704 318 A1

FIG.25

## ADJUSTMENT PROCESSING FLOW P31

```
        ┌─────────────┐
        │    START    │
        └─────────────┘
               │
               ▼                                              ⌐S1240a
┌──────────────────────────────────────────────────────────┐
│      ADJUST THIRD ORDER DISTORTION VECTOR ADJUSTER 1240a  │
└──────────────────────────────────────────────────────────┘
               │                                              ⌐S1340a
               ▼
┌──────────────────────────────────────────────────────────┐
│   ADJUST SUB THIRD ORDER DISTORTION VECTOR ADJUSTER 1340a │
└──────────────────────────────────────────────────────────┘
               │                                              ⌐S1240b
               ▼
┌──────────────────────────────────────────────────────────┐
│      ADJUST THIRD ORDER DISTORTION VECTOR ADJUSTER 1240b  │
└──────────────────────────────────────────────────────────┘
               │                                              ⌐S1340b
               ▼
┌──────────────────────────────────────────────────────────┐
│   ADJUST SUB THIRD ORDER DISTORTION VECTOR ADJUSTER 1340b │
└──────────────────────────────────────────────────────────┘
               │                                              ⌐S1340c
               ▼
┌──────────────────────────────────────────────────────────┐
│   ADJUST SUB THIRD ORDER DISTORTION VECTOR ADJUSTER 1340c │
└──────────────────────────────────────────────────────────┘
               │                                              ⌐S1340d
               ▼
┌──────────────────────────────────────────────────────────┐
│   ADJUST SUB THIRD ORDER DISTORTION VECTOR ADJUSTER 1340d │
└──────────────────────────────────────────────────────────┘
               │
               ▼
        ┌─────────────┐
        │     END     │
        └─────────────┘
```

FIG.26

## ADJUSTMENT PROCESSING FLOW P32

FIG.27

ADJUSTMENT PROCESSING FLOW P33

START

S1240a
ADJUST 3RD ORDER DISTORTION VECTOR ADJ 1240a

S1340a
ADJUST SUB 3RD ORD DISTORTION VECTOR ADJ 1340a

S1240b
ADJUST 3RD ORDER DISTORTION VECTOR ADJ 1240b

S1340b
ADJUST SUB 3RD ORD DISTORTION VECTOR ADJ 1340b

S905
MEASURE DISTORTION COMPONENT BAND POWER

S995
EQUAL TO OR SMALLER THAN THRESHOLD VALUE?
NO
YES

S1340c
ADJUST SUB 3RD ORD DISTORTION VECTOR ADJ 1340c

S1340d
ADJUST SUB 3RD ORD DISTORTION VECTOR ADJ 1340d

S906
MEASURE DISTORTION COMPONENT BAND POWER

S996
EQUAL TO OR SMALLER THAN THRESHOLD VALUE?
NO
YES

S999
ALL ADJUSTMENT ENDED?
NO
YES

END

FIG.28

ADJUSTMENT PROCESSING FLOW P34

```
                              ┌──────────┐
                              │  START   │
                              └──────────┘
                                   │
        ┌──────────────────────────┼──────────────────────────┐
        │                          │                          │
        ▼  ┌── S1240a              ▼  ┌── S1240b              ▼  ┌── S1340c
 ┌──────────────────┐      ┌──────────────────┐      ┌──────────────────┐
 │ ADJUST THIRD ORDER│     │ ADJUST THIRD ORDER│     │ ADJUST SUB THIRD ORDER│
 │DISTORTION VECTOR  │     │DISTORTION VECTOR  │     │DISTORTION VECTOR   │
 │ADJ 1240a          │     │ADJ 1240b          │     │ADJ 1340c           │
 └──────────────────┘      └──────────────────┘      └──────────────────┘
        │  ┌── S1340a              │  ┌── S1340b              │  ┌── S1340d
        ▼                          ▼                          ▼
 ┌──────────────────┐      ┌──────────────────┐      ┌──────────────────┐
 │ADJUST SUB THIRD   │     │ADJUST SUB THIRD   │     │ADJUST SUB THIRD    │
 │ORDER DISTORTION   │     │ORDER DISTORTION   │     │ORDER DISTORTION    │
 │VECTOR ADJ 1340a   │     │VECTOR ADJ 1340b   │     │VECTOR ADJ 1340d    │
 └──────────────────┘      └──────────────────┘      └──────────────────┘
        │  ┌── S902                │  ┌── S903                │  ┌── S906
        ▼                          ▼                          ▼
 ┌──────────────────┐      ┌──────────────────┐      ┌──────────────────┐
 │MEASURE DISTORTION │     │MEASURE DISTORTION │     │MEASURE DISTORTION  │
 │COMPONENT BAND     │     │COMPONENT BAND     │     │COMPONENT BAND      │
 │POWER              │     │POWER              │     │POWER               │
 └──────────────────┘      └──────────────────┘      └──────────────────┘
        │  ┌── S992                │  ┌── S993                │  ┌── S996
        ▼                          ▼                          ▼
   ◇ EQUAL TO OR SMALLER   ◇ EQUAL TO OR SMALLER   ◇ EQUAL TO OR SMALLER
     THAN THRESHOLD          THAN THRESHOLD          THAN THRESHOLD
     VALUE?         NO        VALUE?         NO        VALUE?         NO
        │ YES                   │ YES                   │ YES
        └───────────────────────┼───────────────────────┘
                                ▼
                        ◇ ALL ADJUSTMENT ENDED? ──┐ ┌── S999
                                │                  NO
                                │ YES
                                ▼
                          ┌──────────┐
                          │   END    │
                          └──────────┘
```

FIG.29

FIG.30

FIG.31

FIG.32

EP 2 704 318 A1

FIG.33

FIG.34

ADJUSTMENT PROCESSING FLOW P41

```
                    ┌──────────┐
                    │  START   │
                    └────┬─────┘
                         │
                         │            ╱─S1240a
        ┌────────────────▼───────────────────────┐
        │ ADJUST 3RD ORDER DISTORTION VECTOR ADJ 1240a │
        └────────────────┬───────────────────────┘
                         │            ╱─S1340a
        ┌────────────────▼───────────────────────┐
        │ ADJUST SUB 3RD ORDER DISTORTION VEC ADJ 1340a │
        └────────────────┬───────────────────────┘
                         │            ╱─S1240b
        ┌────────────────▼───────────────────────┐         ┌────────────────▼───────────────────────┐
        │ ADJUST 3RD ORDER DISTORTION VECTOR ADJ 1240b │     │ ADJUST 5TH ORDER DISTORTION VECTOR ADJ 1260b │
        └────────────────┬───────────────────────┘         └────────────────┬───────────────────────┘
                         │            ╱─S1340b                                │            ╱─S1380c
        ┌────────────────▼───────────────────────┐         ┌────────────────▼───────────────────────┐
        │ ADJUST SUB 3RD ORDER DISTORTION VEC ADJ 1340b │     │ ADJUST SUB 5TH ORDER DISTORTION VEC ADJ 1380c │
        └────────────────┬───────────────────────┘         └────────────────┬───────────────────────┘
                         │            ╱─S1260a                                │            ╱─S1380d
        ┌────────────────▼───────────────────────┐         ┌────────────────▼───────────────────────┐
        │ ADJUST 5TH ORDER DISTORTION VECTOR ADJ 1260a │     │ ADJUST SUB 5TH ORDER DISTORTION VEC ADJ 1380d │
        └────────────────┬───────────────────────┘         └────────────────┬───────────────────────┘
                         │            ╱─S1380a
        ┌────────────────▼───────────────────────┐
        │ ADJUST SUB 5TH ORDER DISTORTION VEC ADJ 1380a │
        └────────────────┬───────────────────────┘
                         │            ╱─S1380b
        ┌────────────────▼───────────────────────┐
        │ ADJUST SUB 5TH ORDER DISTORTION VEC ADJ 1380b │
        └─────────────────────────────────────────┘
```

S1240a
S1340a
S1240b
S1340b
S1260a
S1380a
S1380b
S1260b
S1380c
S1380d

END

FIG.35

EP 2 704 318 A1

ADJUSTMENT PROCESSING FLOW P42

START

S1240a
ADJUST 3RD ORDER DISTORTION VECTOR ADJ 1240a

S1340a
ADJUST SUB 3RD ORDER DISTORTION VEC ADJ 1340a

S1240b
ADJUST 3RD ORDER DISTORTION VECTOR ADJ 1240b

S1340b
ADJUST SUB 3RD ORDER DISTORTION VEC ADJ 1340b

S1260a
ADJUST 5TH ORDER DISTORTION VECTOR ADJ 1260a

S1380a
ADJUST SUB 5TH ORDER DISTORTION VEC ADJ 1380a

S1380b
ADJUST SUB 5TH ORDER DISTORTION VEC ADJ 1380b

S1260b
ADJUST 5TH ORDER DISTORTION VECTOR ADJ 1260b

S1380c
ADJUST SUB 5TH ORDER DISTORTION VEC ADJ 1380c

S1380d
ADJUST SUB 5TH ORDER DISTORTION VEC ADJ 1380d

S901
MEASURE DISTORTION COMPONENT BAND POWER

S991
EQUAL TO OR SMALLER THAN THRESHOLD VALUE?

NO

YES

END

FIG.36

EP 2 704 318 A1

ADJUSTMENT PROCESSING FLOW P43

( START )

S1240a
ADJUST 3RD ORDER DISTORTION VECTOR ADJ 1240a

S1340a
ADJUST SUB 3RD ORDER DISTORTION VEC ADJ 1340a

S1260a
ADJUST 5TH ORDER DISTORTION VECTOR ADJ 1260a

S1380a
ADJUST SUB 5TH ORDER DISTORTION VEC ADJ 1380a

S1380b
ADJUST SUB 5TH ORDER DISTORTION VEC ADJ 1380b

S907
MEASURE DISTORTION COMPONENT BAND POWER

S997
EQUAL TO OR SMALLER THAN THRESHOLD VALUE?  NO

YES

S1240b
ADJUST 3RD ORDER DISTORTION VECTOR ADJ 1240b

S1340b
ADJUST SUB 3RD ORDER DISTORTION VEC ADJ 1340b

S1260b
ADJUST 5TH ORDER DISTORTION VECTOR ADJ 1260b

S1380c
ADJUST SUB 5TH ORDER DISTORTION VEC ADJ 1380c

S1380d
ADJUST SUB 5TH ORDER DISTORTION VEC ADJ 1380d

S908
MEASURE DISTORTION COMPONENT BAND POWER

S998
EQUAL TO OR SMALLER THAN THRESHOLD VALUE?  NO

YES

S999
ALL ADJUSTMENT ENDED?  NO

YES

( END )

FIG.37

## INTERNATIONAL SEARCH REPORT

| International application No. |
| --- |
| PCT/JP2012/080864 |

A. CLASSIFICATION OF SUBJECT MATTER
*H03F1/32*(2006.01)i, *H03F3/24*(2006.01)i, *H04B1/04*(2006.01)i, *H04L27/36*
(2006.01)i

According to International Patent Classification (IPC) or to both national classification and IPC

B. FIELDS SEARCHED

Minimum documentation searched (classification system followed by classification symbols)
H03F1/32, H03F3/24, H04B1/04, H04L27/36

Documentation searched other than minimum documentation to the extent that such documents are included in the fields searched
Jitsuyo Shinan Koho        1922–1996    Jitsuyo Shinan Toroku Koho    1996–2012
Kokai Jitsuyo Shinan Koho   1971–2012    Toroku Jitsuyo Shinan Koho    1994–2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2007-20157 A  (NTT Docomo Inc.), 25 January 2007 (25.01.2007), entire text; all drawings & US 2006/0276147 A1    & EP 1732208 A1 | 1-9 |
| A | JP 2007-13947 A  (NTT Docomo Inc.), 18 January 2007 (18.01.2007), entire text; all drawings & US 2006/0276146 A1    & US 2009/0264089 A1 & EP 1732207 A1 | 1-9 |
| A | JP 2003-92518 A  (Hitachi Kokusai Electric Inc.), 28 March 2003 (28.03.2003), entire text; all drawings & US 2003/0053552 A1    & EP 1300941 A2 | 1-9 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 12 December, 2012 (12.12.12) | 25 December, 2012 (25.12.12) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2012/080864

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-84146 A (Hitachi, Ltd.),<br>22 March 2002 (22.03.2002),<br>entire text; all drawings<br>(Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006191673 A

**Non-patent literature cited in the description**

- **S. MIZUTA ; Y. SUZUKI ; T. HIROTA ; Y. YAMAO.** Digital predistortion linearizer for compensating frequency-dependent IM distortion. *Proc. 34th European Microwave Conference,* October 2004, 1053-1056
- **S. MIZUTA ; Y. SUZUKI ; S. NARAHASHI ; Y. YAMAO.** A New Adjustment Method for the Frequency-Dependent IMD Compensator of the Digital Predistortion Linearizer. *IEEE Radio and Wireless Symposium,* January 2006, 255-258

- **T. NOJIMA ; T. KONNO.** Cuber Predistortion Linearizer for Relay Equipment in 800 MHz Band Land Mobile Telephone System. *IEEE Transactions on vehicular technology,* 1985, vol. 34 (4), 169-177
- **J. OHKAWARA ; Y. SUZUKI ; S. NARAHASHI.** Fast Calculation Scheme for Frequency Characteristic Compensator of Digital Predistortion Linearizer. *IEEE Vehicular Technology Conference Spring 2009,* April 2009